# EUROPEAN PATENT APPLICATION

(11) **EP 4 672 931 A1**
(43) Date of publication of application: **31.12.2025**
(21) Application number: 25184687.9
(22) Date of filing: 23.06.2025
(51) Int. Cl.: H10K 50/11, H10K 59/35, H10K 101/20

(54) **DISPLAY APPARATUS AND ELECTRONIC DEVICE INCLUDING THE DISPLAY APPARATUS**

(30) Priority: 25.06.2024 KR 20240083028; 28.03.2025 KR 20250040471
(71) Applicant: Samsung Display Co., Ltd., Yongin-si, Gyeonggi-do 17113 (KR)
(72) Inventor: Sun, Jinwon, 17113 Yongin-si (KR); Kim, Myoungki, 17113 Yongin-si (KR); Seo, Jihyun, 17113 Yongin-si (KR)
(74) Representative: Taor, Simon Edward William

(57) **Abstract**

Provided are a display apparatus and an electronic device. The display apparatus includes: a substrate having a unit area, the unit area being quadrangular and repeatedly arranged along a first direction and along a second direction perpendicular to the first direction; a first subpixel emitting light of a first color and including a first light-emitting area positioned on the unit area; a second subpixel emitting light of a second color and including a second light-emitting area adjacent to the first light-emitting area along the first direction on the unit area; and a third subpixel emitting light of a third color and including a third light-emitting area adjacent to the second light-emitting area along the first direction on the unit area, wherein a size of the first light-emitting area is at least 1.3 times a size of the second light-emitting area or a size of the third light-emitting area, and a maximum emission wavelength of the light of the first color is shorter than a maximum emission wavelength of the light of the second color or a maximum emission wavelength of the light of the third color.

## Description

This application claims priority to Korean Patent Application No. 10-2024-0083028, filed on June 25, 2024 and Korean Patent Application No. 10-2025-0040471, filed on March 28, 2025.

### BACKGROUND

### 1. Field

One or more embodiments relate to a display apparatus and an electronic device including the same.

### 2. Description of the Related Art

Organic light-emitting display apparatuses are display apparatuses in which an image is implemented through light generated from an emission layer positioned between a pixel electrode and a counter electrode. In these organic light-emitting display apparatuses, in order to control light emission of each pixel or the level of emission, pixel electrodes are electrically connected to thin-film transistors through which electrical signals applied to the pixel electrodes are controlled.

### SUMMARY

One or more embodiments include a display apparatus and an electronic device including the same.

Additional aspects will be set forth in part in the description which follows and, in part, will be apparent from the description, or may be learned by practice of the presented embodiments of the disclosure.

According to one or more embodiments, display apparatus includes a substrate having a unit area that is quadrangular, the unit area repeatedly positioned in or along a first direction and in or along a second direction perpendicular to the first direction, a first subpixel emitting light of first color and including a first light-emitting area positioned on the unit area, a second subpixel emitting light of second color and including a second light-emitting area adjacent to the first light-emitting area in the first direction on the unit area and a third subpixel emitting light of third color and including a third light-emitting area adjacent to the second light-emitting area in the first direction on the unit area. A size of the first light-emitting area is at least 1.3 times a size of the second light-emitting area or a size of the third light-emitting area, and a maximum emission wavelength of the light of first color is shorter than a maximum emission wavelength of the light of second color or a maximum emission wavelength of the light of third color.

According to one or more embodiments, a display apparatus includes a substrate having a unit area that may be quadrangular, the unit area repeatedly positioned in or along a first direction and in or along a second direction perpendicular to the first direction, a first subpixel emitting light of first color and including a first light-emitting area positioned on the unit area, a second subpixel emitting light of second color and including a second light-emitting area adjacent to the first light-emitting area in a third direction or a fourth direction on the unit area and a third subpixel emitting light of third color and including a third light-emitting area adjacent to the first light-emitting area in or along the second direction on the unit area. The third direction and the fourth direction intersect with the first direction and the second direction to effectively position the first subpixel, the second subpixel and the third subpixel in a crisscrossing pattern. A size of the first light-emitting area may be at least 1.3 times a size of the second light-emitting area or a size of the third light-emitting area, and the maximum emission wavelength of the first color may be shorter than the maximum emission wavelength of the second color or the maximum emission wavelength of the third color.

According to another aspect, an electronic device includes the display apparatus.

According to an aspect, there is provide a display apparatus comprising: a substrate having a unit area; a first subpixel configured to emit light of a first color and comprising a first light-emitting area on the unit area; a second subpixel configured to emit light of a second color and comprising a second light-emitting area on the unit area adjacent to the first light-emitting area; and a third subpixel configured to emit light of a third color and comprising a third light-emitting area on the unit area adjacent to the second light-emitting area, wherein: a size of the first light-emitting area is at least 1.3 times one of a size of the second light-emitting area and a size of the third light-emitting area, and a maximum emission wavelength of the light of the first color is shorter than one of an emission wavelength of the light of the second color and a maximum emission wavelength of the light of the third color.

In some embodiments, the size of the first light-emitting area is at least 1.6 times the one of the size of the second light-emitting area and the size of the third light-emitting area.

In some embodiments, the size of the first light-emitting area is at least twice the one of the size of the second light-emitting area and the size of the third light-emitting area.

In some embodiments, the size of the second light-emitting area is greater than the size of the third light-emitting area.

In some embodiments, shapes of the first light-emitting area, the second light-emitting area, and the third light-emitting area are at least one or more of circular, rectangular and rhombus shapes.

In some embodiments, shapes of the first light-emitting area, the second light-emitting area, and the third light-emitting area are the same as or different from each other.

In some embodiments, the display apparatus further comprises: a pixel electrode of the first subpixel; and a pixel definition film positioned on the substrate to cover at least a portion of the pixel electrode of the first subpixel and having an opening defining the first light-emitting area.

In some embodiments, the display apparatus further comprises a first light-emitting element, a second light-emitting element and a third light-emitting element, which are positioned on the substrate, wherein the first light-emitting element, the second light-emitting element, and the third light-emitting element each independently comprise: a pixel electrode; a counter electrode; and an interlayer positioned between the pixel electrode and the counter electrode and comprising an emission layer.

In some embodiments, a thickness of the emission layer of the first light-emitting element is about 350 Å to about 450 Å.

In some embodiments, the interlayer further comprises a first functional layer positioned between the pixel electrode and the emission layer and a second functional layer positioned between the emission layer and the counter electrode, the first functional layer comprises at least one of a hole injection layer, a hole transport layer, a buffer layer, an emission auxiliary layer, and an electron-blocking layer, and the second functional layer comprises at least one of a hole-blocking layer, an electron transport layer, and an electron injection layer.

In some embodiments, a thickness of the electron-blocking layer is about 50 Å to about 100 Å.

In some embodiments, a thickness of the hole-blocking layer is about 30 Å to about 50 Å.

In some embodiments, the emission layer of the first light-emitting element comprises a first compound including a group represented by Formula 20, a second compound including at least one π electron-deficient nitrogen-containing C₁-C₆₀ cyclic group, a third compound including a transition metal, a fourth compound that emits delayed fluorescence and includes at least one cyclic group including boron (B) and nitrogen (N) as ring-forming atoms, and/or any combination thereof, and the first compound, the second compound, the third compound, and the fourth compound are different from each other: 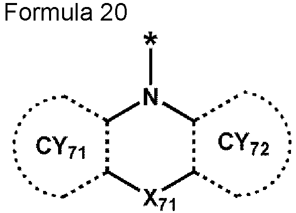
wherein ring CY₇₁ and ring CY₇₂ in Formula 20 are each independently a π electron-rich C₃-C₆₀ cyclic group or a pyridine group,
X₇₁ in Formula 20 is a single bond or a linking group including O, S, N, B, C, Si, and/or any combination thereof,
* in Formula 20 indicates a binding site to a neighboring atom in compound 20,
and the following compounds are excluded from the first compound:

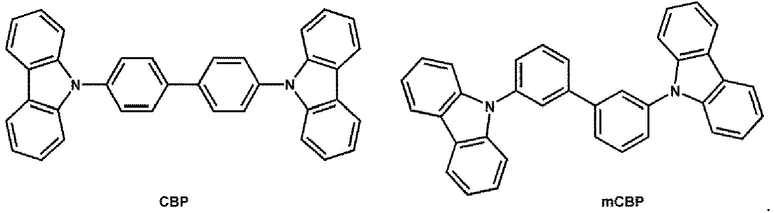

In some embodiments, the second compound includes a pyridine group, a pyrimidine group, a pyrazine group, a pyridazine group, a triazine group, and/or any combination thereof.

According to an aspect, there is provided a display apparatus comprising: a substrate having a unit area; a first subpixel configured to emit light of a first color and comprising a first light-emitting area positioned on the unit area; a second subpixel configured to emit light of a second color and comprising a second light-emitting area positioned on the unit area adjacent to the first light-emitting area; and a third subpixel configured to emit light of a third color and comprising a third light-emitting area positioned on the unit area adjacent to the first light-emitting area, wherein: the first subpixel, the second subpixel, and the third subpixel are arranged in a crisscrossing pattern, a size of the first light-emitting area is at least 1.3 times one of a size of the second light-emitting area and a size of the third light-emitting area, and a maximum emission wavelength of the light of the first color is shorter than one of a maximum emission wavelength of the light of the second color and a maximum emission wavelength of the light of the third color.

In some embodiments, the size of the first light-emitting area is at least 1.6 times the size of the second light-emitting area.

In some embodiments, the size of the first light-emitting area is at least twice the size of the third light-emitting area.

In some embodiments, the second light-emitting area comprises a first sub light-emitting area and a second sub light-emitting area which are spaced apart from each other on the unit area, the first sub light-emitting area is adjacent to the first light-emitting area, and the second sub light-emitting area is adjacent to the first light-emitting area.

According to an aspect, there is provided an electronic device comprising the display apparatus of any one of the above-mentioned aspects.

In some embodiments, the electronic device is one of a smartphone, a tablet, a laptop, a desk monitor, smart glasses, a head-mounted display, a smart watch, an instrument panel, a center fascia, a center information display, and a room mirror display.

According to an aspect, there is provided a display device as set out in claim 1. Additional features are set out in claims 2 to 13.

According to an aspect, there is provided an electronic device as set out in claim 14. Additional features are set out in claim 15.

### BRIEF DESCRIPTION OF THE DRAWINGS

These and other aspects, features, and advantages of certain embodiments of the disclosure will be more apparent from the following description taken in conjunction with the accompanying drawings, in which:
FIG. 1 is a plan view schematically illustrating a display apparatus according to an embodiment;
FIG. 2 is a cross-sectional view schematically illustrating a portion of a cross-section of a display apparatus according to an embodiment;
FIG. 3 is a cross-sectional view schematically illustrating a portion of a cross-section of a display apparatus according to an embodiment;
FIG. 4 is a cross-sectional view schematically illustrating a portion of a cross-section of a display apparatus according to an embodiment;
FIG. 5 is an equivalent circuit diagram of one pixel of a display apparatus according to an embodiment;
FIG. 6 is a schematic plan view illustrating a portion of a display apparatus with subpixels having first relative sizes in a linear pattern according to an embodiment;
FIG. 7 is a schematic plan view illustrating a portion of a display apparatus with subpixels having second relative sizes in a linear pattern according to an embodiment;
FIG. 8 is a schematic plan view illustrating a portion of a display apparatus with subpixels having third relative sizes in a linear pattern according to an embodiment;
FIG. 9 is a schematic plan view illustrating a portion of a display apparatus with subpixels having first shapes in a crisscrossing pattern according to an embodiment;
FIG. 10 is a schematic plan view illustrating a portion of a display apparatus with subpixels having second shapes in a crisscrossing pattern according to an embodiment;
FIG. 11 is a cross-sectional view schematically illustrating a portion of a cross-section of a display apparatus according to an embodiment;
FIG. 12 is a block diagram of an electronic device according to an embodiment;
FIG. 13 shows schematic diagrams of an electronic device according to various embodiments;
FIG. 14 is a schematic drawing of the exterior of a vehicle as an electronic device including a display apparatus according to an embodiment; and
FIGS. 15A to 15C are each a diagram schematically illustrating the interior of a vehicle according to various embodiments.

### DETAILED DESCRIPTION

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

Hereinafter, embodiments of the present disclosure will be described in detail with reference to the accompanying drawings. The same or corresponding components will be denoted by the same reference numerals, and thus redundant description thereof will be omitted.

It will be understood that although the terms "first," "second," etc. may be used herein to describe various components, these components should not be limited by these terms. These components are only used to distinguish one component from another.

An expression used in the singular encompasses the expression of the plural, unless it has a clearly different meaning in the context.

It will be further understood that the terms "comprises" and/or "comprising" used herein specify the presence of stated features or elements, but do not preclude the presence or addition of one or more other features or elements.

In the following embodiments, when various components such as layers, films, areas, plates, etc. are said to be "on" another component, this may include not only a case in which other components are "immediately on" the layers, films, areas, or plates, but also a case in which other components may be positioned therebetween. Sizes of elements in the drawings may be exaggerated for convenience of explanation. In other words, because sizes and thicknesses of components in the drawings are arbitrarily illustrated for convenience of explanation, the following embodiments are not limited thereto.

The term "interlayer" as used herein refers to a single layer and/or all of multiple layers positioned between the first electrode and the second electrode of the light-emitting element.

Sizes of elements in the drawings may be exaggerated for convenience of explanation. For example, the size and thickness of each component shown in the drawing are arbitrarily shown for convenience of explanation, and thus the disclosure is not necessarily limited to what is shown.

The term "A and/or B" as used herein refers to either A, B, or both A and B. Additionally, the term "at least one of A and B" as used herein refers to a case where it is A, or B, or both A and B.

In embodiments below, the wording "a wiring extends in or along a first direction or in or along a second direction" includes not only extending in a straight shape, but also extending in a zigzag or curved shape in or along the first direction or in or along the second direction.

In embodiments below, when referring to "plan view," it means when a target portion is viewed from above, and when referring to "cross-sectional view," it means when the cross-section of the target portion cut vertically therethrough is viewed from the side. In embodiments below, the wording "a first component and a second component overlap" refers to a case where a first component is positioned above or below the second component.

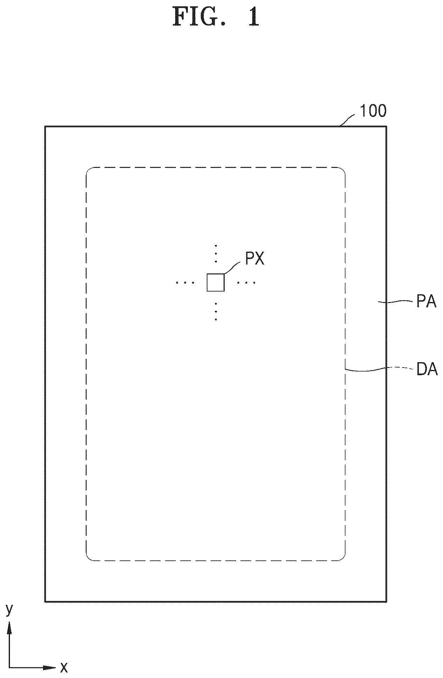

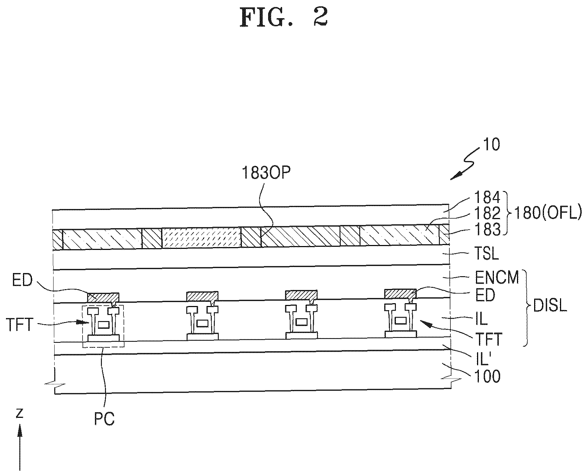

FIG. 1 is a plan view schematically illustrating a display apparatus according to an embodiment. FIGS. 2 to 4 are cross-sectional views schematically illustrating a portion of a cross-section of a display apparatus according to an embodiment.

Referring to FIG. 1, the display apparatus may include a display panel 10, and a cover window (not shown) that protects the display panel 10 may be further positioned on the display panel 10.

The display panel 10 may include a display area DA that implements an image and a peripheral area PA outside the display area DA. The peripheral area PA may be, for example, a non-display area where pixels are not placed. The display area DA may be completely surrounded by the peripheral area PA. Various components forming the display panel 10 may be positioned on a substrate 100. Therefore, it can be seen that the substrate 100 may include the display area DA and the peripheral area PA.

A plurality of subpixels PX may be positioned in the display area DA. A subpixel PX may include a display element. The display element may be connected to a pixel circuit that drives the subpixel PX. In an embodiment, the display element may be a light-emitting element ED, in particular, an organic light-emitting diode OLED. Each pixel PX may emit light of, for example, red, green, blue or white via an organic light-emitting diode OLED.

When the display area DA is viewed from above, the display area DA may have a rectangular shape as shown in FIG. 1. In some embodiments, the display area DA may have at least one or more of a polygonal shape such as a triangle, a pentagon, a hexagon, a circular or annular shape, an oval shape, an irregular shape, etc.

The peripheral area PA may be an area positioned around the display area DA and may be an area where no image may be displayed. In the peripheral area PA, various wirings for transmitting electrical signals to be applied to the display area DA, peripheral circuits electrically connected to pixel circuits, and pads to which printed circuit boards or driver IC chips are attached may be positioned.

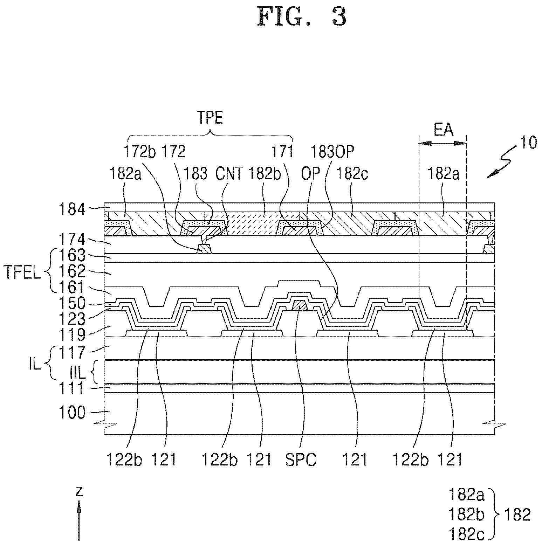

Referring to FIGS. 2 and 3, the display panel 10 may include a substrate 100, a display layer DISL, a touch screen layer TSL, and an optical functional layer OFL, which are positioned on the substrate 100.

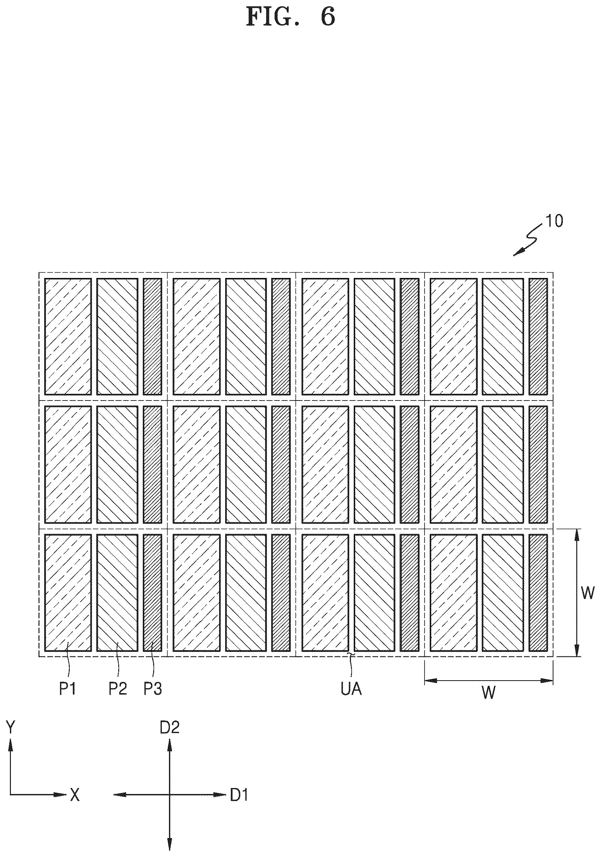

The display layer DISL may include a pixel circuit PC including a thin film transistor TFT, a light-emitting element ED which may be a display element, and an encapsulation member ENCM such as a thin film encapsulation layer TFEL or an encapsulation substrate (not shown). Accordingly, a light-emitting element may be positioned on the substrate 100. In this regard, the light-emitting element may include a first light-emitting element, a second light-emitting element, and a third light-emitting element according to color of light emitted from subpixels P1, P2, and P3 (see FIG.6). That is, the first light-emitting element may be a light-emitting element corresponding to a blue subpixel (P1) that emits blue light. An insulating layer IL or IL' may be positioned between the substrate 100 and the display layer DISL, and within the display layer DISL. In FIG. 3, the pixel circuit PC is omitted for convenience of illustration.

The substrate 100 may be a single layer of glass material. In some embodiments, the substrate 100 may include a polymer resin. In case the substrate 100 includes a polymer resin, the substrate 100 may have a multilayer structure in which organic layers including a polymer resin and inorganic layers are laminated. The substrate 100 may be a rigid substrate or a flexible substrate capable of bending, folding, rolling, etc.

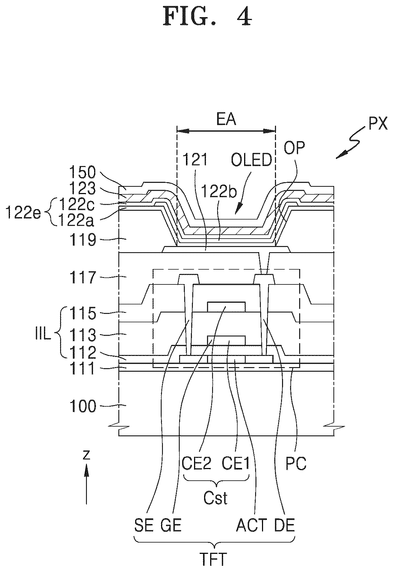

A buffer layer 111, an inorganic insulating layer IIL, and a planarization layer 117 may be sequentially laminated on the substrate 100. The planarization layer 117 may include an organic material or an inorganic material and may have a single-layer structure or a multi-layer structure. A pixel circuit PC may be positioned between the buffer layer 111 and the planarization layer 117. As illustrated in FIG. 4, the pixel circuit PC may include a thin film transistor TFT and a capacitor Cst.

A thin film transistor TFT may include a semiconductor layer ACT including an inorganic semiconductor material such as one or more of amorphous silicon, polycrystalline silicon, and an oxide semiconductor, a gate electrode GE, a source electrode SE, and a drain electrode DE. The capacitor Cst may include a lower electrode CE1 and an upper electrode CE2.

A semiconductor layer ACT may be positioned on the buffer layer 111. A first insulating layer 112 may be positioned between the semiconductor layer ACT and the gate electrode GE. A second insulating layer 113 may be positioned on the gate electrode GE, and the upper electrode CE2 of the capacitor Cst may be positioned on the second insulating layer 113. The upper electrode CE2 and the gate electrode GE may overlap. The gate electrode GE and the upper electrode CE2, overlapping with the second insulating layer 113 positioned between the gate electrode GE and the upper electrode CE2, may form the capacitor Cst. The gate electrode GE may be the lower electrode CE1 of the capacitor Cst. A third insulating layer 115 may be positioned on the capacitor Cst, and a source electrode SE and a drain electrode DE may be positioned on the third insulating layer 115.

The first insulating layer 112, the second insulating layer 113, and the third insulating layer 115 may each include an inorganic material such as silicon oxide, silicon nitride, and/or silicon oxynitride. The first insulating layer 112, the second insulating layer 113, and the third insulating layer 115 may be collectively referred to as an inorganic insulating layer IlL.

A buffer layer 111 including an inorganic material such as silicon oxide, silicon nitride, and/or silicon oxynitride may be positioned between the thin film transistor TFT and the substrate 100.

The planarization layer 117 may be positioned on the thin film transistor TFT. The planarization layer 117 may include an organic insulating material such as one or more of acrylic, benzocyclobutene (BCB), and hexamethyldisiloxane (HMDSO) and/or combinations thereof. Meanwhile, the planarization layer 117 may include an inorganic insulating material such as one or more of silicon oxide (SiOₓ), silicon nitride (SiNₓ), silicon oxynitride (SiON), aluminum oxide (Al₂O₃), titanium oxide (TiO₂), tantalum oxide (Ta₂O₅), hafnium oxide (HfO₂), and zinc oxide (ZnO₂) and/or combinations thereof. When forming the planarization layer 117, a layer may be formed and then chemical and mechanical polishing may be performed on the upper surface of the layer to provide a flat upper surface. The planarization layer 117 may be a single-layer or multiple layers.

An organic light-emitting diode OLED, which may be a display element and the light-emitting element ED, may be positioned on the planarization layer 117. The light-emitting element ED, i.e., the organic light-emitting diode OLED, may include a pixel electrode 121, a counter electrode 123, and an interlayer between the pixel electrode 121 and the counter electrode 123. According to an embodiment, the pixel electrode 121 may be an anode and the counter electrode 123 may be a cathode. According to an embodiment, the pixel electrode 121 may be a first electrode and the counter electrode 123 may be a second electrode. The light-emitting element ED, i.e., the organic light-emitting diode OLED, may include a first light-emitting element that emits a light of first color, a second light-emitting element that emits a light of second color, and a third light-emitting element that emits a light of third color.

The first light-emitting element, the second light-emitting element, and the third light-emitting element may each independently include the pixel electrode 121, the counter electrode 123, and the interlayer between the pixel electrode 121 and the counter electrode 123.

The pixel electrode 121 may be positioned on a planarization layer 117, and the pixel electrode 121 may be in contact with the source electrode SE or the drain electrode DE through a via hole of the planarization layer 117 and thus be electrically connected to the thin film transistor TFT.

A pixel definition film 119 may be positioned on the planarization layer 117. The pixel definition film 119 covers the edge of the pixel electrode 121 and may have an opening OP that exposes a part of the pixel electrode 121. The size and shape of a light-emitting area EA of the organic light-emitting diode OLED may be defined by an opening OP.

The pixel definition film 119 may include a transparent insulating material or an opaque insulating material. In an embodiment, the pixel definition film 119 may include an organic insulating material such as polyimide, polyamide, acrylic resin, benzocyclobutene, hexamethyldisiloxane (HMDSO), and a phenol resin. In some embodiments, the pixel definition film 119 may include an inorganic insulating material such as silicon nitride or silicon oxide, and/or may include an organic insulating material and an inorganic insulating material.

In some embodiments, the pixel definition film 119 may include a light-blocking material and may be provided as black. The light-blocking material may include a resin or paste containing carbon black, carbon nanotubes, black dye, metal particles such as nickel, aluminum, molybdenum and alloys thereof, metal oxide particles (e.g., chromium oxide), and/or metal nitride particles (e.g., chromium nitride). When the pixel definition film 119 includes a light-blocking material, external light reflection by metal structures positioned under the pixel definition film 119 may be reduced.

As shown in FIG. 3, a spacer SPC may be further provided on the pixel definition film 119. In an embodiment, the spacer SPC may include the same material as the pixel definition film 119. In this case, the pixel definition film 119 and the spacer SPC may formed together in a mask process using a halftone mask, etc., so that the spacer SPC may have an island or trapezoidal shape that protrudes from the pixel definition film 119 to a certain distance in a z direction. In an embodiment, the spacer SPC and the pixel definition film 119 may include different materials. In this case, the spacer SPC may be provided as island-shaped or trapezoidal-shaped insulating patterns positioned at preset intervals on the pixel definition film 119.

As illustrated in FIG. 4, the interlayer may include an emission layer 122b and an organic functional layer 122e above and/or below the emission layer 122b.

The thickness of the emission layer 122b may be about 350 Å to about 450 Å. In an embodiment, the thickness of the emission layer of the first light-emitting element may be about 350 Å to about 450 Å. Within this thickness range, the display apparatus may have long lifespan characteristics.

In some embodiments, the thickness of an emission layer of the second light-emitting element and/or an emission layer of the third light-emitting element may be about 350 Å to about 450 Å.

Emission layers 122b may be each positioned to correspond to the pixel electrode 121 inside the opening OP of the pixel definition film 119. The emission layer 122b may include a polymer material or a low molecular weight material and may emit red, green, blue or white light.

The organic functional layer 122e may include a first functional layer 122a and/or a second functional layer 122c. The first functional layer 122a or the second functional layer 122c may be omitted.

The first functional layer 122a may be positioned below the emission layer 122b, that is, between the pixel electrode 121 and the emission layer 122b. The first functional layer 122a may be a single layer including an organic material or multiple layers including an organic material. The first functional layer 122a may be a hole transport layer (HTL) having a single-layer structure. In some embodiments, the first functional layer 122a may include a hole injection layer (HIL) and a hole transport layer (HTL). In some embodiments, the first functional layer 122a may include at least one selected from a hole injection layer, a hole transport layer, a buffer layer, an emission auxiliary layer, and an electron-blocking layer. The first functional layer 122a may be formed integrally to correspond to organic light-emitting diodes OLEDs included in the display area DA.

The second functional layer 122c may be positioned on the emission layer 122b, that is, between the counter electrode 123 and the emission layer 122b. The second functional layer 122c may be a single layer including an organic material or multiple layers including an organic material. The second functional layer 122c may include an electron transport layer (ETL) and/or an electron injection layer (EIL). In some embodiments, the second functional layer 122c may include at least one selected from a hole-blocking layer, an electron transport layer, and an electron injection layer. The second functional layer 122c may be formed integrally to correspond to the organic light-emitting diodes OLEDs included in the display area DA.

The counter electrode 123 may be positioned on the emission layer 122b. The upper layer 150 including an organic material may be positioned on the counter electrode 123.

Although not shown, in an alternative embodiment, the interlayer may include two or more emitting units sequentially stacked between the pixel electrode and the counter electrode 123, and a charge generation layer (CGL) positioned between the two emitting units. When the interlayer includes an emitting unit and a charge generation layer, the organic light-emitting diode OLED may be a tandem light-emitting element. An organic light-emitting diode OLED may improve color purity and luminescence efficiency by having a stacked structure of a plurality of emitting units.

A single emitting unit may include an emission layer and a first functional layer and a second functional layer respectively below and above the emission layer. The charge generation layer (CGL) may include a negative charge generation layer and a positive charge generation layer. Due to the negative charge generation layer and the positive charge generation layer, the luminescence efficiency of an organic light-emitting diode OLED including a plurality of emission layers, which may be a tandem light-emitting element may be further increased. The negative charge generation layer may be an n-type charge generation layer. The negative charge generation layer may supply electrons. The negative charge generation layer may include a host and a dopant. The host may include an organic material. The dopant may include an organic material or a metallic material. The positive charge generation layer may be a p-type charge generation layer. The positive charge generation layer may supply holes. The positive charge generation layer may include a host and a dopant. The host may include an organic material. The dopant may include an organic material or a metallic material.

### [First functional layer 122a in interlayer]

The first functional layer 122a may have i) a single-layer structure including a single layer including a single material, ii) a single-layer structure including a single layer including multiple materials that are different from each other, or iii) a multi-layer structure including multiple layers including multiple different materials that are different from each other.

The first functional layer 122a may be a hole transport area, and the hole transport area may include a hole injection layer, a hole transport layer, an emission auxiliary layer, an electron-blocking layer, and/or any combination thereof.

For example, the hole transport area may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, and/or a hole injection layer/hole transport layer/electron-blocking layer structure, the layers of each structure being stacked sequentially from the first electrode.

The hole transport area may include a compound represented by Formula 201, a compound represented by Formula 202, and/or any combination thereof:

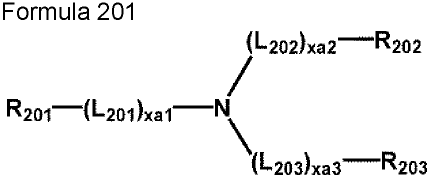

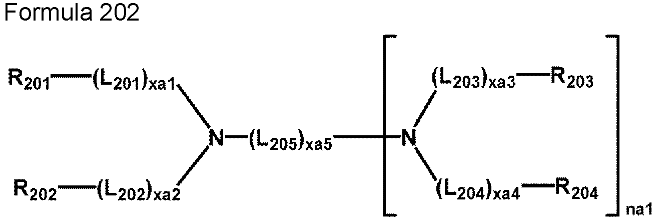

wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q201)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, and/or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, and/or a C₂-C₅ alkenylene group unsubstituted or substituted with at least one R₁₀ₐ to form a C₈-C₆₀ polycyclic group (e.g., a carbazole group or the like) unsubstituted or substituted with at least one R₁₀ₐ (e.g., see Compound HT16),
R₂₀₃ and R₂₀₄ may optionally be linked to each other via a single bond, a C₁-C₅ alkylene group that may be unsubstituted or substituted with at least one R₁₀ₐ, and/or a C₂-C₅ alkenylene group that may be unsubstituted or substituted with at least one R₁₀ₐ to form a C₈-C₆₀ polycyclic group that may be unsubstituted or substituted with at least one R₁₀ₐ, and
na1 may be an integer from 1 to 4.

In an embodiment, each of Formulae 201 and 202 may include at least one of groups represented by Formulae CY201 to CY217: 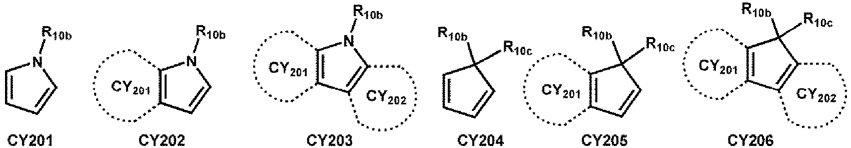 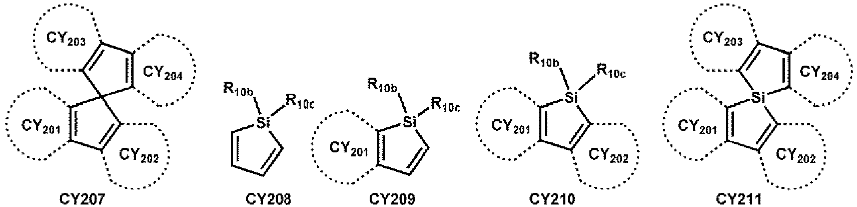 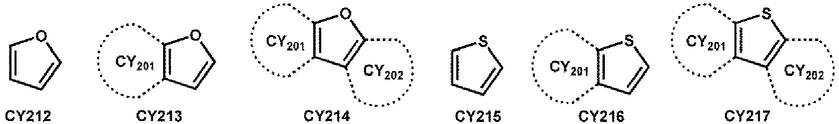 wherein, in Formulae CY201 to CY217, R_{10b}, and R_{10c} are each as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, ring CY₂₀₁ to ring CY₂₀₄ in Formulae CY201 to CY217 may each independently be a benzene group, a naphthalene group, a phenanthrene group, and/or an anthracene group.

In an embodiment, each of Formulae 201 and 202 may include at least one of groups represented by Formulae CY201 to CY203.

In an embodiment, Formula 201 may include at least one of groups represented by Formulae CY201 to CY203 and at least one of groups represented by Formulae CY204 to CY217.

In an embodiment, in Formula 201, xa1 may be 1, R₂₀₁ may be a group represented by one of Formulae CY201 to CY203, xa2 may be 0, and R₂₀₂ may be a group represented by one of Formulae CY204 to CY207.

In an embodiment, each of Formulae 201 and 202 may not include groups represented by Formulae CY201 to CY203.

In an embodiment, each of Formulae 201 and 202 may not include groups represented by Formulae CY201 to CY203 and may include at least one of groups represented by Formulae CY204 to CY217.

In an embodiment, each of Formulae 201 and 202 may not include groups represented by Formulae CY201 to CY217.

In an embodiment, the hole transport area may include one of Compounds HT1 to HT47, HAT-CN, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), and/or a combination thereof:

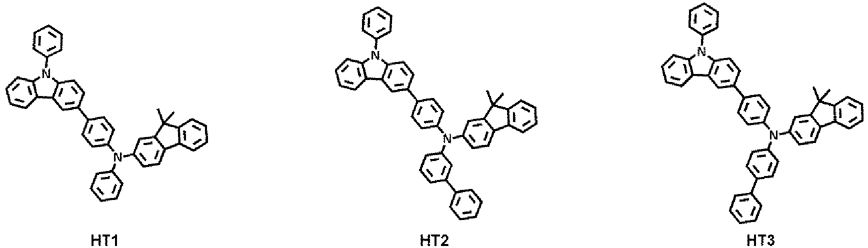

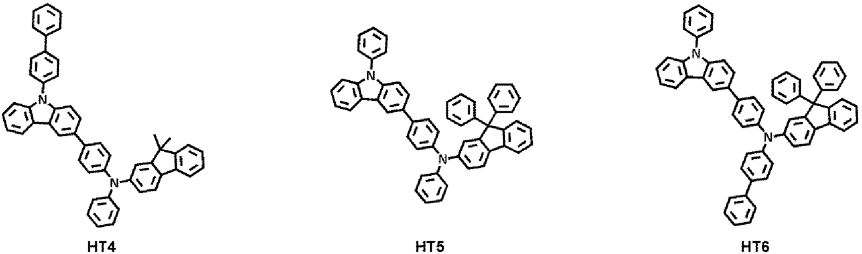

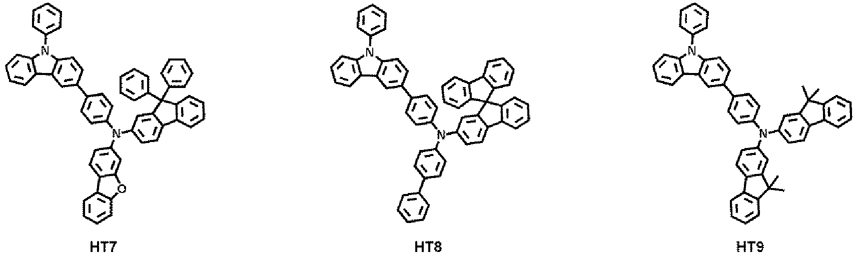

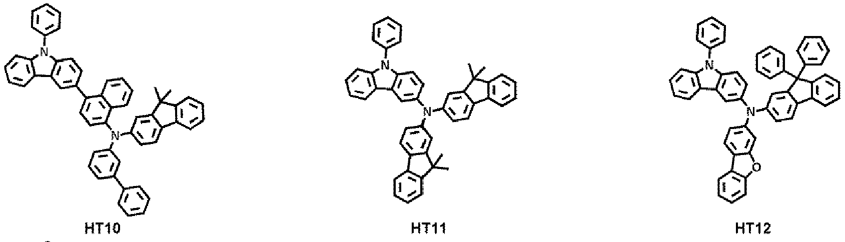

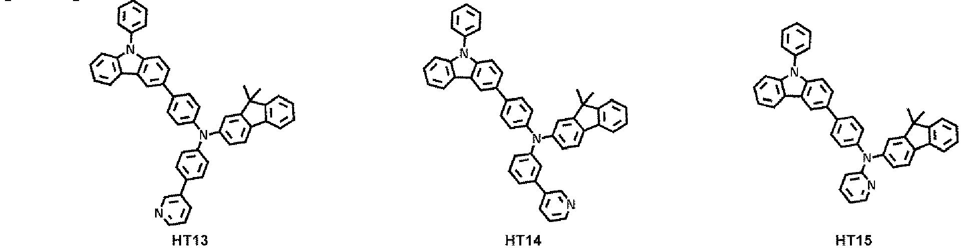

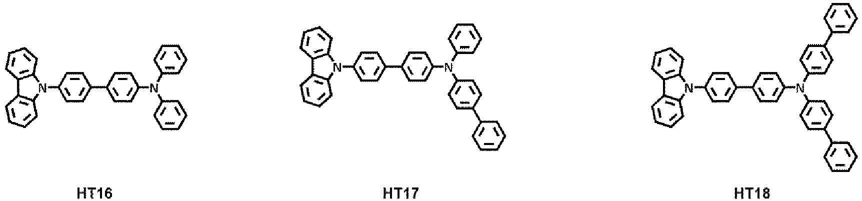

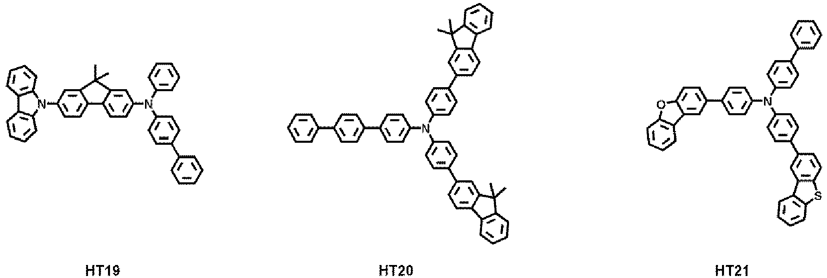

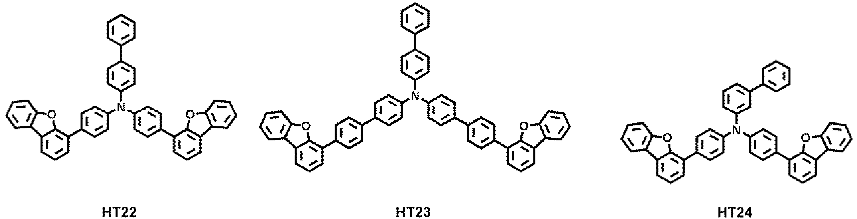

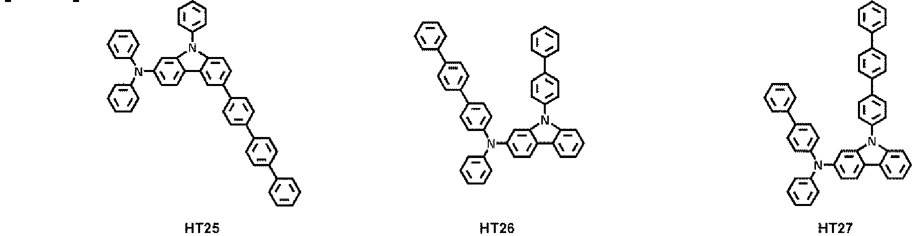

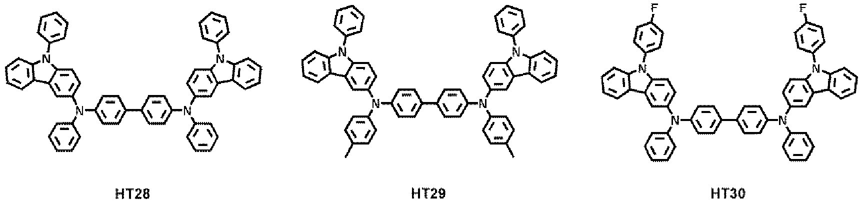

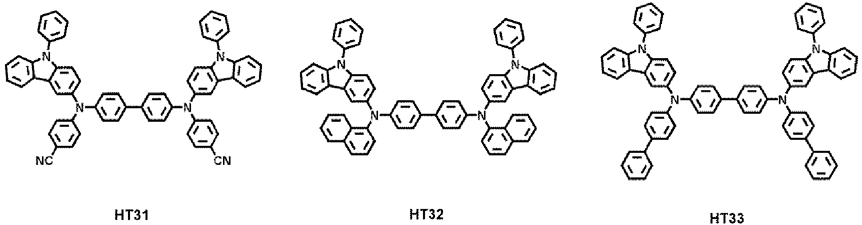

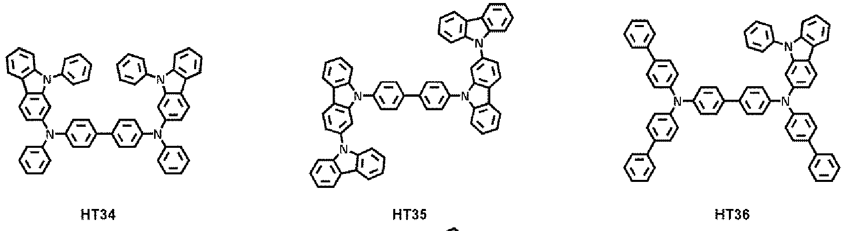

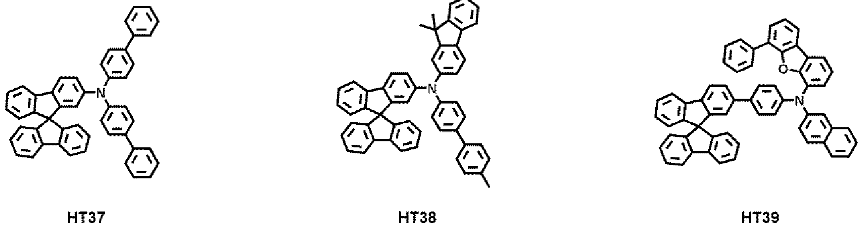

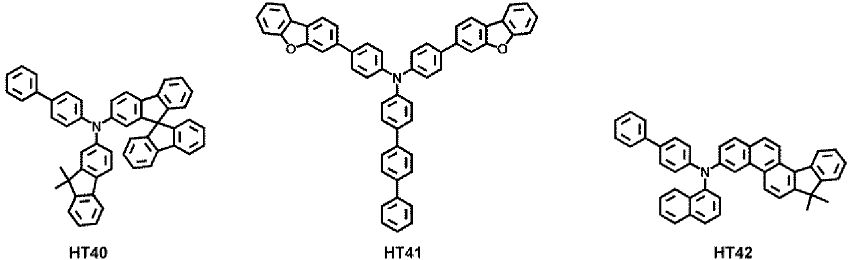

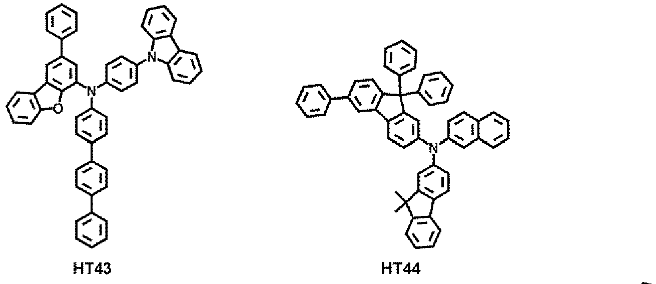

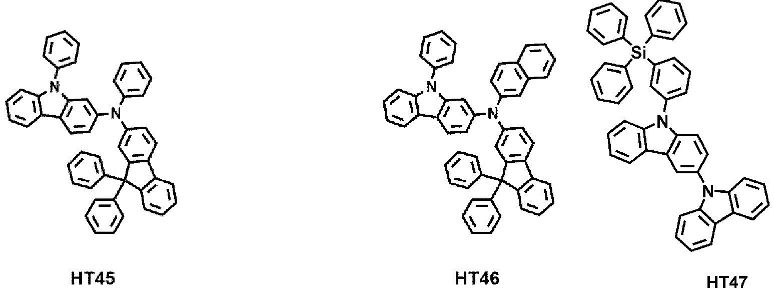

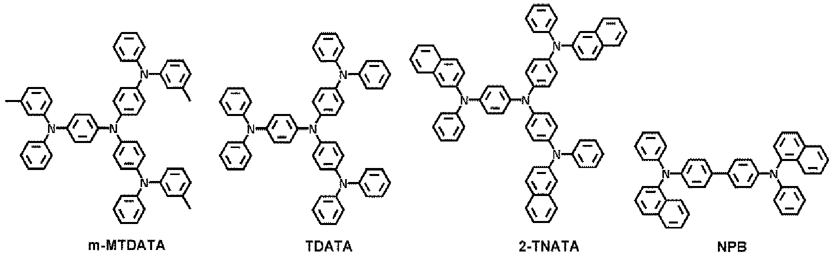

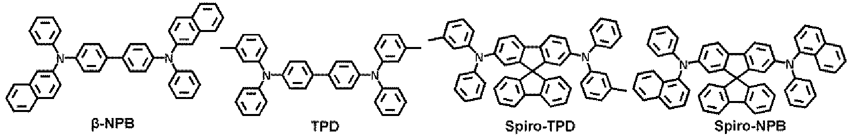

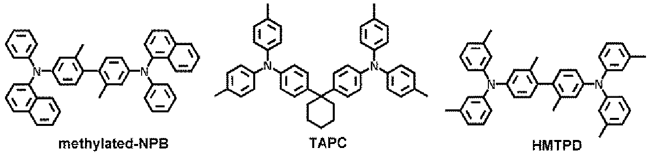

The thickness of the hole transport area may be about 50 Å to about 10,000 Å, for example, about 100 Å to about 4,000 Å. When the hole transport area includes a hole injection layer, a hole transport layer, an electron-blocking layer and/or any combination thereof, the thickness of the hole injection layer may be about 100 Å to about 9,000 Å, for example, about 100 Å to about 1,000 Å, and the thickness of the hole transport layer may be about 50 Å to about 2,000 Å, for example, about 100 Å to about 1,500 Å, and a thickness of the electron-blocking layer may be about 50 Å to about 100 Å. When the thicknesses of the hole transport area, the hole injection layer, and the hole transport layer are within the ranges described above, satisfactory hole transporting characteristics may be obtained without a substantial increase in driving voltage.

The emission auxiliary layer may increase luminescence efficiency by compensating for an optical resonance distance according to the wavelength of light emitted by the emission layer, and the electron-blocking layer may block the leakage of electrons from the emission layer to the hole transport area. Materials that may be included in the hole transport area may be included in the emission auxiliary layer and the electron-blocking layer.

### [p-dopant]

The hole transport area may further include, in addition to these materials, a charge-generation material for the improvement of conductive properties. The charge-generation material may be uniformly or non-uniformly dispersed in the hole transport area (for example, in the form of a single layer including a charge-generation material).

The charge-generation material may be, for example, a p-dopant.

For example, the lowest unoccupied molecular orbital (LUMO) energy of the p-dopant may be less than or equal to -3.5 eV. For example, the LUMO energy level of the p-dopant may be -5.0 eV or less.

According to an embodiment, the p-dopant may include, a quinone derivative, a cyano group-containing compound, an element EL1 and element EL2-containing compound, and/or any combination thereof.

Examples of the quinone derivative may include TCNQ and F4-TCNQ.

Examples of the cyano group-containing compound may include HAT-CN and a compound represented by Formula 221.

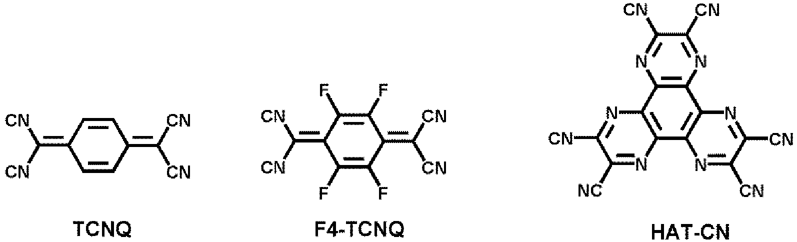

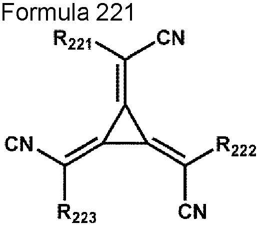

In Formula 221,
R₂₂₁ to R₂₂₃ may each independently be a C₃-C₆₀ carbocyclic group that may be unsubstituted or substituted with at least one R₁₀ₐ or a C₁-C₆₀ heterocyclic group that may be unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, and/or any combination thereof; or any combination thereof.

In the compound including the element EL1 and the element EL2, the element EL1 may be a metal, a metalloid, and/or a combination thereof, and the element EL2 may be a non-metal, a metalloid, and/or a combination thereof.

Examples of the metal are an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid may include silicon (Si), antimony (Sb), and tellurium (Te).

Examples of the non-metal may include oxygen (O) and halogen (for example, F, Cl, Br, I, etc.).

Examples of the compound including the element EL1 and the element EL2 are a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, and/or any combination thereof.

Examples of the metal oxide are a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (MoO, Mo₂O₃, MoO₂, MoO₃, Mo₂O₅, etc.), and a rhenium oxide (for example, ReO₃, etc.).

Examples of the metal halide are an alkali metal halide, an alkaline earth metal halide, a transition metal halide, a post-transition metal halide, and a lanthanide metal halide.

Examples of the alkali metal halide are LiF, NaF, KF, RbF, CsF, LiCl, NaCl, KCI, RbCl, CsCl, LiBr, NaBr, KBr, RbBr, CsBr, Lil, Nal, Kl, Rbl, and Csl.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of the transition metal halide are a titanium halide (for example, TiF₄, TiCl₄, TiBr₄, TiI₄, etc.), a zirconium halide (for example, ZrF₄, ZrCl₄, ZrBr₄, ZrI₄, etc.), a hafnium halide (for example, HfF₄, HfCl₄, HfBr₄, HfI₄, etc.), a vanadium halide (for example, VF₃, VCl₃, VBr₃, VI₃, etc.), a niobium halide (for example, NbF₃, NbCl₃, NbBr₃, NbI₃, etc.), a tantalum halide (for example, TaF₃, TaCl₃, TaBr₃, TaI₃, etc.), a chromium halide (for example, CrF₃, CrCl₃, CrBr₃, CrI₃, etc.), a molybdenum halide (for example, MoF₃, MoCl₃, MoBr₃, MoI₃, etc.), a tungsten halide (for example, WF₃, WCl₃, WBr₃, WI₃, etc.), a manganese halide (for example, MnF₂, MnCl₂, MnBr₂, MnI₂, etc.), a technetium halide (for example, TcF₂, TcCl₂, TcBr₂, TcI₂, etc.), a rhenium halide (for example, ReF₂, ReCl₂, ReBr₂, ReI₂, etc.), an iron halide (for example, FeF₂, FeCl₂, FeBr₂, FeI₂, etc.), a ruthenium halide (for example, RuF₂, RuCl₂, RuBr₂, RuI₂, etc.), an osmium halide (for example, OsF₂, OsCl₂, OsBr₂, OsI₂, etc.), a cobalt halide (for example, CoF₂, CoCl₂, CoBr₂, CoI₂, etc.), a rhodium halide (for example, RhF₂, RhCl₂, RhBr₂, RhI₂, etc.), an iridium halide (for example, IrF₂, IrCl₂, IrBr₂, IrI₂, etc.), a nickel halide (for example, NiF₂, NiCl₂, NiBr₂, NiI₂, etc.), a palladium halide (for example, PdF₂, PdCl₂, PdBr₂, PdI₂, etc.), a platinum halide (for example, PtF₂, PtCl₂, PtBr₂, PtI₂, etc.), a copper halide (for example, CuF, CuCl, CuBr, Cul, etc.), a silver halide (for example, AgF, AgCl, AgBr, Agl, etc.), and a gold halide (for example, AuF, AuCl, AuBr, Aul, etc.).

Examples of the post-transition metal halide are a zinc halide (for example, ZnF₂, ZnCl₂, ZnBr₂, ZnI₂, etc.), an indium halide (for example, InI₃, etc.), and a tin halide (for example, SnI₂, etc.).

Examples of the lanthanide metal halide are YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and the like.

Examples of the metalloid halide are an antimony halide (for example, SbCl₅, etc.).

Examples of the metal telluride are an alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer 122b in interlayer]

When the light-emitting element may be a full-color light-emitting element, the emission layer may be patterned into a red emission layer, a green emission layer, and/or a blue emission layer, according to a subpixel. In an embodiment, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

In an embodiment, the emission layer may include a host and a dopant (or an emitter). In an embodiment, the emission layer may further include an auxiliary dopant that promotes energy transfer to a dopant (or an emitter), in addition to the host and the dopant (or an emitter). When the emission layer includes the dopant (or an emitter) and the auxiliary dopant, the dopant (or an emitter) and the auxiliary dopant are different from each other.

An amount (weight) of the dopant (or an emitter) in the emission layer may be in a range of about 0.01 parts by weight to about 15 parts by weight based on 100 parts by weight of the host.

In an embodiment, the emission layer may include a quantum dot.

In an embodiment, the emission layer may include a delayed fluorescence material. The delayed fluorescence material may act as a host or a dopant in the emission layer.

The thickness of the emission layer may be about 100 Å to about 1,000 Å, for example, about 200 Å to about 600 Å. When the thickness of the emission layer may be within the range described above, excellent luminescence characteristics may be obtained without a substantial increase in driving voltage.

In some embodiments,
The emission layer 122b, in particular, the emission layer of the first light-emitting element may include a first compound including a group represented by Formula 20, a second compound including at least one π electron-deficient nitrogen-containing C₁-C₆₀ cyclic group, a third compound including a transition metal, a fourth compound that emits delayed fluorescence and/or includes at least one cyclic group including boron (B) and nitrogen (N) as ring-forming atoms, and/or any combination thereof:

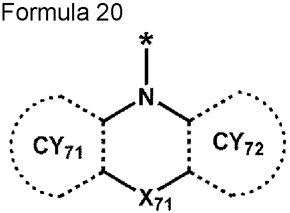

wherein ring CY₇₁ and ring CY₇₂ in Formula 20 may each independently a π electron-rich C₃-C₆₀ cyclic group or a pyridine group,
X₇₁ in Formula 20 may be a single bond or a linking group including O, S, N, B, C, Si, and/or any combination thereof, and
* in Formula 20 indicates a binding site to a neighboring atom in compound 20.

Compounds below are not examples of the second compound:

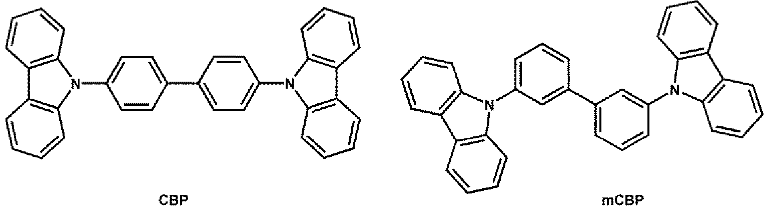

In an embodiment, each of the first compound, the second compound, the third compound and the fourth compound may be different from each other.

In an embodiment, the second compound may include a pyridine group, a pyrimidine group, a pyrazine group, a pyridazine group, a triazine group, and/or any combination thereof.

In an embodiment, the emission layer may include the first compound and may include at least one of the third compound and the fourth compound.

In some embodiments, the emission layer may include the first compound, the second compound, and the third compound.

In some embodiments, the emission layer may include the first compound, the second compound, and the fourth compound.

In some embodiments, the emission layer may include all of the first compound to the fourth compound.

In an embodiment, the first compound may include a compound represented by Formula 20-1, a compound represented by Formula 20-2, a compound represented by Formula 20-3, a compound represented by Formula 20-4, a compound represented by Formula 20-5, and/or any combination thereof: 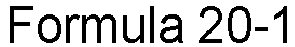 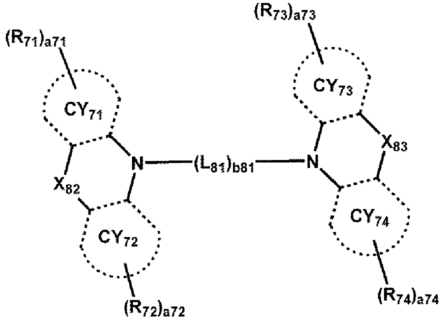 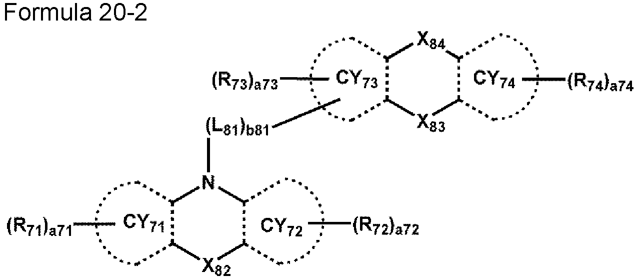 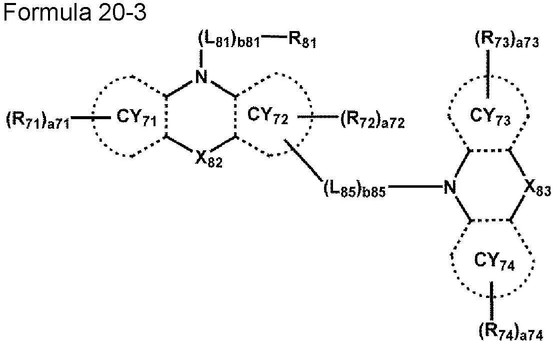 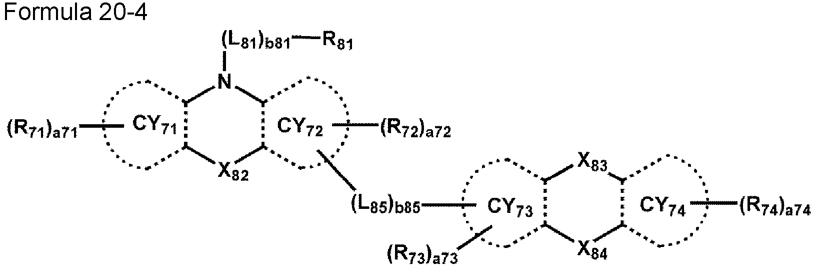 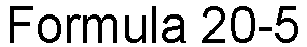 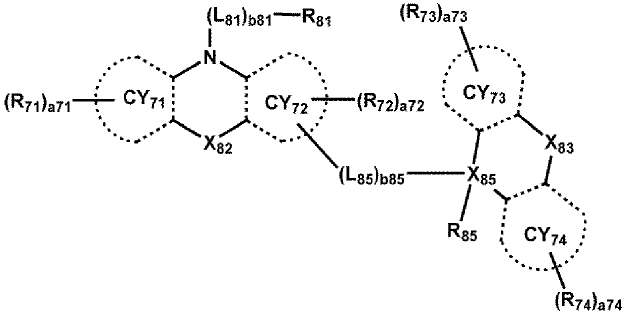 wherein, in Formula 20-1 to 20-5,
ring CY₇₁ to ring CY₇₄ may each independently be a π electron-rich C₃-C₆₀ cyclic group or a pyridine group,
X₈₂ may be a single bond, O, S, N-[(L₈₂)_{b82}-R₈₂], B[(L₈₂)_{b82}-R₈₂], C(R₈₂ₐ)(R_{82b}), or Si(R82a)(R82b),
X₈₃ may be a single bond, O, S, N-[(L₈₃)_{b83}-R₈₃], B[(L₈₃)_{b83}-R₈₃], C(R₈₃ₐ)(R_{83b}), or Si(R83a)(R83b),
X₈₄ may be O, S, N-[(L₈₄)_{b84}-R₈₄], B[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each be understood by referring to the description of Q₁ provided herein,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be the same as described herein.

In an embodiment, the second compound may include a pyridine group, a pyrimidine group, a pyrazine group, a pyridazine group, a triazine group, and/or any combination thereof.

In an embodiment, the second compound may include a compound represented by Formula 30: 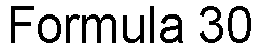 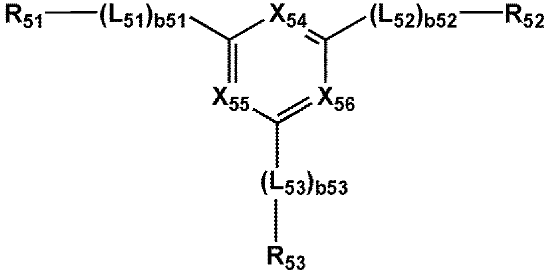 wherein, in Formula 30,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₅ may be N or C(R₅₆), and at least one of X₅₄ to X₅₅ may be N,
R₅₁ to R₅₆ are respectively the same as those described in the present specification, and
R₁₀ₐ and Q₁ to Q₃ are each the same as described herein.

### Description of Formulae 20, 20-1 to 20-5, and 30

In an embodiment, a group represented by 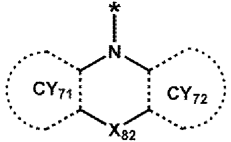 in Formulae 20-1 and 20-2 may be a group represented by one of Formulae CY71-1(1) to CY71-1(8), and/or
a group represented by 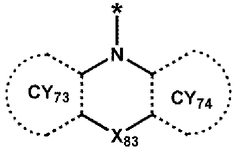 in Formulae 20-1 and 20-3 may be a group represented by one of Formulae CY71-2(1) to CY71-2(8), and/or
a group represented by 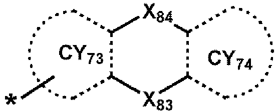 in Formulae 20-2 and 20-4 may be a group represented by one of Formulae CY71-3(1) to CY71-3(32), and/or
a group represented by 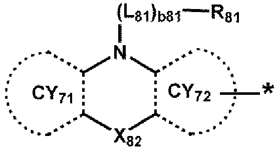 in Formulae 20-3 to 20-5 may be a group represented by one of Formulae CY71-4(1) to CY71-4(32), and/or
a group represented by 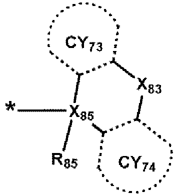 in Formula 20-5 may be a group represented by one of Formulae CY71-5(1) to CY71-5(8): 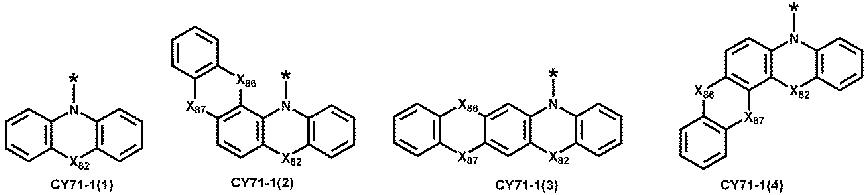 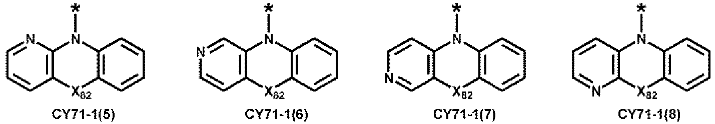 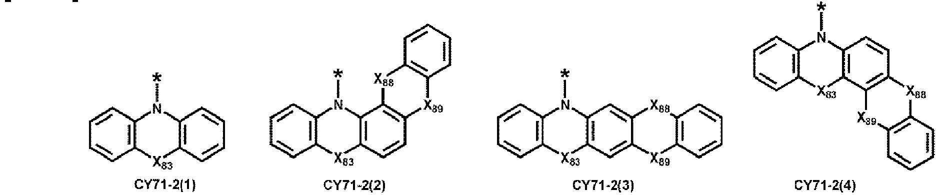 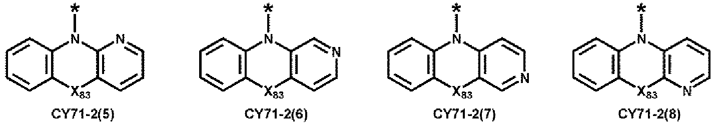 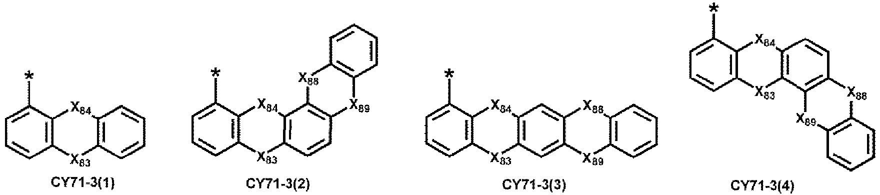 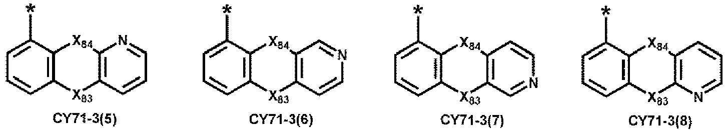 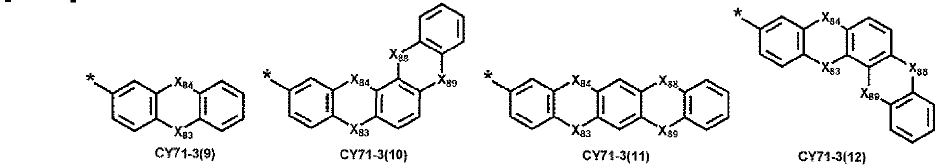 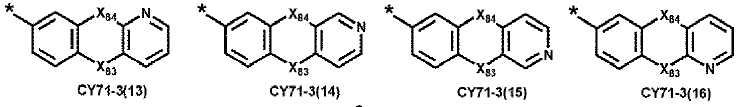 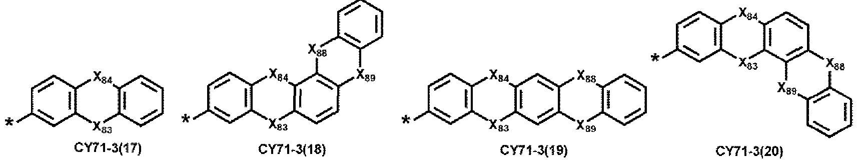 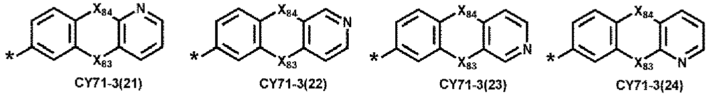 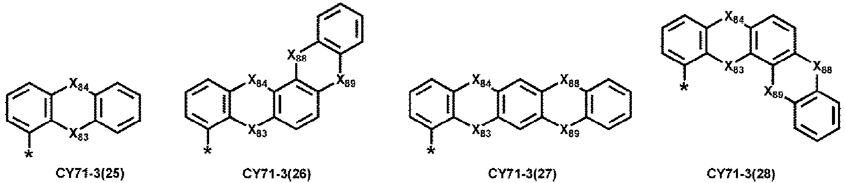 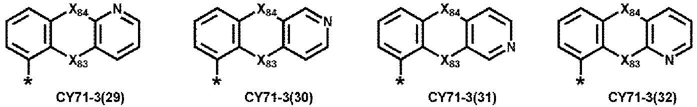 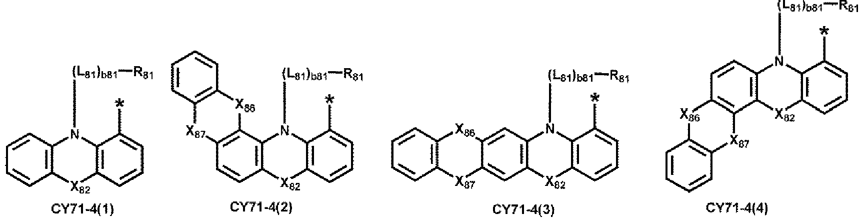 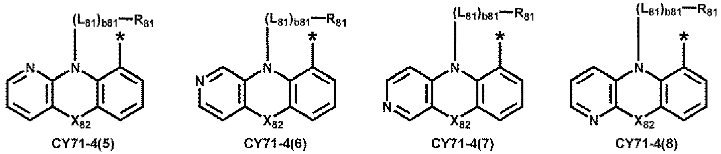 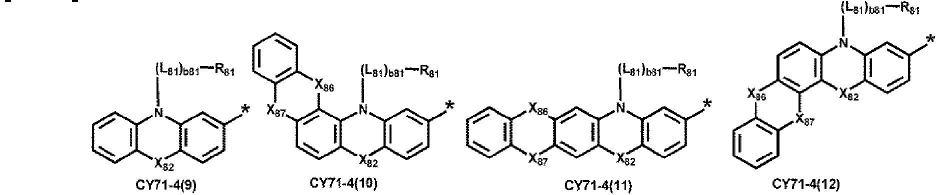 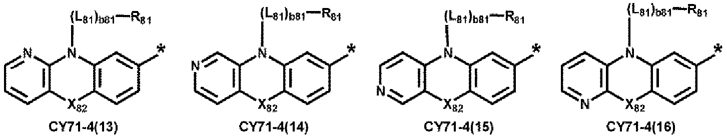 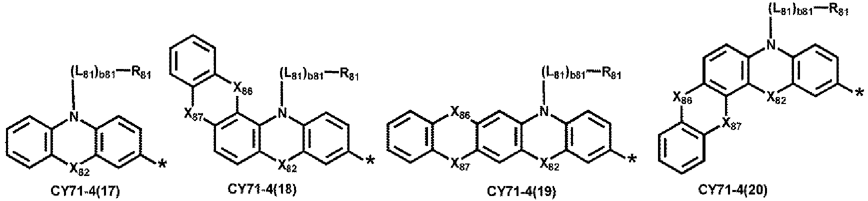 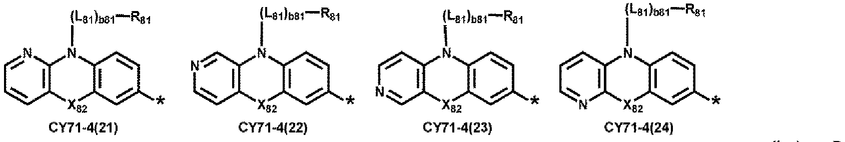 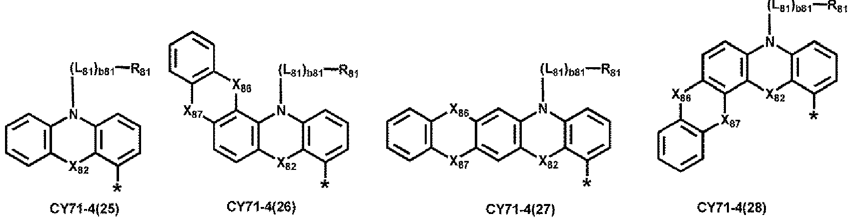 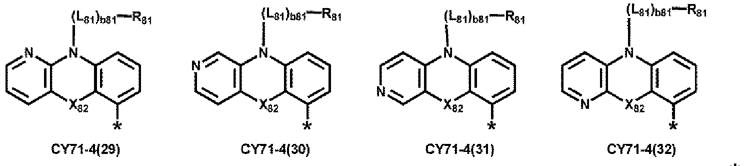 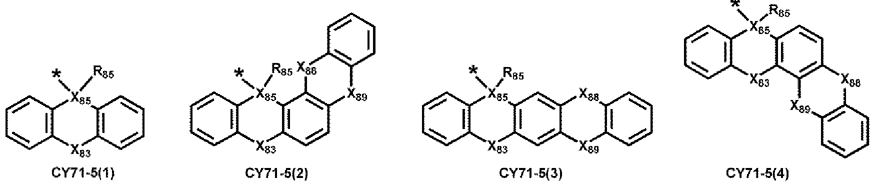 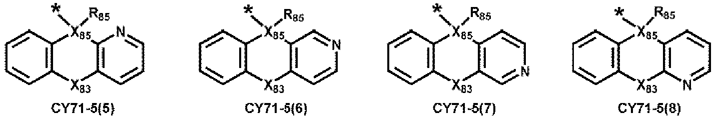
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
each of X₈₆ and X₈₇ in Formulae CY71-1(2) to CY71-1(4), CY71-4(2) to CY71-4(4), CY71-4(10) to CY71-4(12), CY71-4(18) to CY71-4(20), and CY71-4(26) to CY71-4(28) may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
each of X₈₈ and X₈₉ in Formulae CY71-2(2) to CY71-2(4), CY71-3(2) to CY71-3(4), CY71-3(10) to CY71-3(12), CY71-3(18) to CY71-3(20), CY71-3(26) to CY71-3(28), and CY71-5(2) to CY71-5(4) may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described in connection with R₈₁.
b51 to b53 in Formula 30 indicate numbers of L₅₁ to L₅₃, respectively, and may each be an integer from 1 to 5. When b51 may be 2 or more, two or more of L₅₁ may be identical to or different from each other, when b52 may be 2 or more, two or more of L₅₂ may be identical to or different from each other, and when b53 may be 2 or more, two or more of L₅₃ may be identical to or different from each other. In an embodiment, b51 to b53 may each independently be 1 or 2.
L₅₁ to L₅₃ in Formula 30 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxacilline group, a dibenzothiacilline group, a dibenzodihydroazacilline group, a dibenzodihydrodicilline group, a dibenzodihydrocilline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), and/or any combination thereof, and
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 30, a bond between L51 and R51, a bond between L52 and R52, a bond between L53 and R53, a bond between two or more L51(s), a bond between two or more L52(s), a bond between two or more L53(s), a bond between L51 and carbon between X54 and X55 in Formula 30, a bond between L52 and carbon between X54 and X56 in Formula 30, and a bond between L53 and carbon between X55 and X56 in Formula 30 may each be a "carbon-carbon single bond."

In Formula 30, X₅₄ may be N or C(R₅₄), X₅₅ may be N or C(R₅₅), X₅₆ may be N or C(R₅₆), and at least one of X₅₄ to X₅₆ may be N. R₅₄ to R₅₆ may each be the same as described herein. In an embodiment, two or three among X₅₄ to X₅₆ may each be N.

R₄₁ to R₄₅, R₅₁ to R₅₆, R₇₁ to R₇₄, R₈₁ to R₈₅, R₈₂ₐ, R_{82b}, R₈₃ₐ, R_{83b}, R₈₄ₐ, and R_{84b} in the present specification may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

For example, i) R₄₁ to R₄₅, R₅₁ to R₅₆, R₇₁ to R₇₄, R₈₁ to R₈₅, R₈₂ₐ, R_{82b}, R₈₃ₐ, R_{83b}, R₈₄ₐ, and R_{84b} in Formulae 20-1 to 20-5 and 30, and ii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, - F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, and/or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), and/or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, and/or any combination thereof. 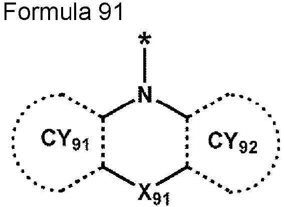 wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
   X₉₁ may be a single bond, O, S, N(R₉₁), B(R₉₁), C(R₉₁ₐ)(R_{91b}), or Si(R₉₁ₐ)(R_{91b}),
   R₉₁, R₉₁ₐ, and R_{91b} may be the same as described in connection with R₈₂, R₈₂ₐ, and R_{82b}, respectively,
   R₁₀ₐ may be the same as described herein, and
   * indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, and/or any combination thereof.

In some embodiments, i) R₄₁ to R₄₅, R₅₁ to R₅₆, R₇₁ to R₇₄, R₈₁ to R₈₅, R₈₂ₐ, R_{82b}, R₈₃ₐ, R_{83b}, R₈₄ₐ and R_{84b} in Formulae 20-1 to 20-5, 30 and 40, and ii) R₁₀ₐ may each independently be hydrogen, deuterium, -F, a cyano group, a nitro group, -CH₃, -CD₃, - CD₂H, -CDH₂, -CF₃, -CF₂H, -CFH₂, a group represented by one of Formulae 9-1 to 9-67 below, a group represented by one of Formulae 10-1 to 10-154 and 10-201 to 10-368, - C(Q₁)(Q₂)(Q₃), -Si(Q₁)(Q₂)(Q₃), or -P(=O)(Q₁)(Q₂) (however, the description of Q₁ to Q₃ may be referred to as described in this specification):

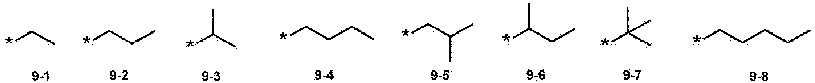

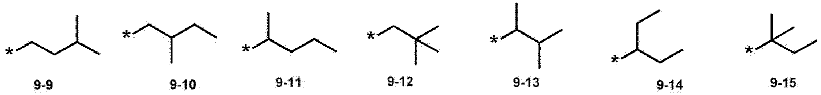

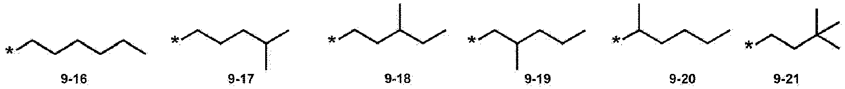

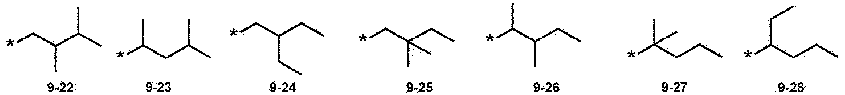

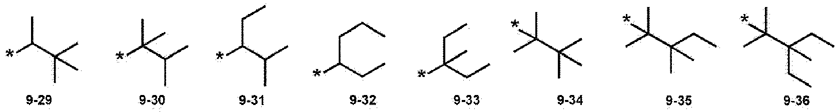

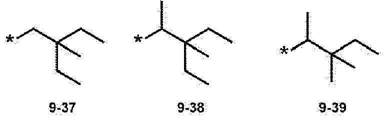

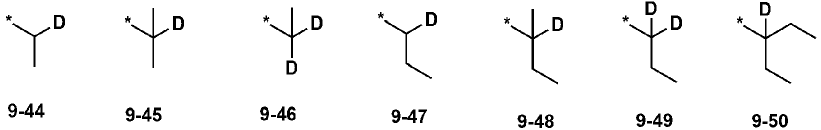

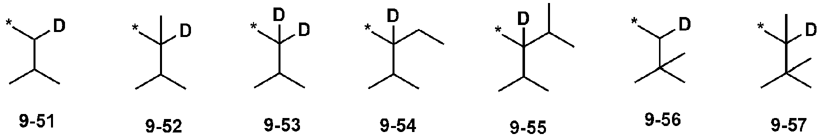

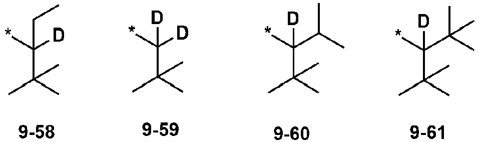

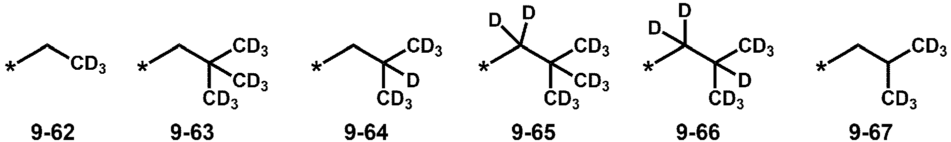

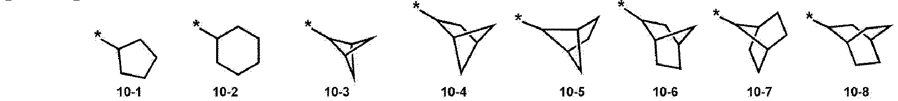

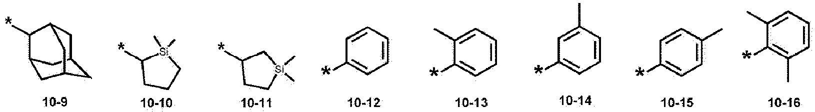

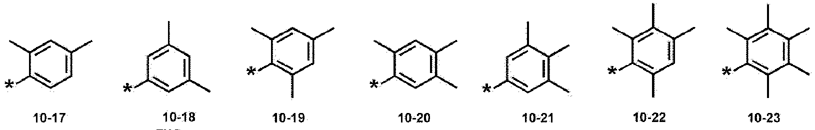

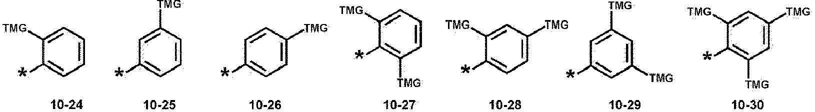

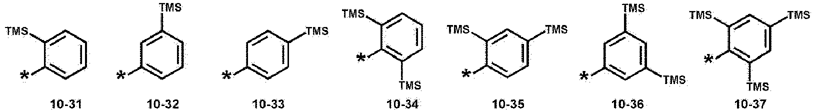

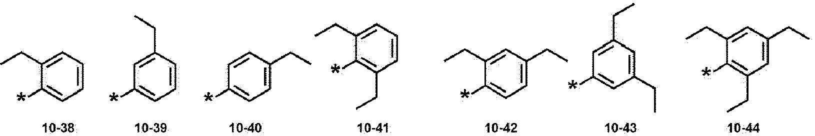

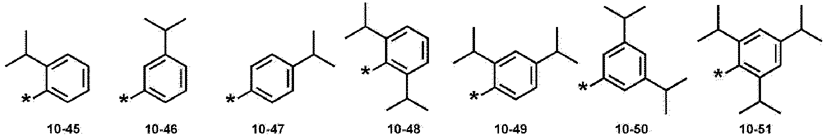

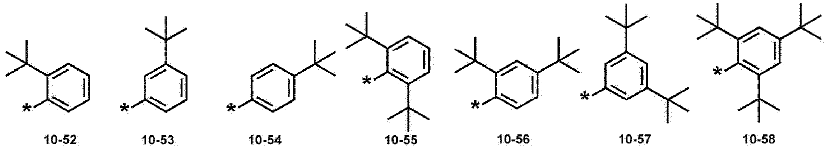

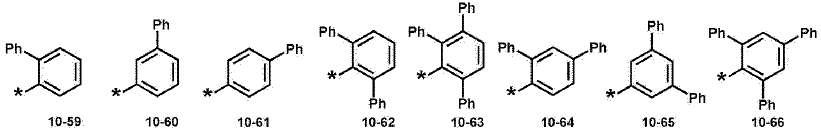

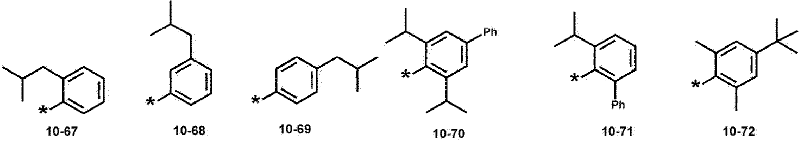

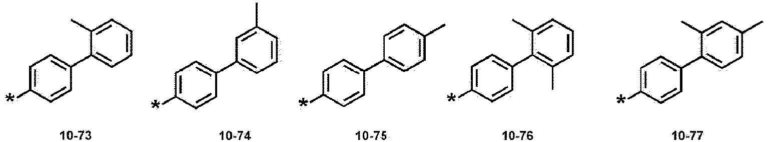

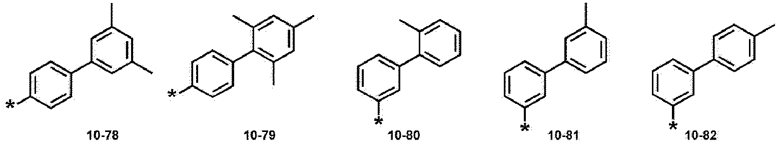

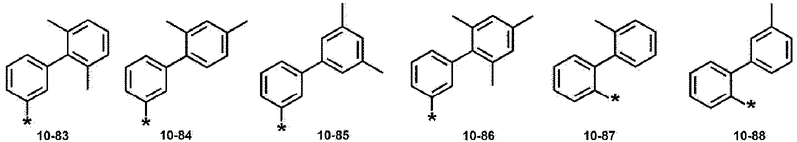

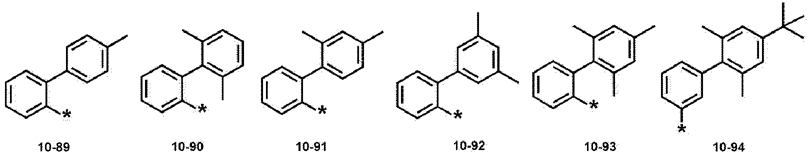

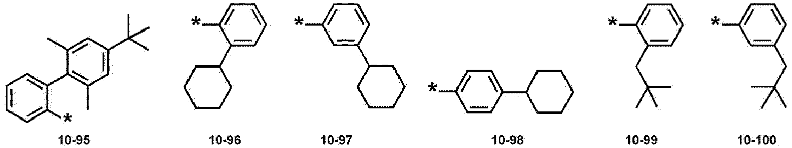

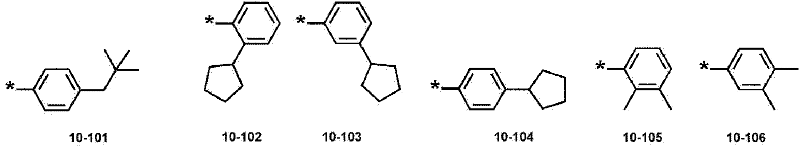

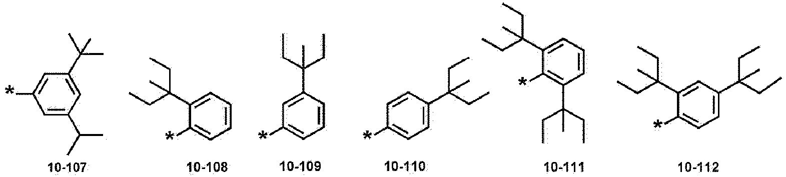

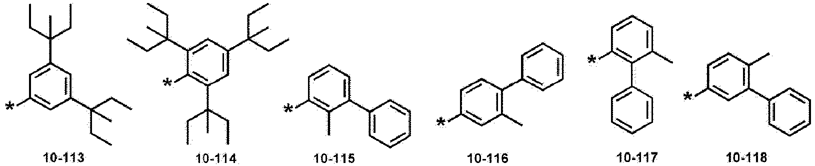

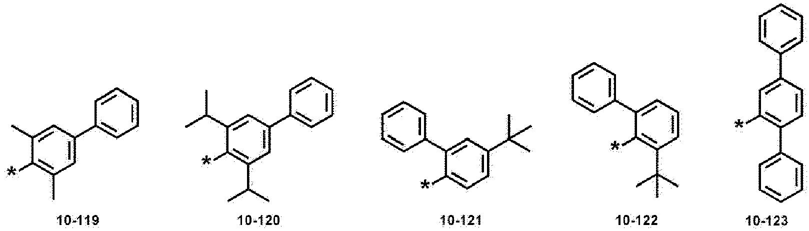

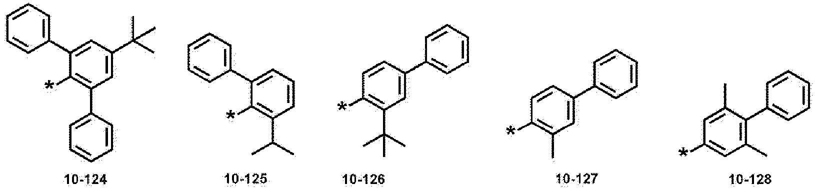

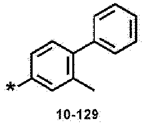

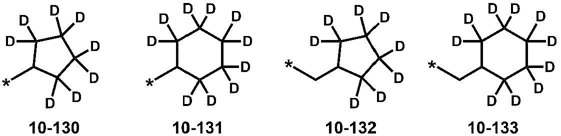

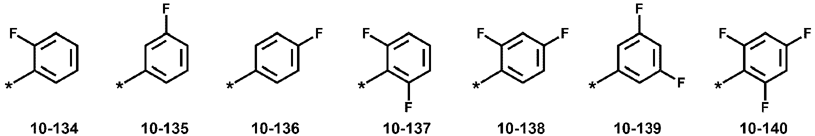

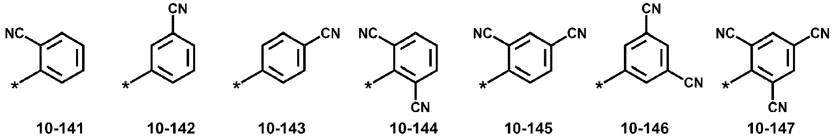

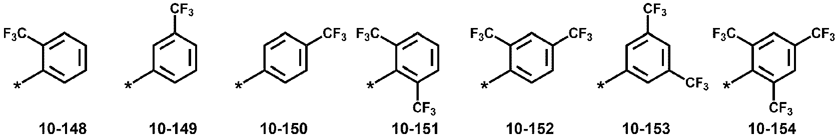

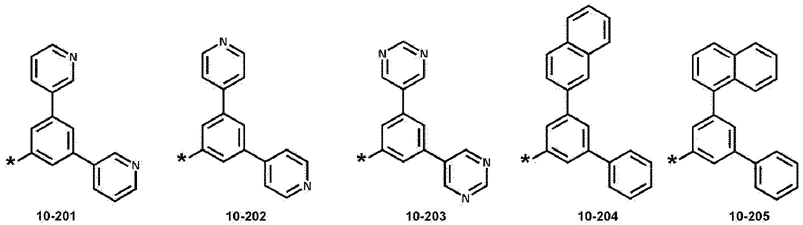

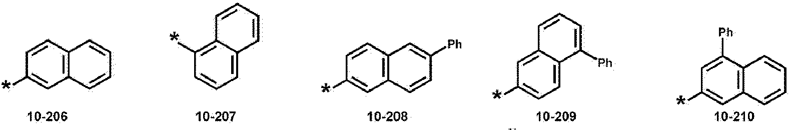

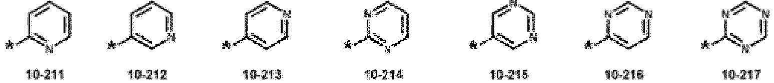

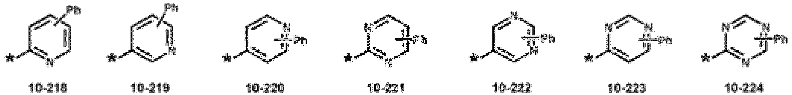

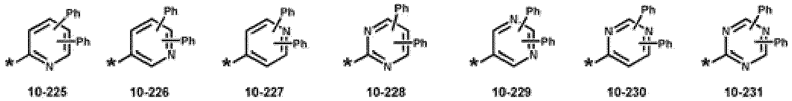

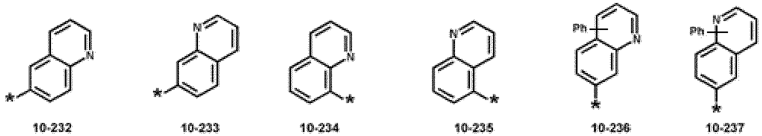

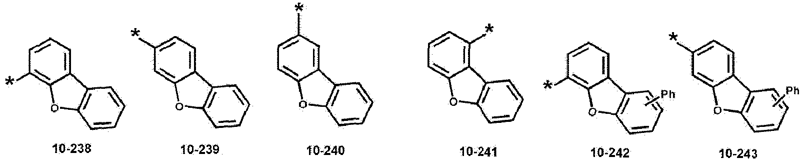

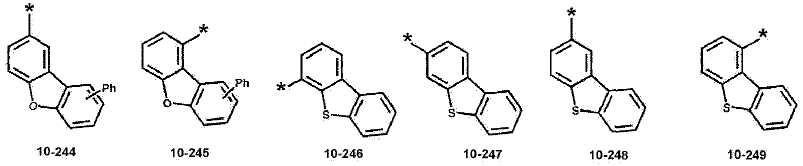

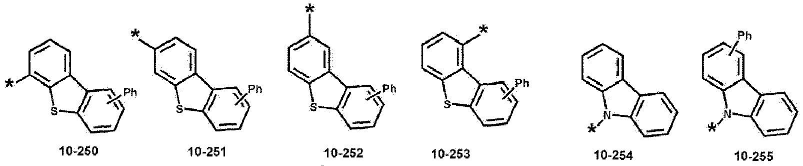

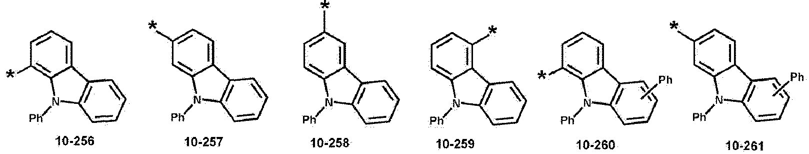

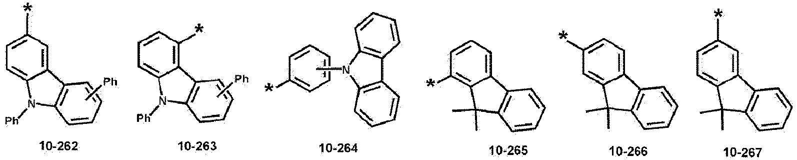

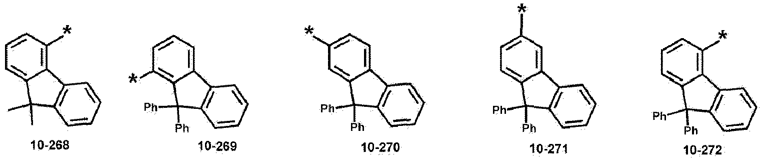

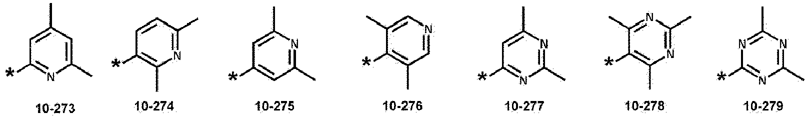

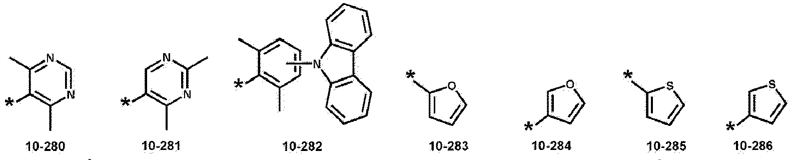

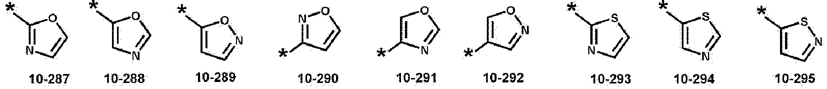

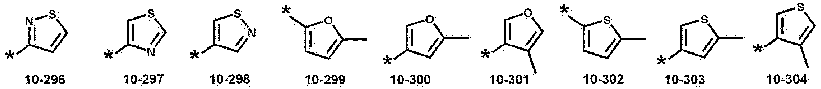

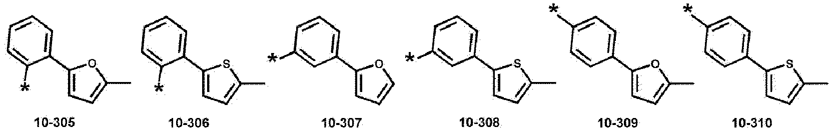

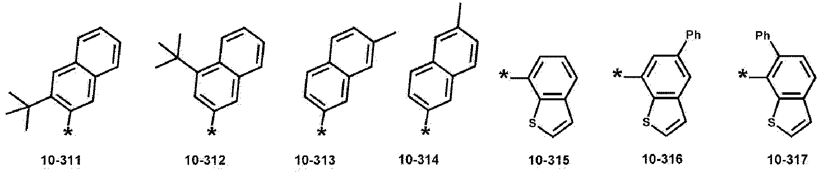

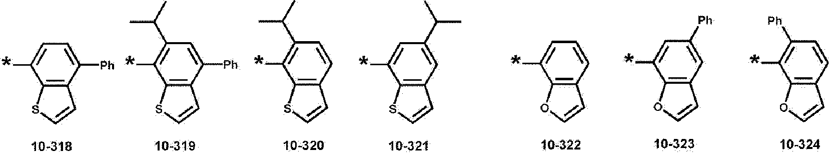

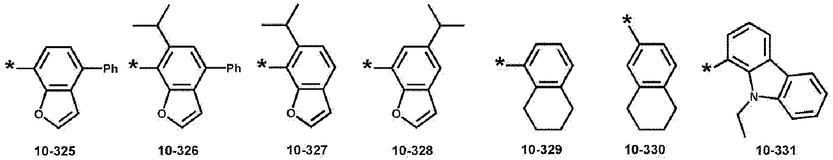

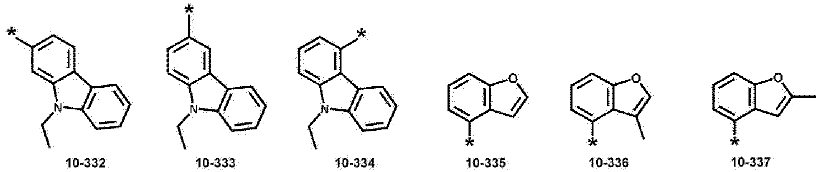

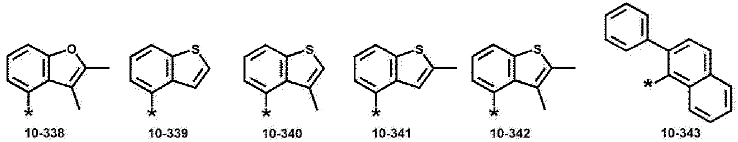

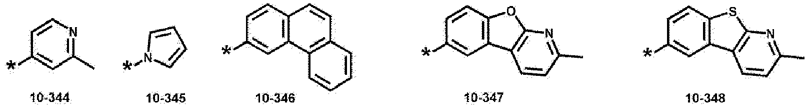

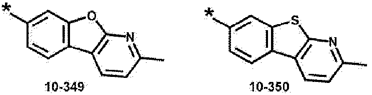

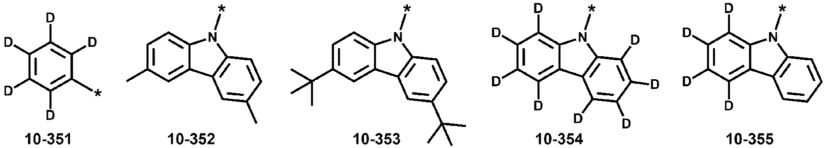

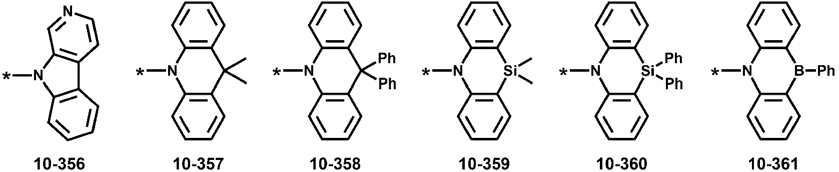

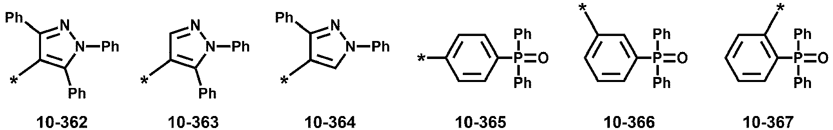

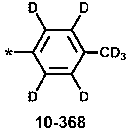

In Formulae 9-1 to 9-67, 10-1 to 10-154 and 10-201 to 10-368, * represents a bonding site with a neighboring atom, Ph represents a phenyl group, TMS represents a trimethylsilyl group, and TMG represents a trimethylgermyl group.
a71 to a74 and a501 to a504 in Formulae 20-1 to 20-5 respectively indicate the number of R₇₁ to the number of R₇₄, and may each independently be an integer from 0 to 20. When a71 may be 2 or more, two or more of R₇₁ may be identical to or different from each other, when a72 may be 2 or more, two or more of R₇₂ may be identical to or different from each other, when a73 may be 2 or more, two or more of R₇₃ may be identical to or different from each other, and when a74 may be 2 or more, two or more of R₇₄ may be identical to or different from each other. a71 to a74 may each independently be an integer from 0 to 8.

In Formula 30, a group represented by *-(L₅₁)_{b51}-R₅₁ and a group represented by *-(L₅₂)_{b52}-R₅₂ may each not be a phenyl group.

In an embodiment, in Formula 30, a group represented by *-(L₅₁)_{b51}-R₅₁ and a group represented by *-(L₅₂)_{b52}-R₅₂ may be identical to each other.

In an embodiment, in Formula 30, a group represented by *-(L₅₁)_{b51}-R₅₁ and a group represented by *-(L₅₂)_{b52}-R₅₂ may be different from each other.

In an embodiment, in Formula 30, b₅₁ and b₅₂ may each independently be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

In an embodiment, R₅₁ and R₅₂ in Formula 30 may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or -Si(Q₁)(Q₂)(Q₃), and
Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, and/or any combination thereof.

In an embodiment,
a group represented by *-(L₅₁)_{b51}-R₅₁ in Formula 30 may be a group represented by one of Formulae CY51-1 to CY51-26, and/or
a group represented by *-(L₅₂)_{b52}-R₅₂ in Formula 30 may be a group represented by one of Formulae CY52-1 to CY52-26, and/or
a group represented by *-(L₅₃)_{b53}-R₅₃ in Formula 30 may be a group represented by one of Formulae CY53-1 to CY53-27, -C(Q₁)(Q₂)(Q₃), or -Si(Q₁)(Q₂)(Q₃): 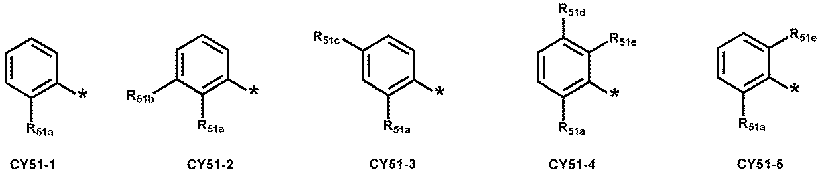 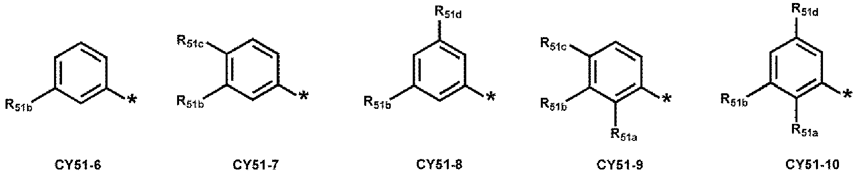 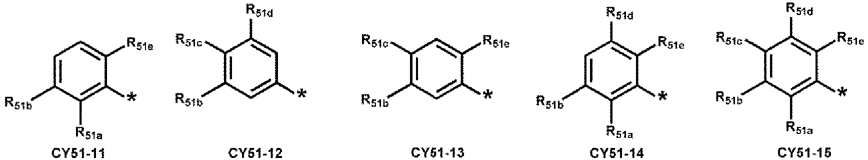 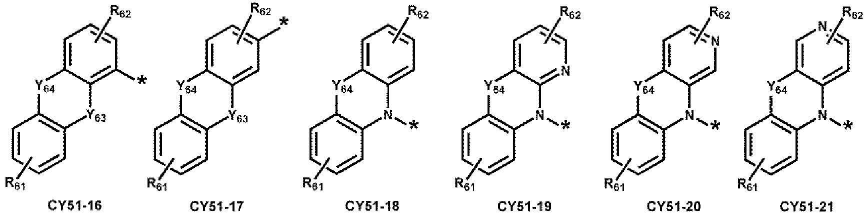 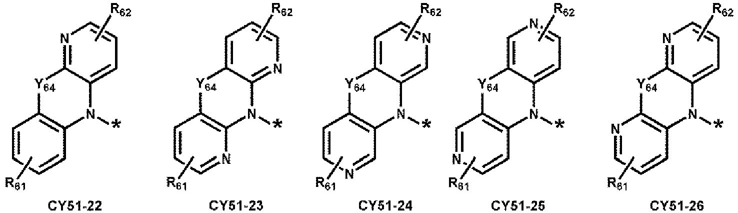 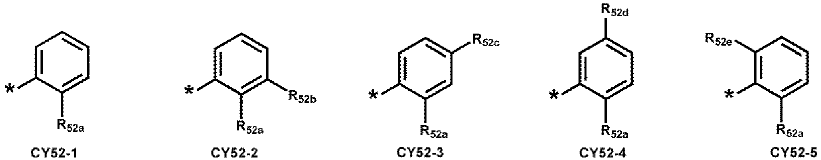 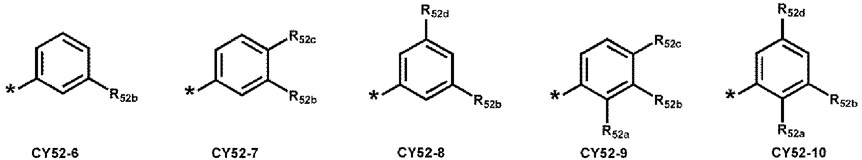 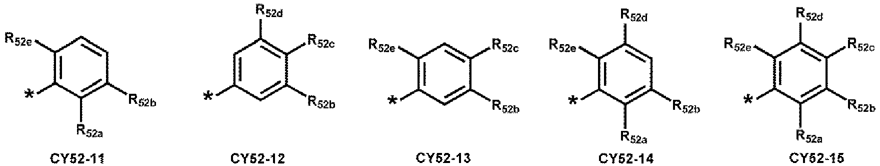 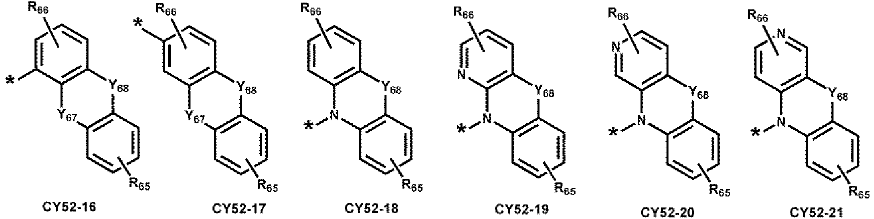 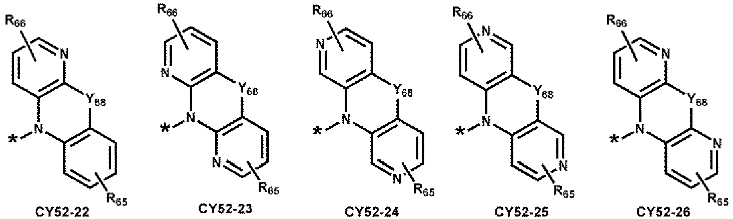 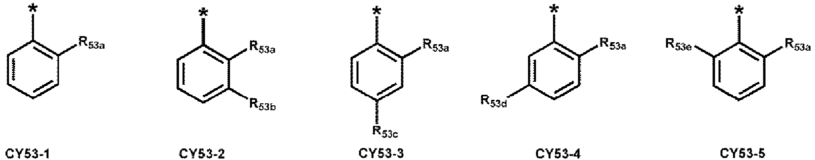 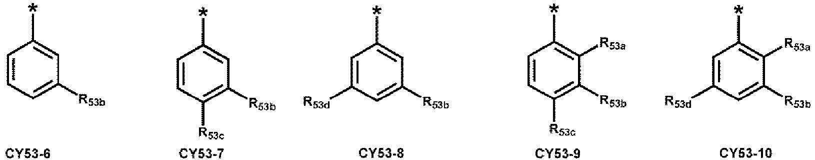 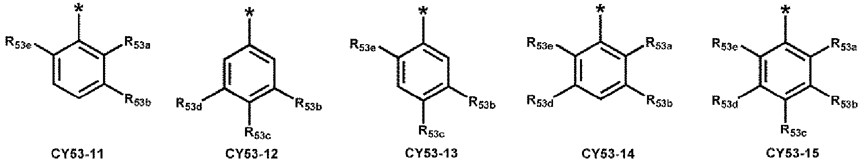 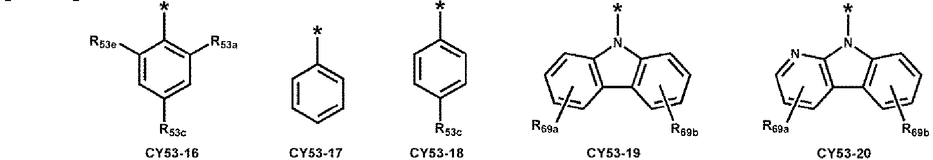 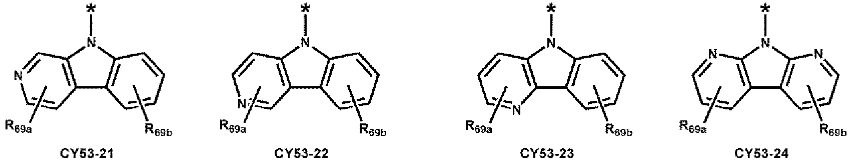 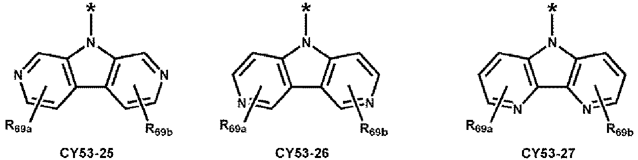
wherein, in Formulae CY51-1 to CY51-26, CY52-1 to CY52-26, and CY53-1 to CY53-27,
Y₆₃ may be a single bond, O, S, N(R₆₃), B(R₆₃), C(R₆₃ₐ)(R_{63b}), or Si(R₆₃ₐ)(R_{63b}),
Y₆₄ may be a single bond, O, S, N(R₆₄), B(R₆₄), C(R₆₄ₐ)(R_{64b}), or Si(R₆₄ₐ)(R_{64b}),
Y₆₇ may be a single bond, O, S, N(R₆₇), B(R₆₇), C(R₆₇ₐ)(R_{67b}), or Si(R₆₇ₐ)(R_{67b}),
Y₆₈ may be a single bond, O, S, N(R₆₈), B(R₆₈), C(R₆₈ₐ)(R_{68b}), or Si(R₆₈ₐ)(R_{68b}),
each of Y₆₃ and Y₆₄ in Formulae CY51-16 and CY51-17 may not be a single bond at the same time,
each of Y₆₇ and Y₆₈ in Formulae CY52-16 and CY52-17 may not be a single bond at the same time,
R₅₁ₐ to R₅₁ₑ, R₆₁ to R₆₄, R₆₃ₐ, R_{63b}, R₆₄ₐ, and R_{64b} may each be the same as described in connection with R₅₁, wherein R₅₁ₐ to R₅₁ₑ may each not be hydrogen,
R₅₂ₐ to R₅₂ₑ, R₆₅ to R₆₈, R₆₇ₐ, R_{67b}, R₆₈ₐ, and R_{68b} may each be the same as described in connection with R₅₂, wherein R₅₂ₐ to R₅₂ₑ may each not be hydrogen,
R₅₃ₐ to R₅₃ₑ, R₆₉ₐ, and R_{69b} may each be the same as described in connection with R₅₃, wherein R₅₃ₐ to R₅₃ₑ may each not be hydrogen, and
* indicates a binding site to a neighboring atom.

In an embodiment,
in Formulae CY51-1 to CY51-26 and CY52-1 to 52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, and/or any combination thereof; or
-C(Q₁)(Q₂)(Q₃) or -Si(Q₁)(Q₂)(Q₃),
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, and/or any combination thereof,
in Formulae CY51-16 and CY51-17, i) Y₆₃ may be O or S, and Y₆₄ may be Si(R₆₄ₐ)(R_{64b}), or ii) Y₆₃ may be Si(R₆₃ₐ)(R_{63b}), and Y₆₄ may be O or S, and
in Formulae CY52-16 and CY52-17, i) Y₆₇ may be O or S, and Y₆₈ may be Si(R₆₈ₐ)(R_{68b}), or ii) Y₆₇ may be Si(R₆₇ₐ)(R_{67b}), and Y₆₈ may be O or S.

In Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), and/or any combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 402 may be 2 or more, two ring A₄₀₁(s) in two or more of L₄₀₁(s) may optionally be linked to each other via T₄₀₂, which may be a linking group, or two ring A₄₀₂(s) may optionally be linked to each other via T₄₀₃, which may be a linking group (see compounds PD1 to PD4 and PD7). T₄₀₂ and T₄₀₃ are each as described in connection with T₄₀₁.

L₄₀₂ in Formula 401 may be an organic ligand. In an embodiment, L402 may include a halogen group, a diketone group (for example, an acetylacetonate group), a carboxylic acid group (for example, a picolinate group), -C(=O), an isonitrile group, a -CN group, a phosphorus group (for example, a phosphine group, a phosphite group, etc.), and/or any combination thereof.

In an embodiment, the third compound may include a group represented by Formula 401:

Formula 401 M(L401)xc1(L402)xc2

Formula 402 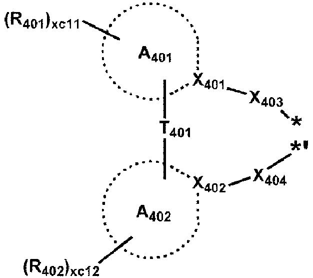 wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 may be 2 or more, two or more of L₄₀₁ may be identical to or different from each other,
L₄₀₂ may be an organic ligand, and xc2 may be 0, 1, 2, 3, or 4, wherein, when xc2 may be 2 or more, two or more of L₄₀₂ may be identical to or different from each other,
X₄₀₁ and X₄₀₂ may each independently be nitrogen or carbon,
ring A₄₀₁ and ring A₄₀₂ may each independently a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond, O, S, N(Q₄₁₃), B(Q₄₁₃), P(Q₄₁₃), C(Q₄₁₃)(Q₄₁₄), or Si(Q₄₁₃)(Q₄₁₄),
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O)(Q₄₀₁)(Q₄₀₂),
xc11 and xc12 may each independently be an integer from 0 to 10, and
Q₄₁₁ to Q₄₁₄ and Q₄₀₁ to Q₄₀₃ may each independently be: hydrogen; deuterium; - F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group, a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, and/or any combination thereof, a C₇-C₆₀ arylalkyl group, or a C₂-C₆₀ heteroarylalkyl group,
* and *' in Formula 402 each indicate a binding site to M in Formula 401, and
R₁₀ₐ may be the same as described herein.

In some embodiments, the fourth compound may be a compound represented by Formula 502, a compound represented by Formula 503, and/or any combination thereof:

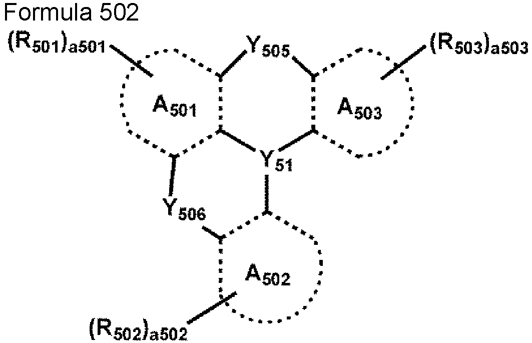

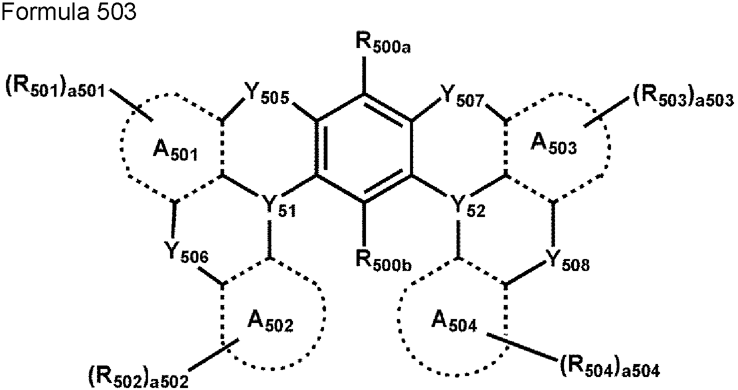

wherein, in Formulae 502 and 503,
ring A₅₀₁ to ring A₅₀₄ may each independently be a C₃-C₆₀ carbocyclic group or a C₁-C₆₀ heterocyclic group,
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each be as described herein, and
a501 to a504 may each independently be an integer from 0 to 20.
R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in the present specification may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

In some embodiments, R₅₁ to R₅₆, R₇₁ to R₇₄, R₈₁ to R₈₅, R₈₂ₐ, R_{82b}, R₈₃ₐ, R_{83b}, R₈₄ₐ and R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, R_{508b}, and R₁₀ₐ may each independently be
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, - F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, and/or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), and/or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a secbutyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, and/or any combination thereof.

### [Specific examples of compounds]

In an embodiment, the first compound may be one of the following compounds:

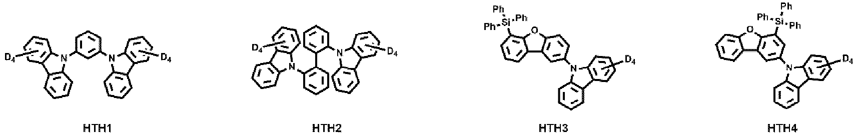

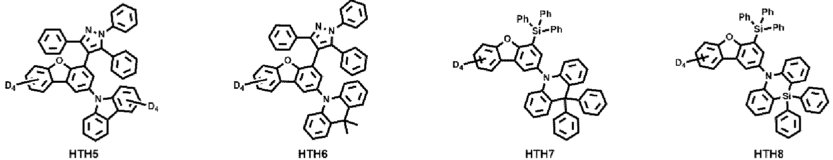

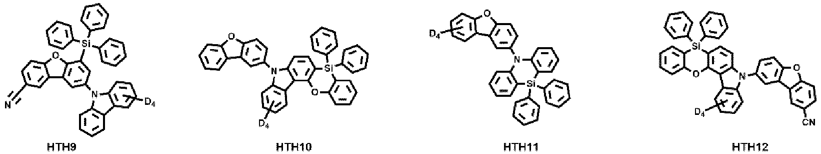

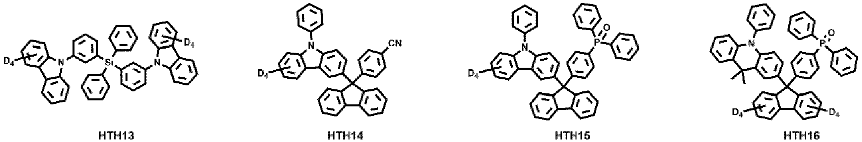

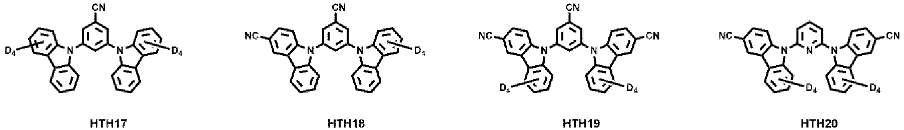

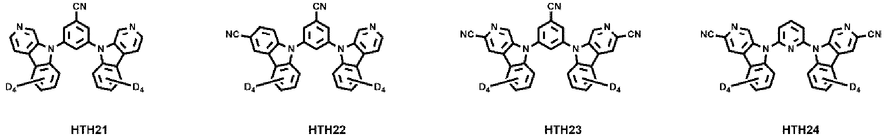

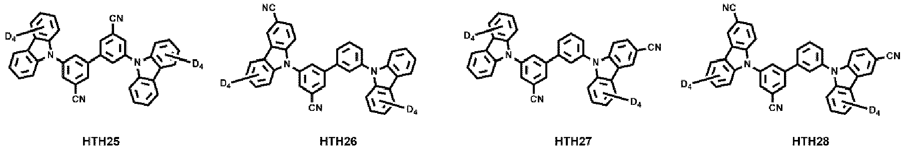

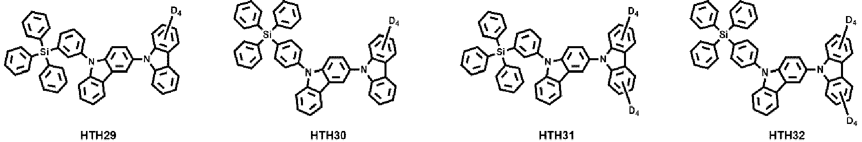

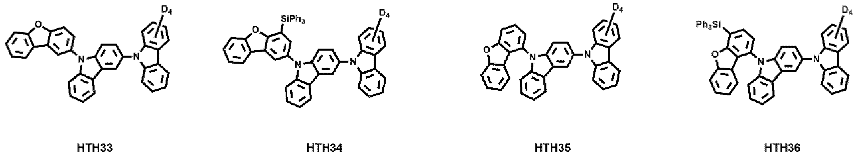

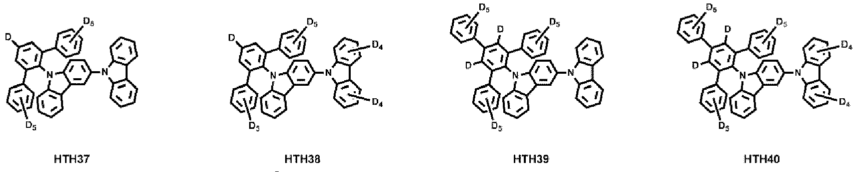

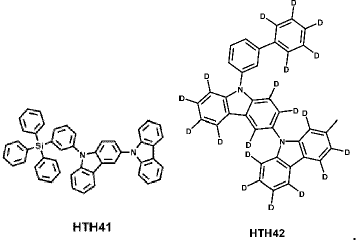

In an embodiment, the second compound may be one of the following compounds:

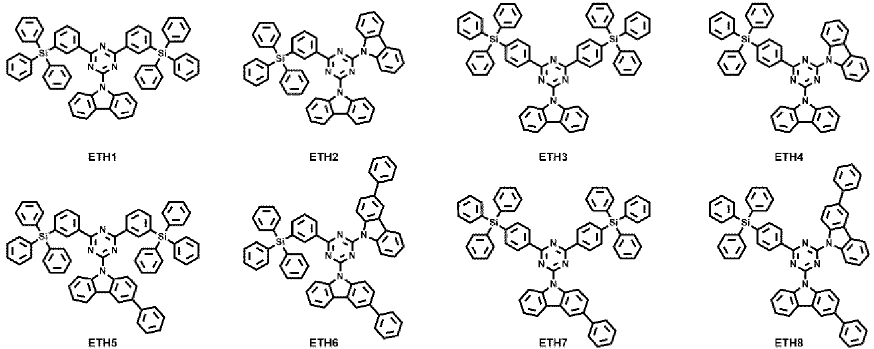

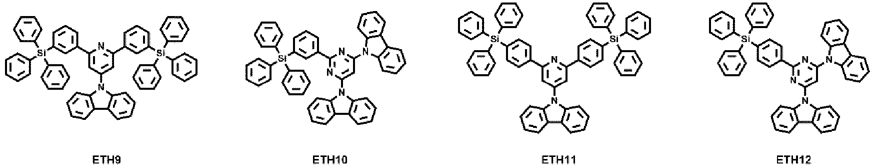

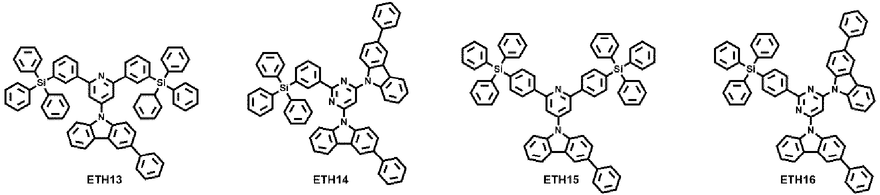

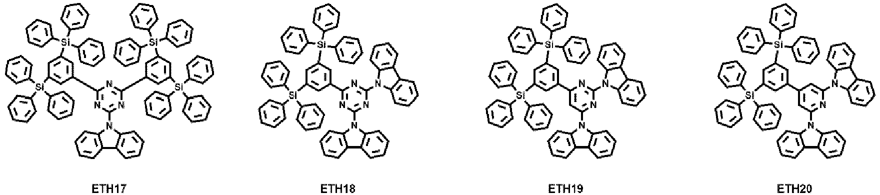

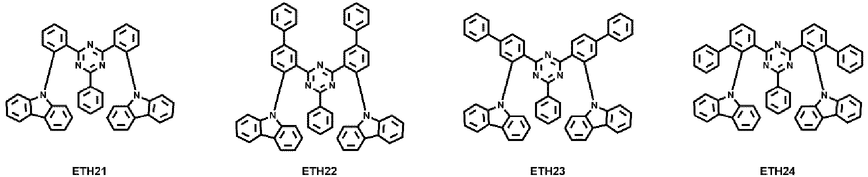

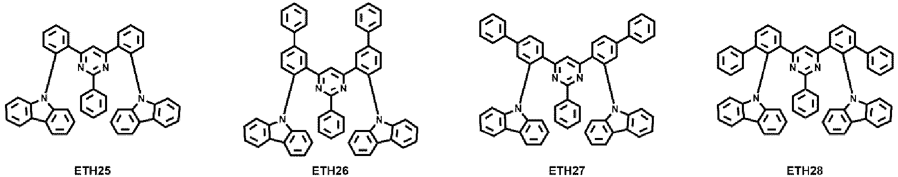

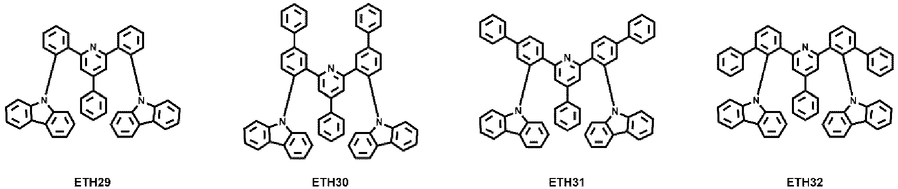

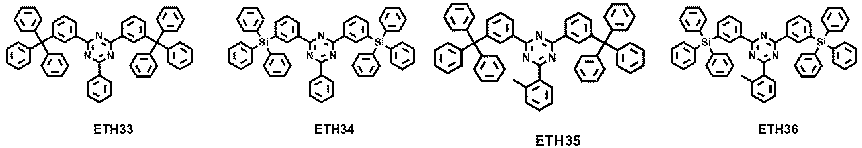

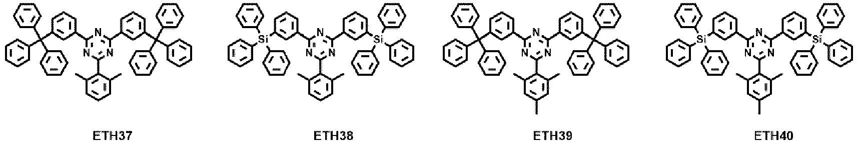

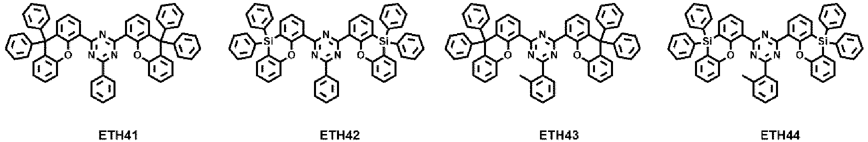

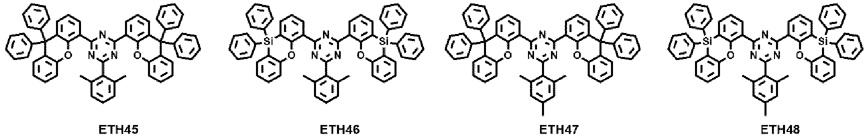

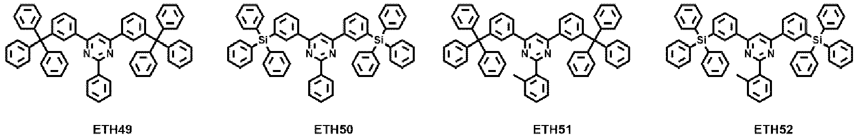

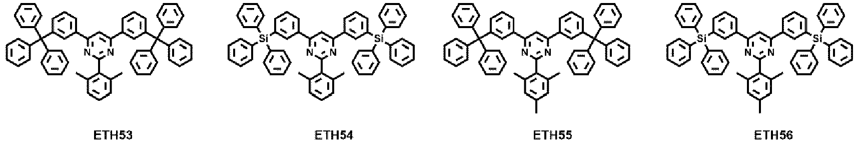

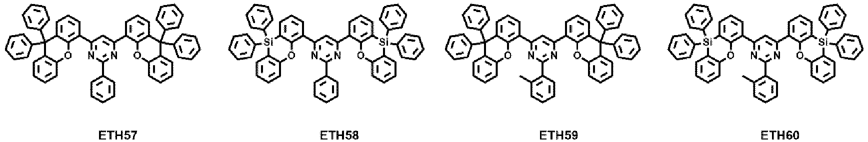

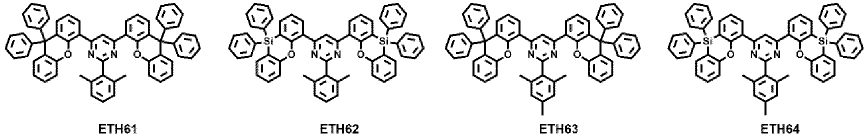

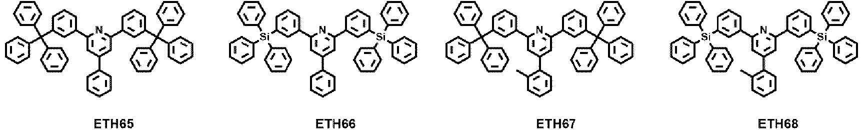

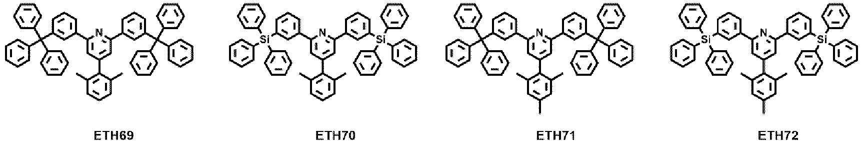

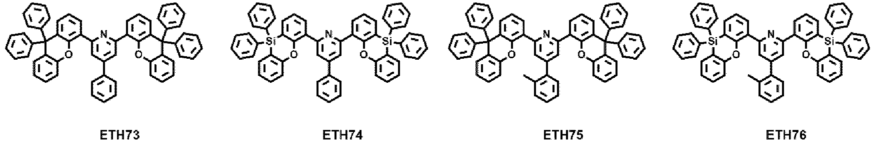

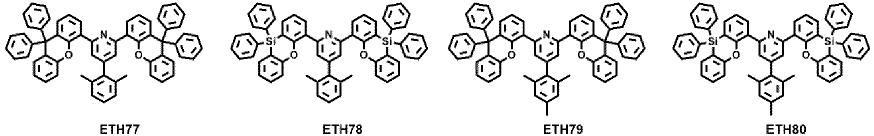

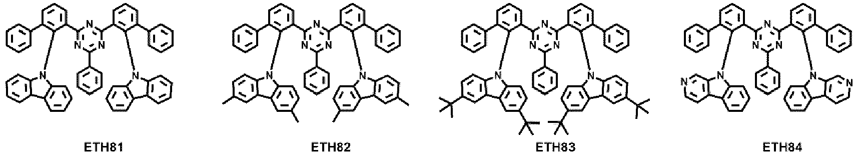

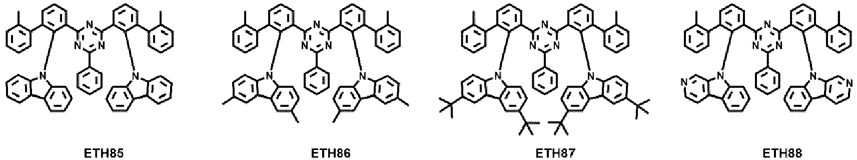

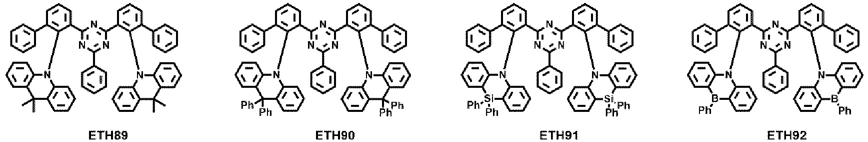

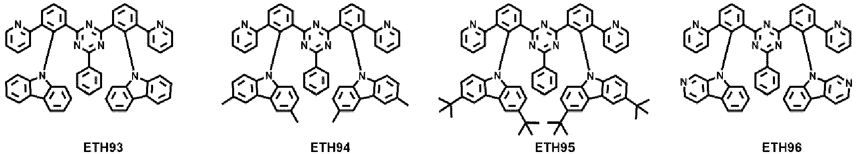

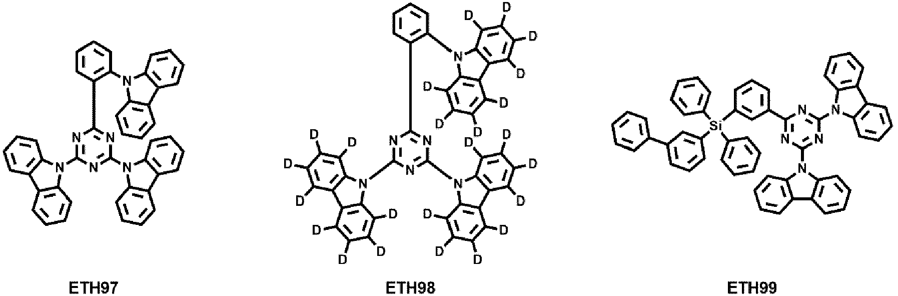

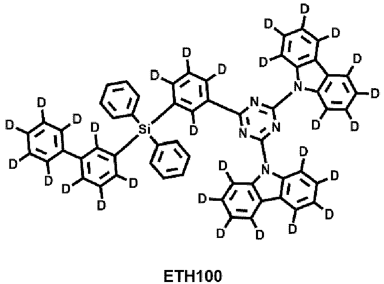

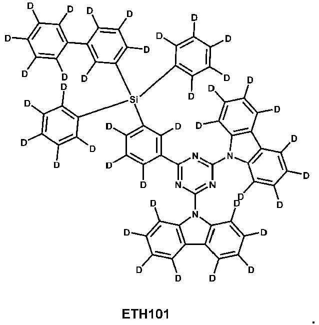

In an embodiment, the third compound may be one of the following compounds:

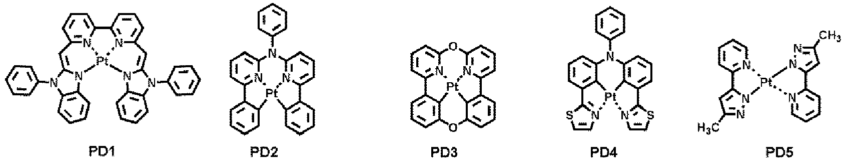

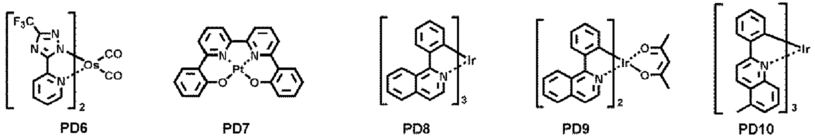

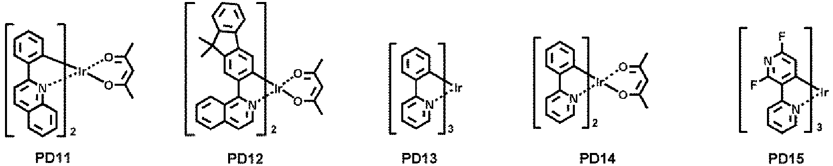

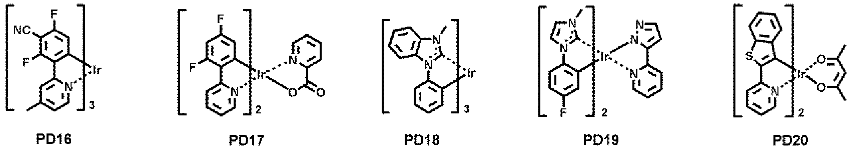

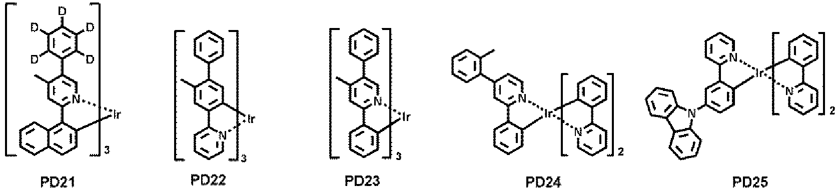

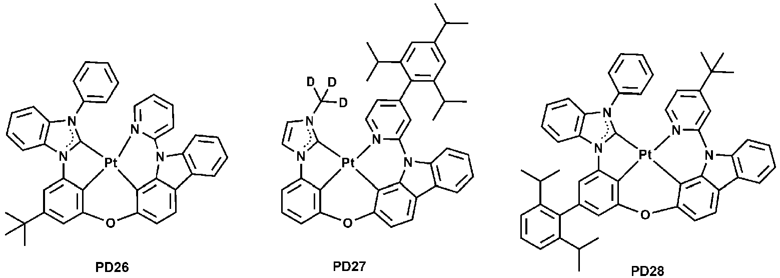

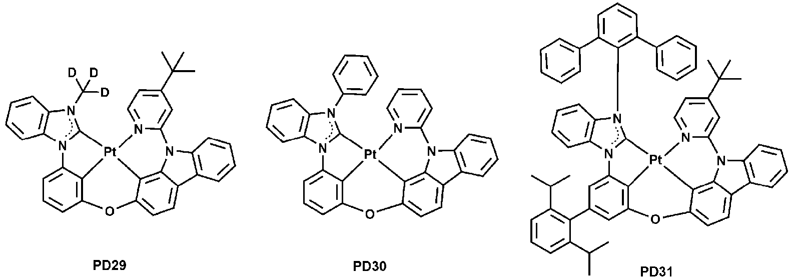

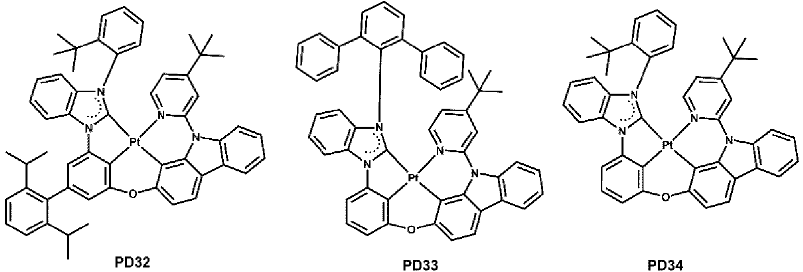

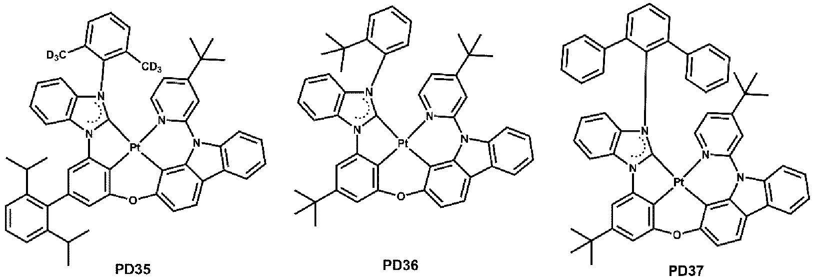

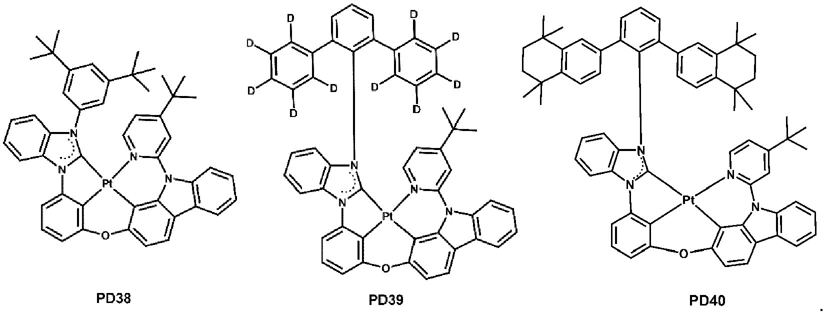

In an embodiment, the fourth compound may be any one of the following compounds:

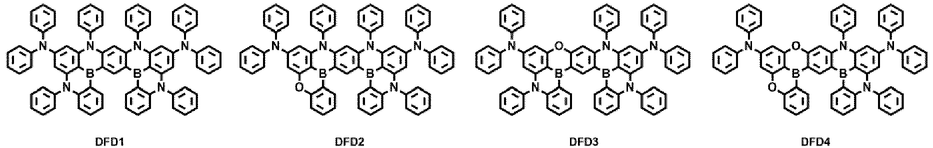

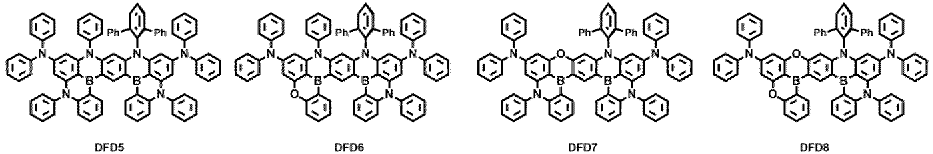

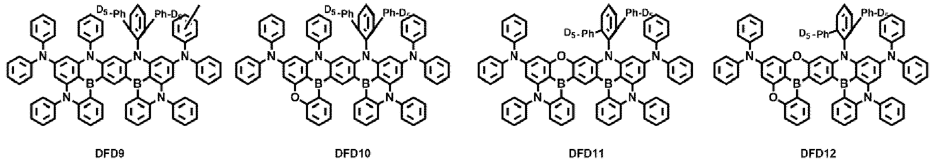

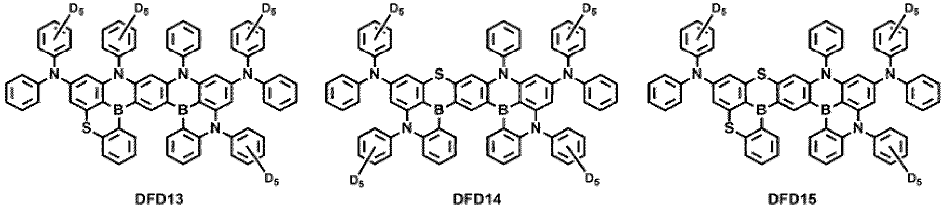

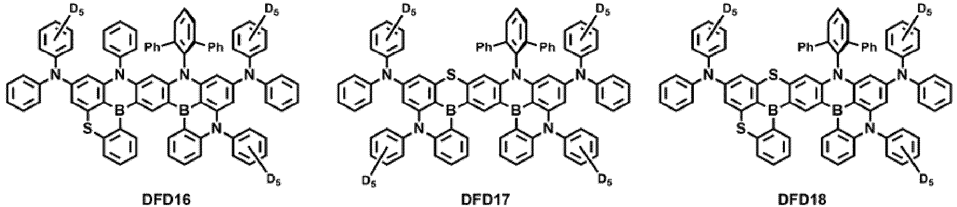

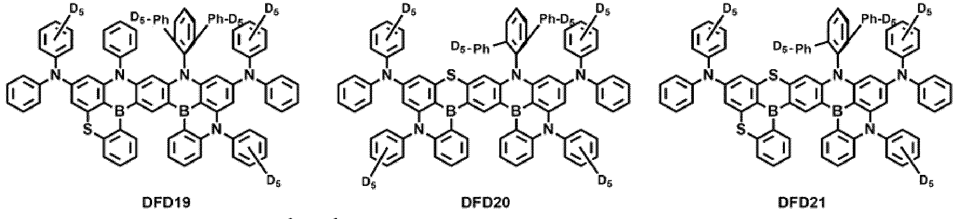

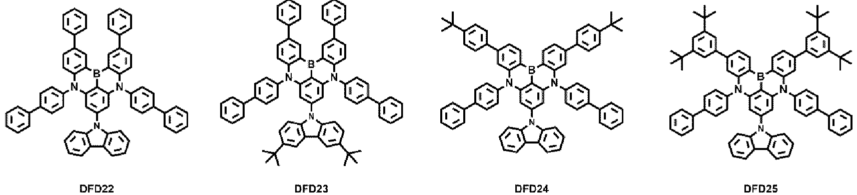

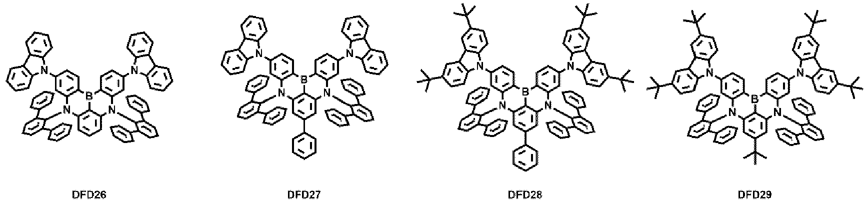

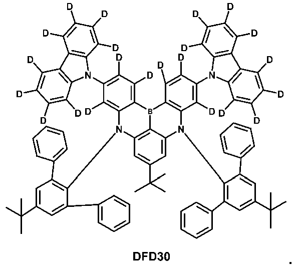

### [Host]

In an embodiment, the host may include a compound represented by Formula 301.

In this regard, the first compound and the second compound may be hosts. Therefore, the description of Formula 301 below may be applied to the description of the first compound and the second compound.

Formula 301 [Ar301]xb11-[(L301)xb1-R301]xb21

wherein, in Formula 301,
Ar₃₀₁ and L₃₀₁ may each independently be a C₃-C₆₀ carbocyclic group that may be unsubstituted or substituted with at least one R₁₀ₐ or a C₁-C₆₀ heterocyclic group that may be unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group that may be unsubstituted or substituted with at least one R₁₀ₐ, a C₂-C₆₀ alkenyl group that may be unsubstituted or substituted with at least one R₁₀ₐ, a C₂-C₆₀ alkynyl group that may be unsubstituted or substituted with at least one R₁₀ₐ, a C₁-C₆₀ alkoxy group that may be unsubstituted or substituted with at least one R₁₀ₐ, a C₃-C₆₀ carbocyclic group that may be unsubstituted or substituted with at least one R₁₀ₐ, a C₁-C₆₀ heterocyclic group that may be unsubstituted or substituted with at least one R₁₀,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ are each as described in connection with Q₁.

In an embodiment, when xb11 in Formula 301 may be 2 or more, two or more of Ar₃₀₁ may be linked to each other via a single bond.

In an embodiment, the host may include a compound represented by Formula 301-1, a compound represented by Formula 301-2, and/or any combination thereof:

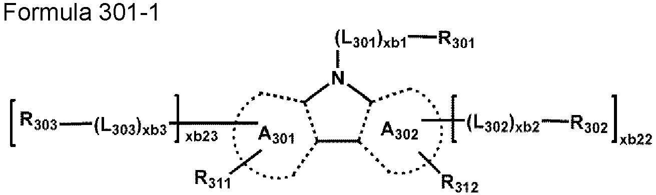

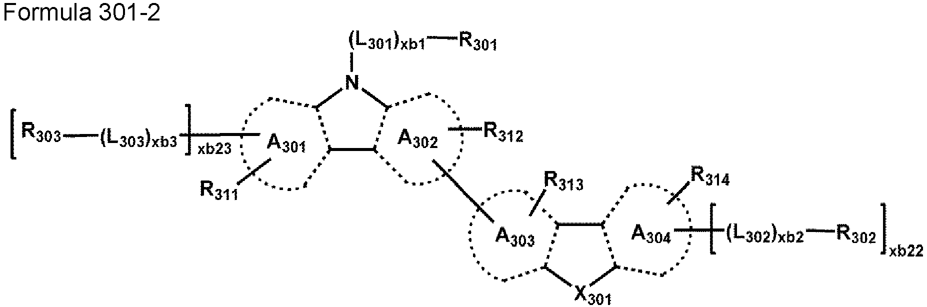

wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ are each as described in the present specification,
L₃₀₂ to L₃₀₄ are each independently as described in connection with L₃₀₁,
xb2 to xb4 are each independently as described in connection with xb1, and
R₃₀₂ to R₃₀₅ and R₃₁₁ to R₃₁₄ are each as described in connection with R₃₀₁.

In an embodiment, the host may include an alkali earth metal complex, a posttransition metal complex, and/or any combination thereof. In an embodiment, the host may include a Be complex (for example, compound H55), an Mg complex, a Zn complex, and/or any combination thereof.

In one or more embodiments, the host may include: one of Compounds H1 to H128; 9,10-di(2-naphthyl)anthracene (ADN); 2-methyl-9,10-bis(naphthalen-2-yl)anthracene (MADN); 9,10-di(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); or any combination thereof:

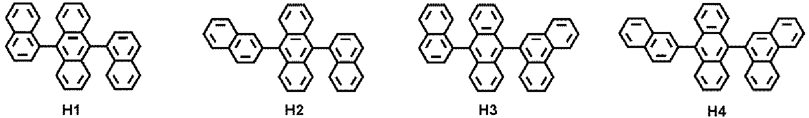

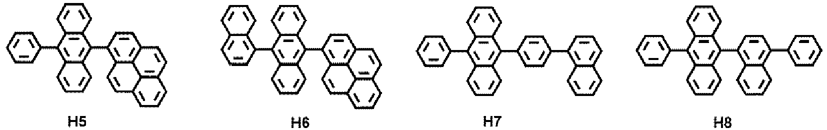

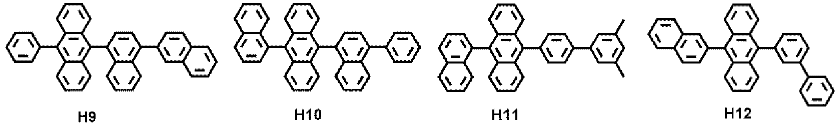

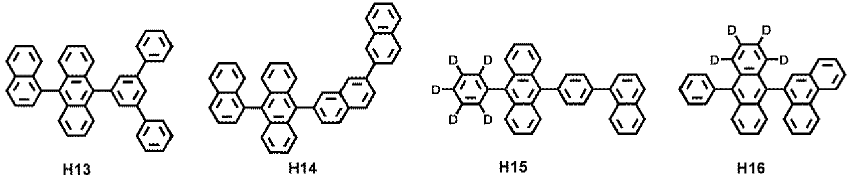

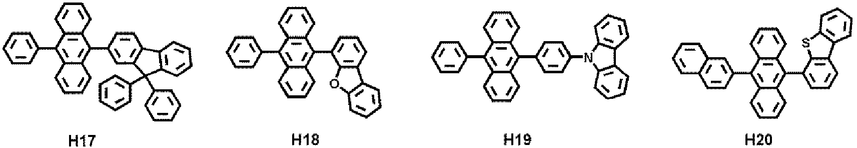

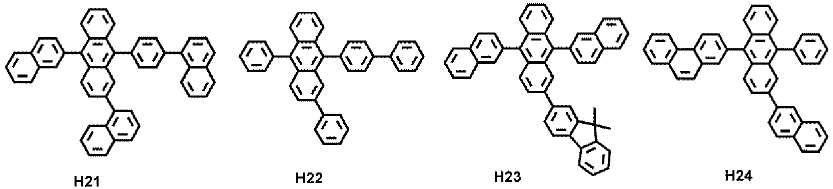

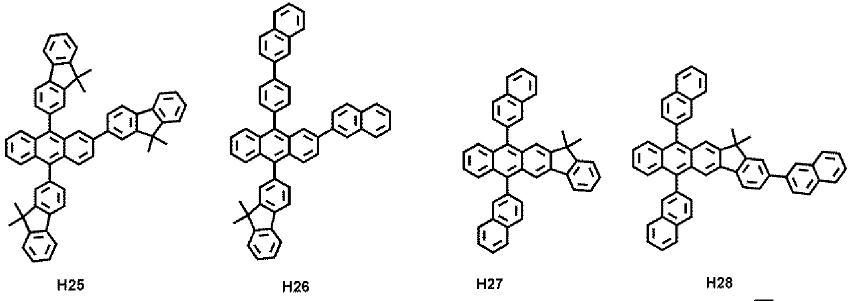

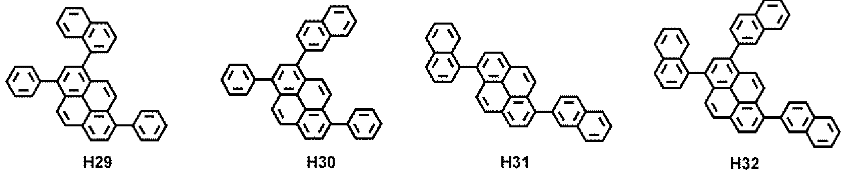

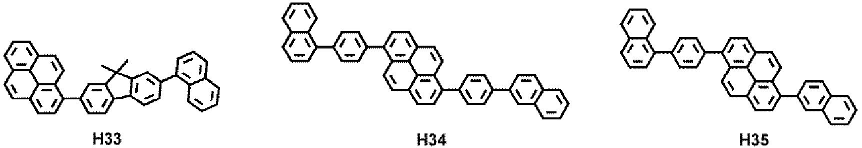

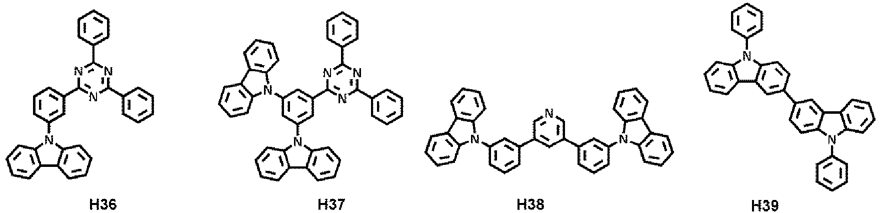

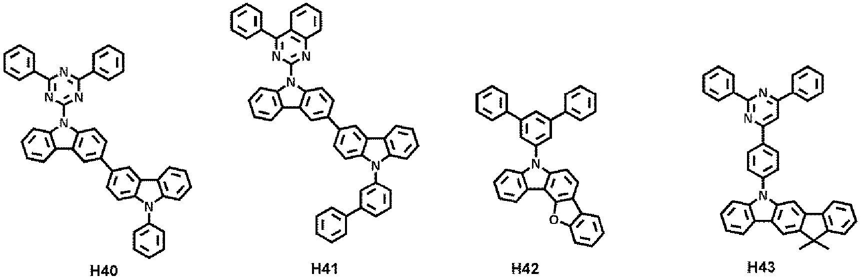

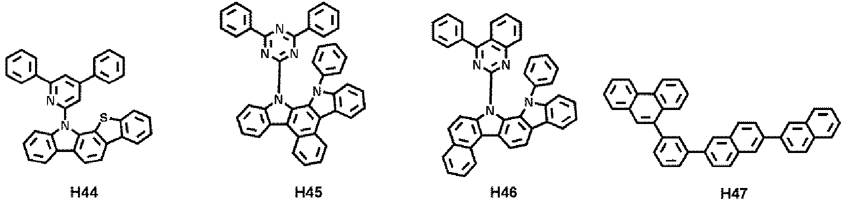

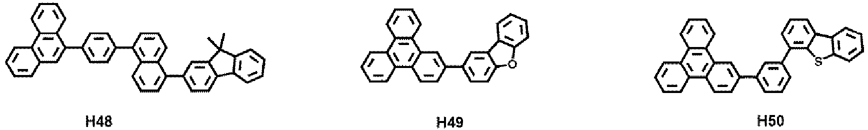

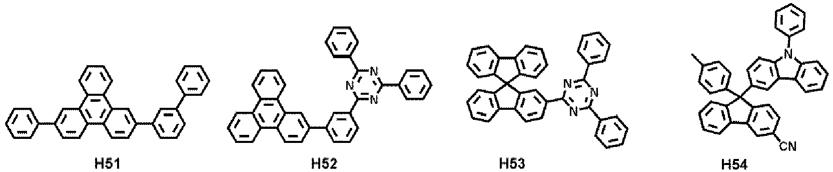

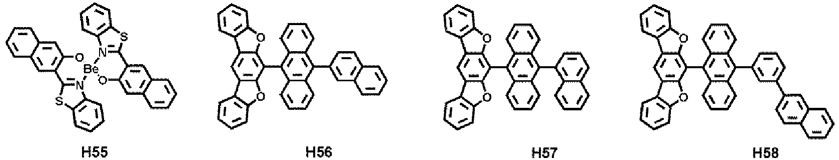

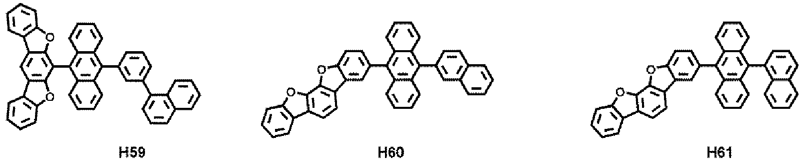

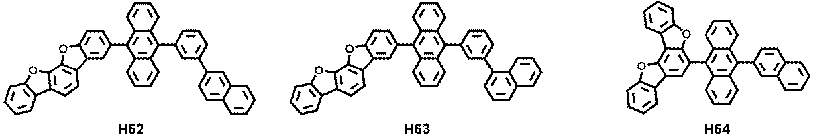

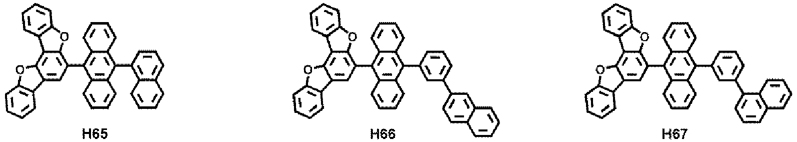

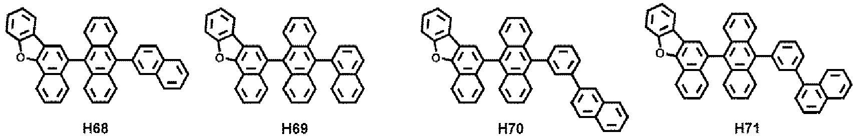

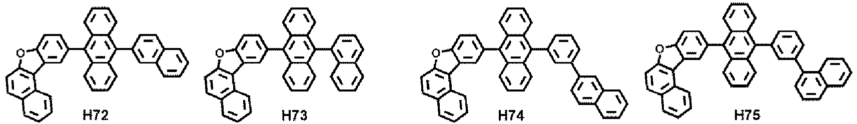

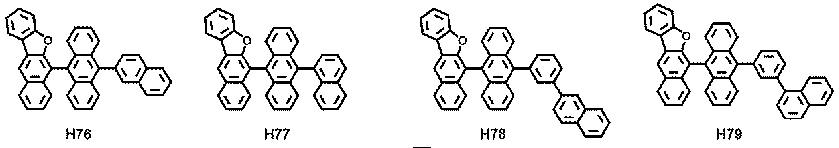

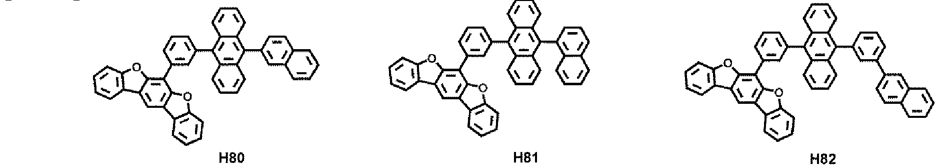

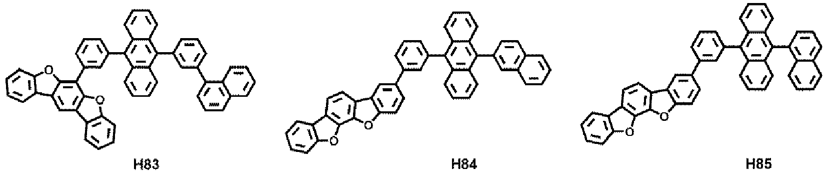

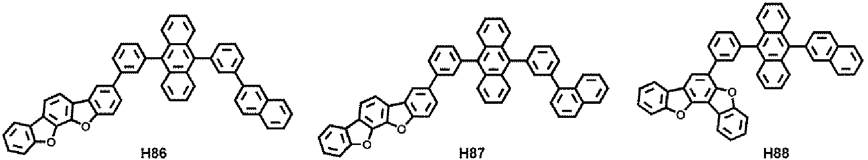

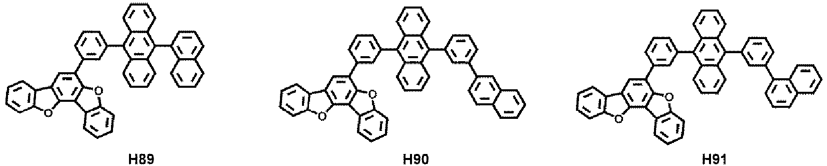

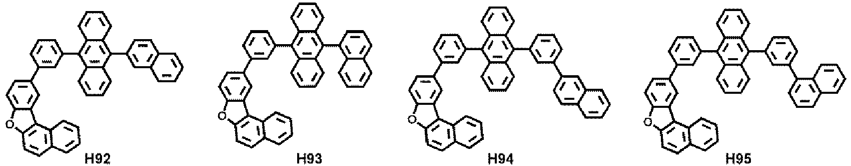

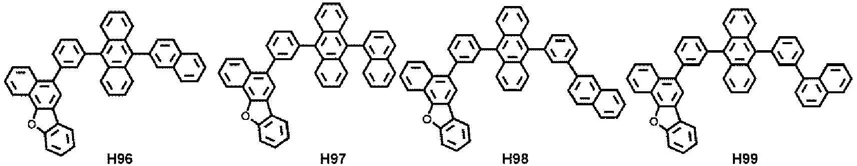

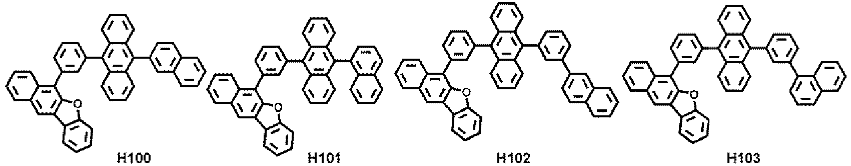

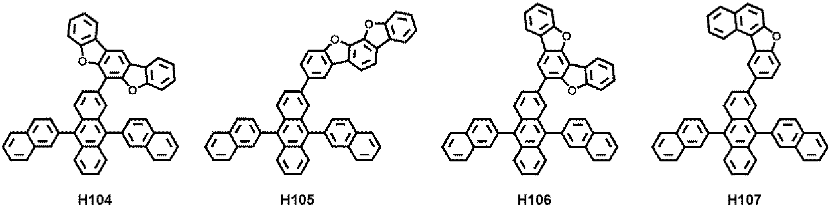

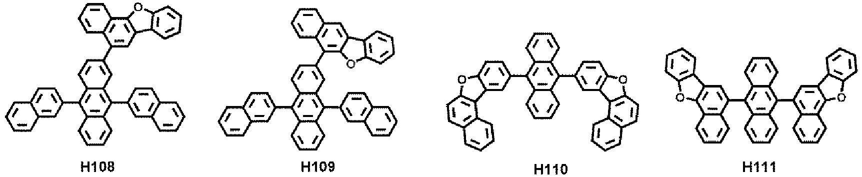

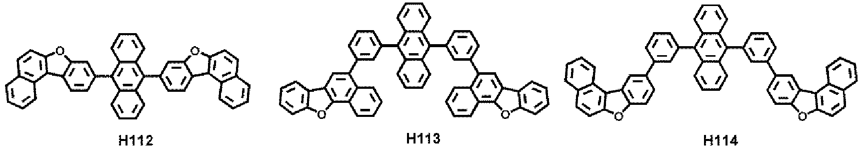

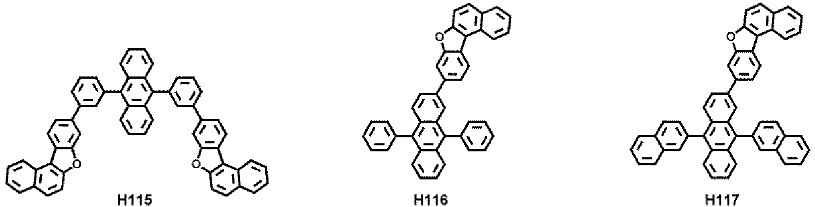

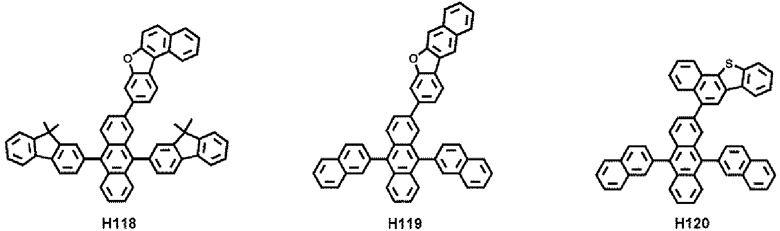

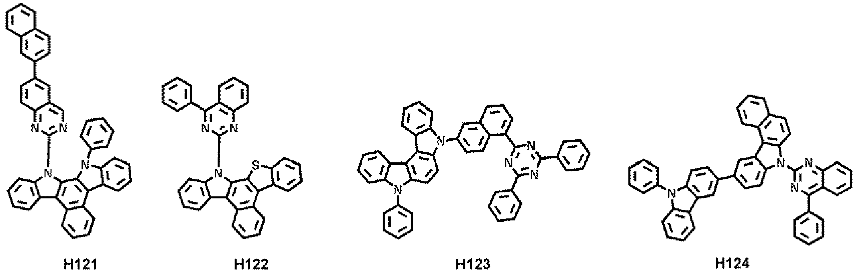

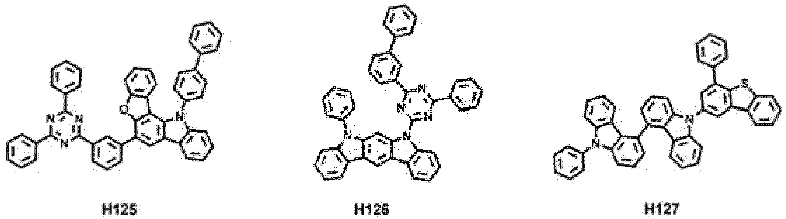

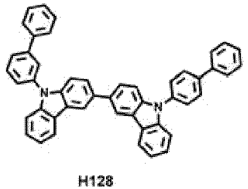

In one or more embodiments, the host may include a silicon-containing compound, a phosphine oxide-containing compound, and/or any combination thereof.

The host may have various modifications. For example, the host may include only one kind of compound, or may include two or more kinds of different compounds.

### [Phosphorescent dopant]

The emission layer may include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, and/or any combination thereof.

The phosphorescent dopant may be electrically neutral.

In an embodiment, the phosphorescent dopant may include an organometallic compound represented by Formula 401 :

Formula 401 M(L401)xc1(L402)xc2

Formula 402 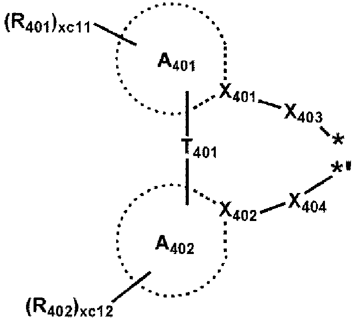 wherein, in Formulae 401 and 402,
M may be a transition metal (e.g., Ir, Pt, Pd, Os, Ti, Au, Hf, Eu, Tb, Rh, Re, or Tm),
L₄₀₁ may be a ligand represented by Formula 402, and xc1 may be 1, 2, or 3, wherein, when xc1 may be 2 or more, two or more of L₄₀₁ may be identical to or different from each other,
L₄₀₂ may be an organic ligand, and xc2 may be 0, 1, 2, 3, or 4, wherein, when xc2 may be 2 or more, two or more of L₄₀₂ may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q411)-*', *-C(Q411)(Q412)-*', *-C(Q411)=C(Q412)-*', *-C(Q411)=*', or *=C(Q411)=*',
X₄₀₃ and X₄₀₄ may each independently be a chemical bond (for example, a covalent bond or a coordinate bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ are each as described in connection with Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O)(Q₄₀₁)(Q₄₀₂),
Q₄₀₁ to Q₄₀₃ are each as described in connection with Q₁,
xc11 and xc12 may each independently be an integer from 0 to 10, and
* and *' in Formula 402 each indicate a binding site to M in Formula 401.

In an embodiment, in Formula 402, i) X₄₀₁ may be nitrogen, and X₄₀₂ may be carbon, or ii) each of X₄₀₁ and X₄₀₂ may be nitrogen.

In an embodiment, when xc1 in Formula 401 may be 2 or more, two ring A₄₀₁ among two or more of L₄₀₁ may be optionally linked together via T₄₀₂, which may be a linking group, and two ring A₄₀₂ may be optionally linked together via T₄₀₃, which may be a linking group (see Compounds PD1 to PD4 and PD7). T₄₀₂ and T₄₀₃ are each as described in connection with T₄₀₁.

L₄₀₂ in Formula 401 may be an organic ligand. In an embodiment, L₄₀₂ may include a halogen group, a diketone group (for example, an acetylacetonate group), a carboxylic acid group (for example, a picolinate group), -C(=O), an isonitrile group, a -CN group, a phosphorus group (for example, a phosphine group, a phosphite group, etc.), and/or any combination thereof.

The phosphorescent dopant may include, for example, one of Compounds PD1 to PD40 or any combination thereof:

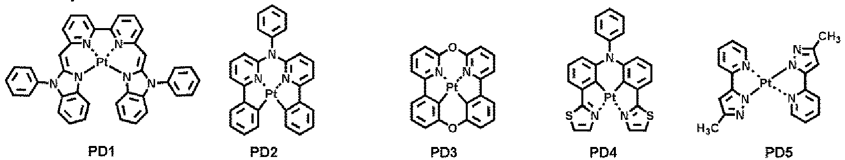

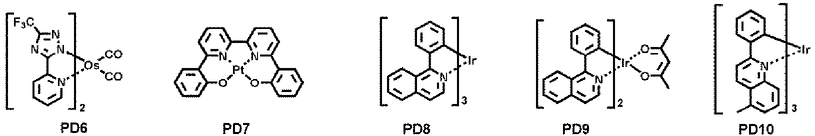

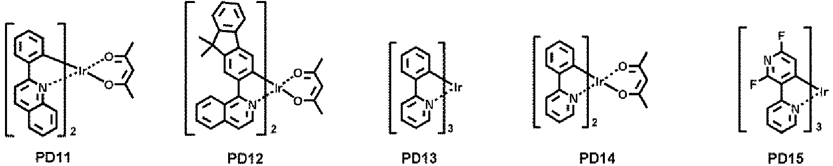

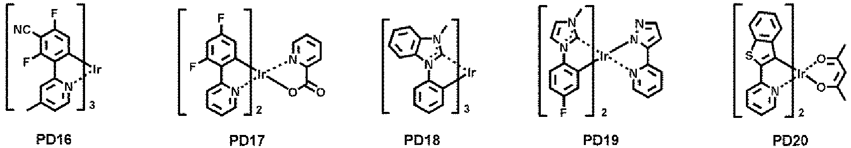

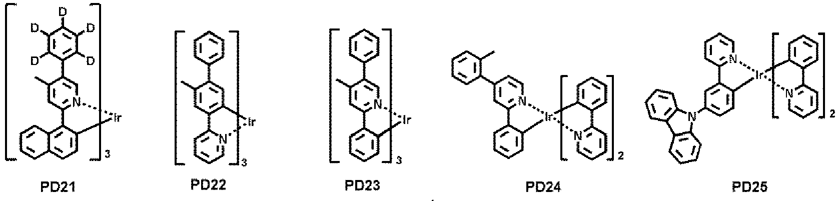

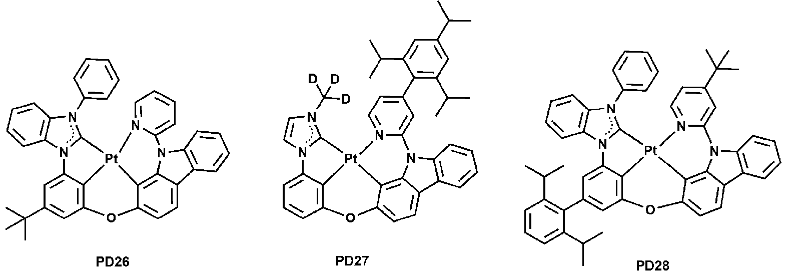

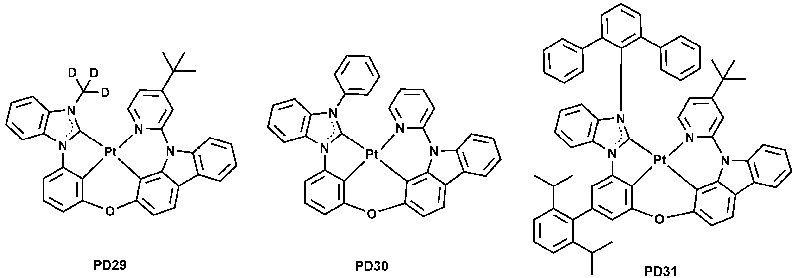

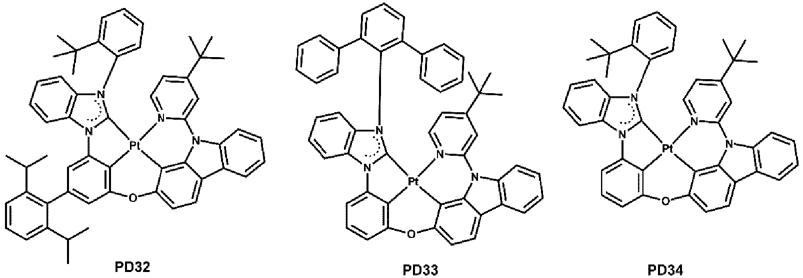

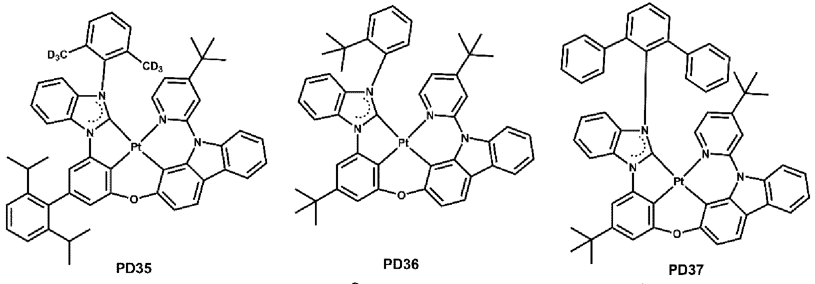

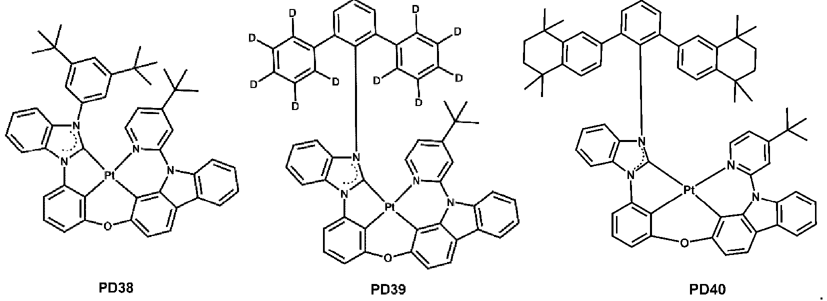

### [Fluorescent dopant]

The emission layer may include a fluorescent dopant and/or an auxiliary dopant.

For example, the fluorescent dopant and/or the auxiliary dopant may each independently include a compound represented by Formula 501: 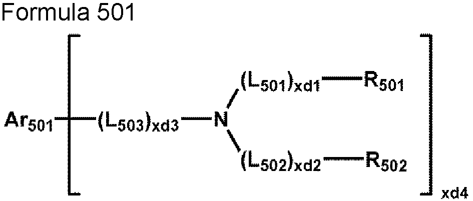 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, Ar501 in Formula 501 may be a condensed cyclic group (for example, an anthracene group, a chrysene group, a pyrene group, etc.) in which three or more monocyclic groups are condensed together.

In an embodiment, xd4 in Formula 501 may be 2.

In an embodiment, the fluorescent dopant and the auxiliary dopant may each include: one of Compounds FD1 to FD37; DPVBi; DPAVB; or any combination thereof:

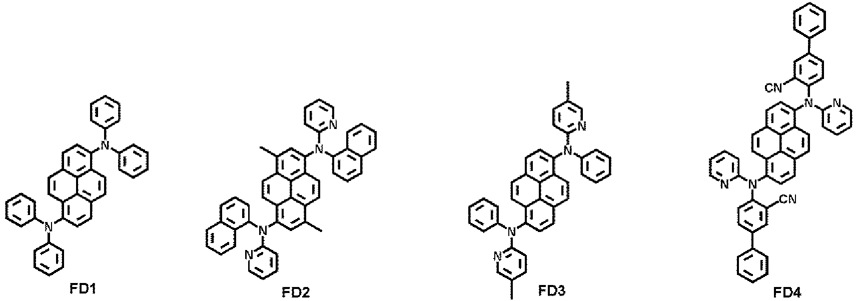

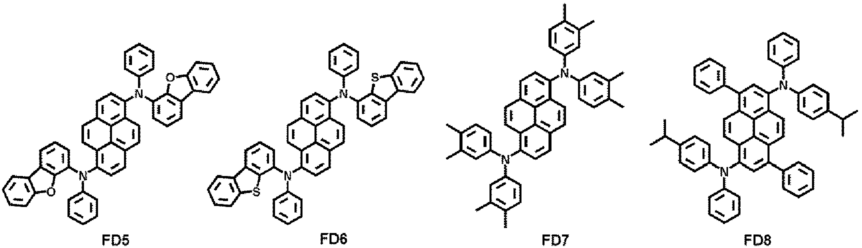

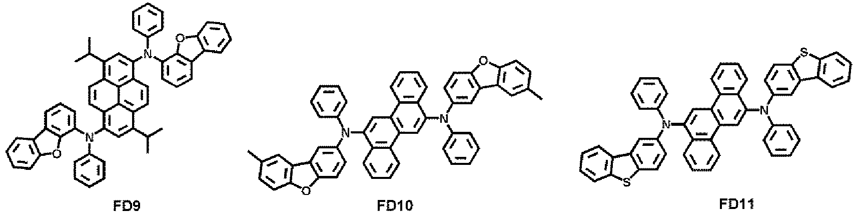

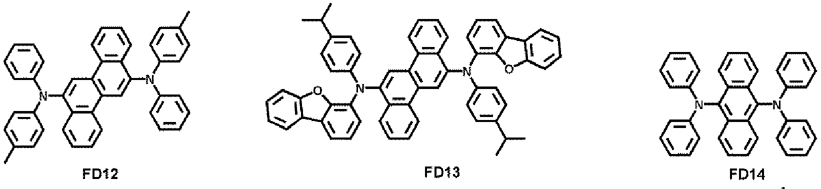

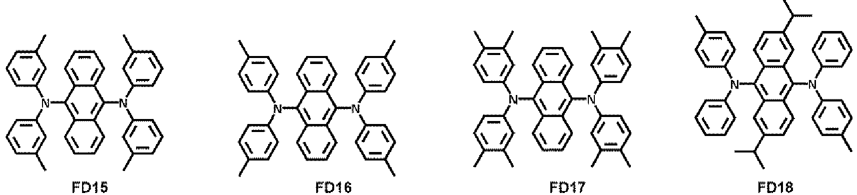

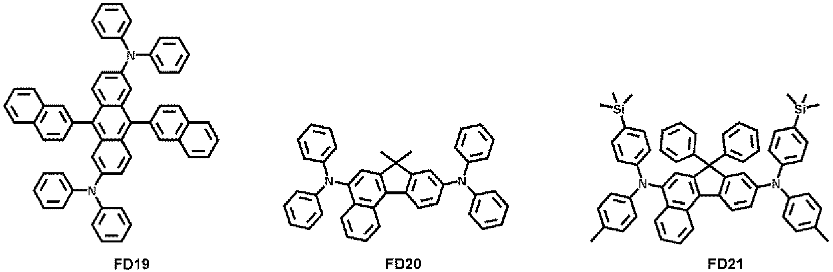

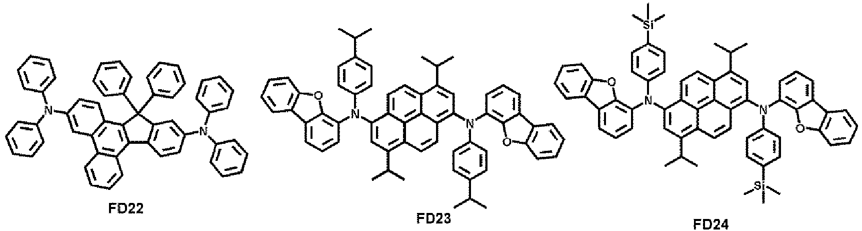

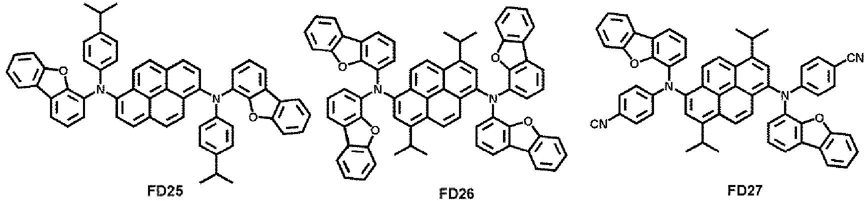

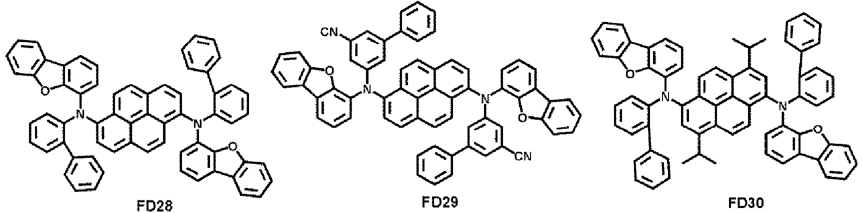

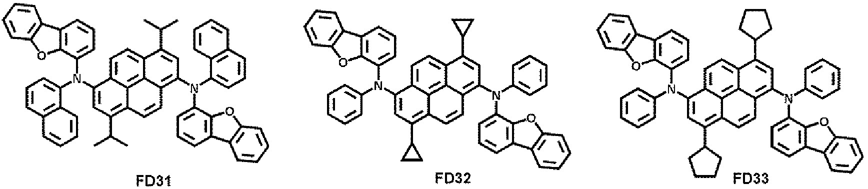

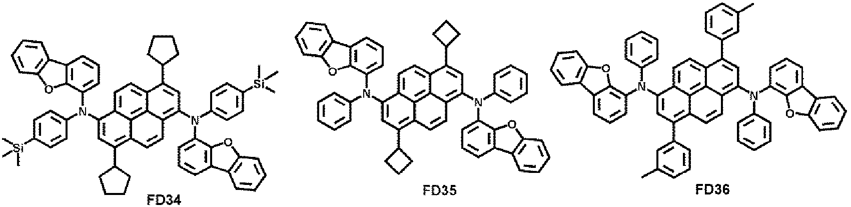

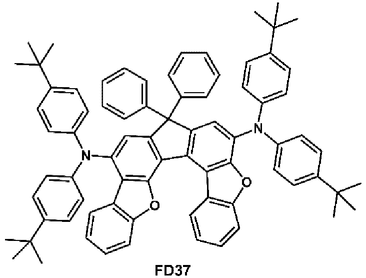

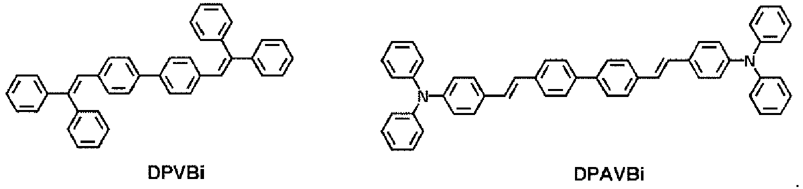

### [Delayed fluorescence material]

The emission layer may include a delayed fluorescence material.

Herein, the delayed fluorescence material may be selected from compounds capable of emitting delayed fluorescence based on a delayed fluorescence emission mechanism.

The delayed fluorescence material included in the emission layer may act as a host or a dopant depending on the type of other materials included in the emission layer.

In an embodiment, a difference between a triplet energy level (eV) of the delayed fluorescence material and the singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the luminescence efficiency of the light-emitting element 10 may be improved.

In an embodiment, the delayed fluorescence material may include: i) a material including at least one electron donor (for example, a π electron-rich C₃-C₆₀ cyclic group such as a carbazole group) and at least one electron acceptor (for example, a sulfoxide group, a cyano group, a π electron-deficient nitrogen-containing C₁-C₆₀ cyclic group, and the like), ii) a material including a C₈-C₆₀ polycyclic group including at least two cyclic groups that are condensed with each other while sharing boron (B).

Examples of the delayed fluorescence material may include at least one of Compounds DF1 to DF14:

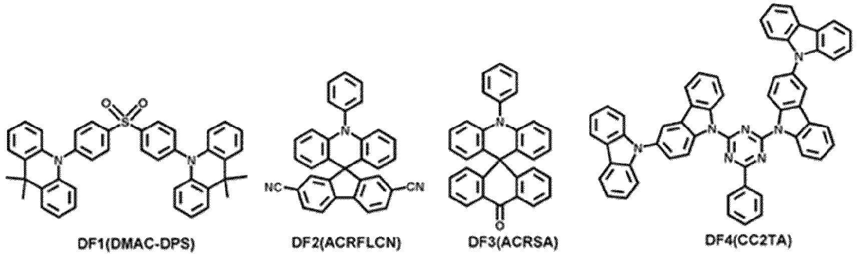

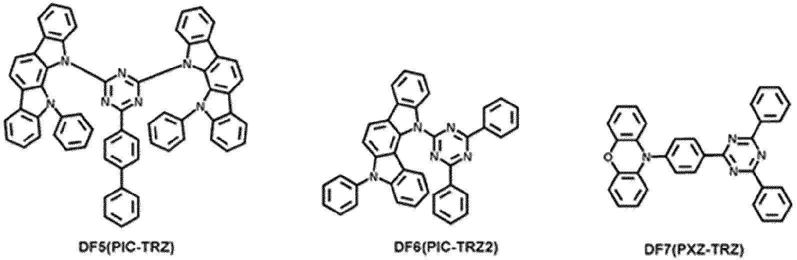

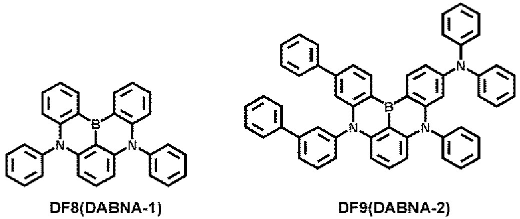

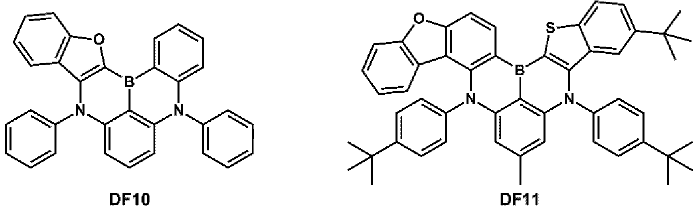

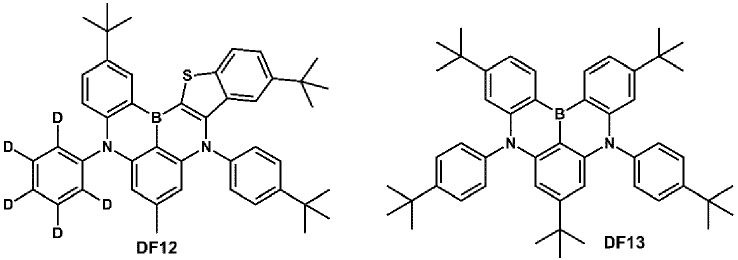

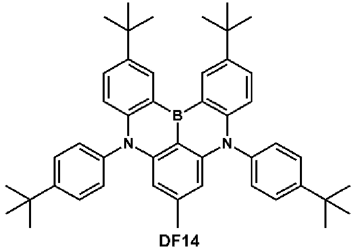

### [Quantum dot]

The emission layer may include a quantum dot.

The term "quantum dot" as used herein refers to a crystal of a semiconductor compound, and may include any material capable of emitting light of various emission wavelengths according to the size of the crystal. Quantum dots may emit light of various emission wavelengths by adjusting the element ratio in the quantum dot compound.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process may be a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled through a process which costs lower, and may be easier than vapor deposition methods, such as metal organic chemical vapor deposition (MOCVD) or molecular beam epitaxy (MBE).

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, and/or a combination thereof.

Examples of the Group II-VI semiconductor compound are a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or a combination thereof.

Examples of the Group III-V semiconductor compound are: a binary compound, such as GaN, GaP, GaAs, GaSb, AIN, AlP, AlAs, AlSb, InN, InP, InAs, InSb, or the like; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, GaAlNP, or the like; a quaternary compound, such as GaAINAs, GaAINSb, GaAlPAs, GaAlPSb, GalnNP, GalnNAs, GaInNSb, GalnPAs, GalnPSb, InAlNP, InAlNAs, InAlNSb, InAlPAs, InAlPSb, or the like; or any combination thereof. Meanwhile, the Group III-V semiconductor compound may further include a Group II element. Examples of the Group III-V semiconductor compound further including a Group II element are InZnP, InGaZnP, InAlZnP, etc.

Examples of the Group III-VI semiconductor compound are: a binary compound, such as GaS, GaSe, Ga₂Se₃, GaTe, InS, InSe, In₂S₃, In₂Se₃, or InTe; a ternary compound, such as InGaS₃, or InGaSe₃; and a combination thereof.

Examples of the Group I-Ill-VI semiconductor compounds are ternary compounds such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂; quaternary compounds such as AgInGaS₂, AgInGaSe₂, CuInGaS₂; or any combination thereof.

Examples of the Group IV-VI semiconductor compound are: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or a combination thereof.

The Group IV element or compound may include: a single element compound, such as Si or Ge; a binary compound, such as SiC or SiGe; or a combination thereof.

Each element included in a multi-element compound such as the binary compound, the ternary compound, and the quaternary compound may be present at a uniform concentration or non-uniform concentration in a particle. The above formulae refer to the types of elements included in each compound, and the element ratios in these compounds may be different from each other. For example, AgInGaS2 may indicate AgInxGa1-xS2 (where x may be a real number satisfying 0<x<1).

Meanwhile, the quantum dot may have a single structure in which the concentration of each element in the quantum dot may be uniform, or a core-shell dual structure. For example, the material included in the core and the material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Examples of the shell of the quantum dot may be an oxide of metal, metalloid, or non-metal, a semiconductor compound, and a combination thereof. Examples of the oxide of metal, metalloid, or non-metal are a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; and a combination thereof. Examples of the semiconductor compound are, as described herein, a Group II-VI semiconductor compound; a Group III-V semiconductor compound; a Group III-VI semiconductor compound; a Group I-III-VI semiconductor compound; a Group IV-VI semiconductor compound; and a combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or a combination thereof.

Each element included in a multi-element compound, such as the binary compound and the ternary compound, may be present at a uniform concentration or non-uniform concentration in a particle. The above formulae refer to the types of elements included in each compound, and the element ratios in these compounds may be different from each other.

A full width at half maximum (FWHM) of the emission wavelength spectrum of the quantum dot may be about 45 nm or less, for example, about 40 nm or less, for example, about 30 nm or less, and within these ranges, color purity or color reproducibility may be increased. In addition, since the light emitted through the quantum dot may be emitted in all directions, the wide viewing angle may be improved.

In addition, the quantum dot may be in the form of a spherical particle, a pyramidal particle, a multi-arm particle, a cubic nanoparticle, a nanotube particle, a nanowire particle, a nanofiber particle, or a nanoplate particle.

Since an energy band gap may be adjusted by controlling the size of the quantum dot, light having various wavelength bands may be obtained from the quantum dot emission layer. Accordingly, by using quantum dots of different sizes, a light-emitting element that emits light of various wavelengths may be implemented. In one or more embodiments, the size of the quantum dots or the ratio of elements in the quantum dot compound may be selected so that red light, green light, and/or blue light can be emitted. In one or more embodiments, the quantum dots may be configured to emit white light by combination of light of various colors.

### [Second functional layer 122c in interlayer]

The second functional layer 122c may be an electron transport area, and the electron transport area may have i) a single-layer structure including a single layer including a single material, ii) a single-layer structure including a single layer including multiple materials that are different from each other, or iii) a multi-layer structure including multiple layers including multiple different materials that are different from each other.

The electron transport area may include a buffer layer, a hole-blocking layer, an electron control layer, an electron transport layer, an electron injection layer, and/or any combination thereof.

For example, the electron transport area may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein layers in each structure are sequentially stacked from the emission layer.

The electron transport area (e.g., a buffer layer, a hole blocking layer, an electron control layer, or an electron transport layer in the electron transport area) may include a metal-free compound including at least one π electron-deficient nitrogen-containing C1-C60 heterocyclic group.

In an embodiment, the electron transport area may include a compound represented by Formula 601.

Formula 601 [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that may be unsubstituted or substituted with at least one R₁₀ₐ, a C₁-C₆₀ heterocyclic group that may be unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ are each as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group that may be unsubstituted or substituted with at least one R₁₀ₐ.

In an embodiment, when xe11 in Formula 601 may be 2 or more, two or more of Ar₆₀₁ may be linked together via a single bond.

In an embodiment, Ar₆₀₁ in Formula 601 may be a substituted or unsubstituted anthracene group.

In an embodiment, the electron transport area may include a compound represented by Formula 601-1:

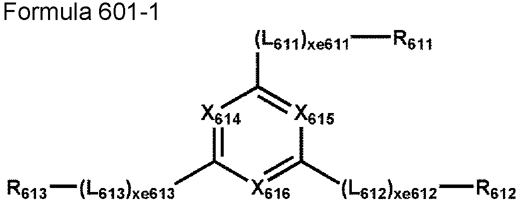

wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ are each as described in connection with L₆₀₁,
xe611 to xe613 are each as described in connection with xe1,
R₆₁₁ to R₆₁₃ are each as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that may be unsubstituted or substituted with at least one R₁₀ₐ, or a C₁-C₆₀ heterocyclic group that may be unsubstituted or substituted with at least one R₁₀ₐ.

In an embodiment, xe1 and xe611 to xe613 in Formulae 601 and 601-1 may each independently be 0, 1, or 2.

The electron transport area may include: one of Compounds ET1 to ET46; 2,9-dimethyl-4,7-diphenyl-1,10-phenanthroline (BCP); 4,7-diphenyl-1,10-phenanthroline (Bphen); Alq3; BAlq; TAZ; NTAZ; or any combination thereof:

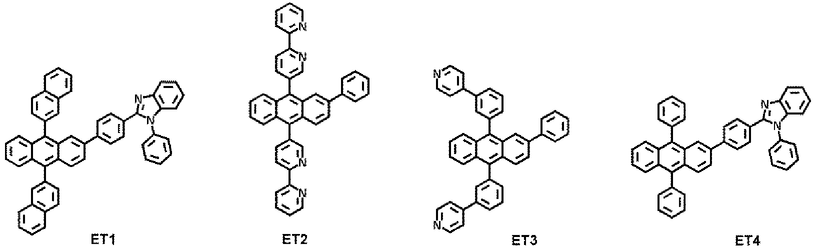

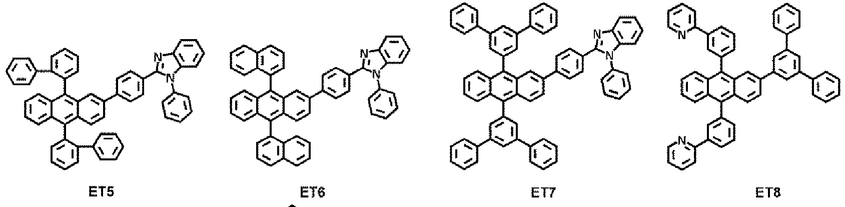

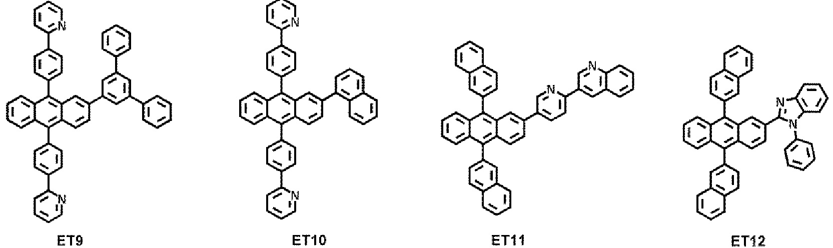

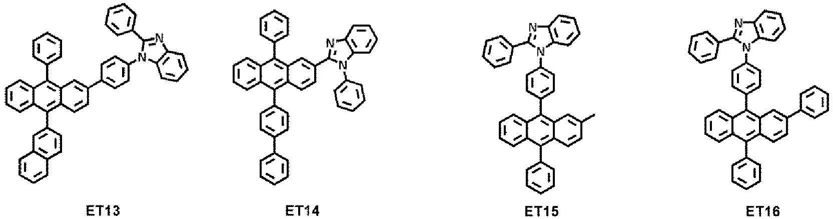

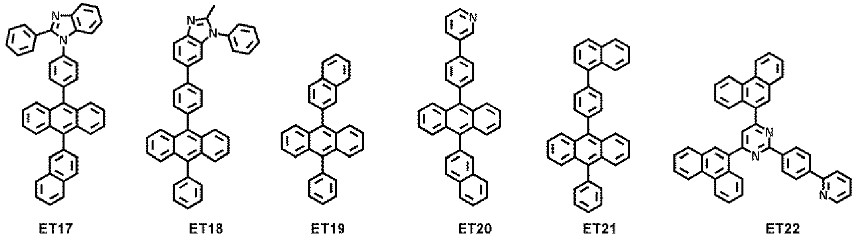

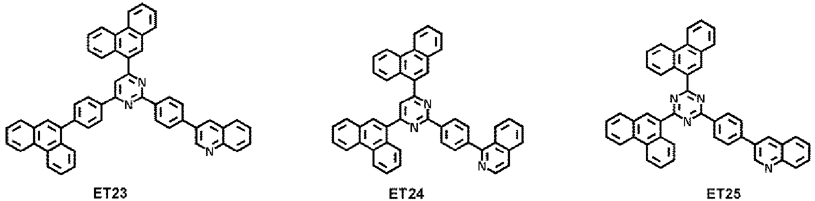

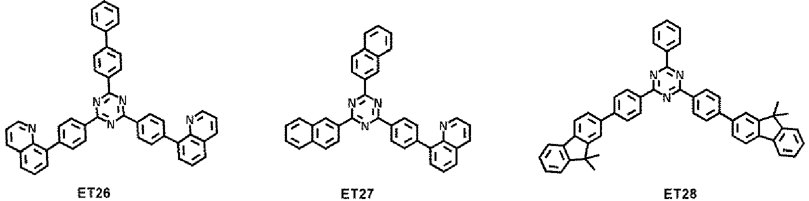

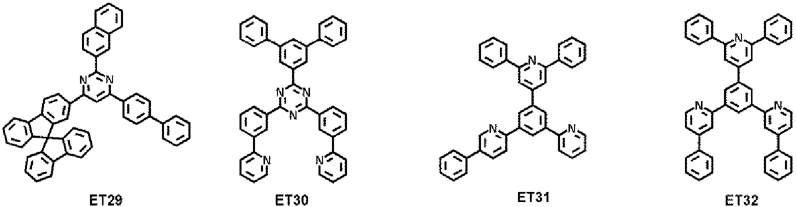

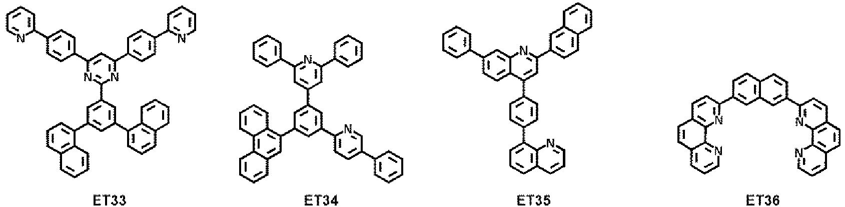

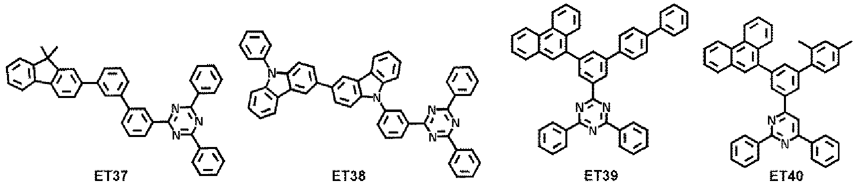

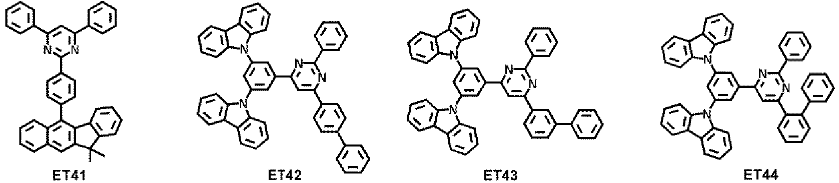

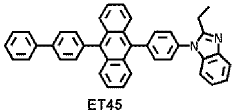

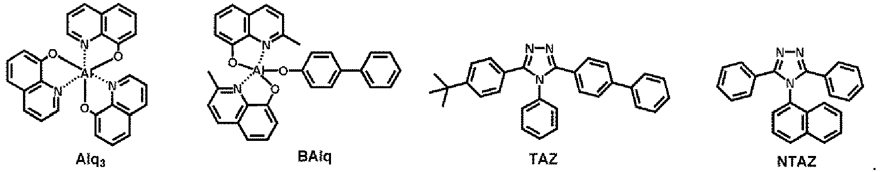

The thickness of the electron transport area may be about 100 Å to about 5,000 Å, for example, about 160 Å to about 4,000 Å. When the electron transport area includes a buffer layer, a hole-blocking layer, an electron control layer, an electron transport layer, and/or any combination thereof, a thickness of the buffer layer, the hole-blocking layer, or the electron control layer may each independently be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport area are within the ranges described above, satisfactory electron transporting characteristics may be obtained without a substantial increase in driving voltage.

The electron transport area (for example, the electron transport layer in the electron transport area) may further include, in addition to the materials described above, a metal-containing material.

The metal-containing material may include an alkali metal complex, an alkaline earth metal complex, and/or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, and/or any combination thereof.

In an embodiment, the metal-containing material may include a Li complex. The Li complex may include, for example, Compound ET-D1 (LiQ) or ET-D2:

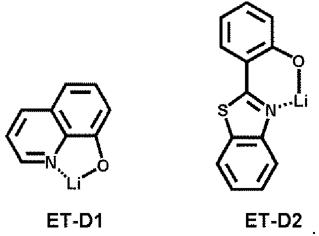

The electron transport area may include an electron injection layer that facilitates the injection of electrons from the second electrode. The electron injection layer may be in direct contact with the second electrode.

The electron injection layer may have: i) a single-layered structure including a single layer including a single material, ii) a single-layered structure including a single layer including multiple different materials, or iii) a multilayer structure including multiple layers including multiple different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, and/or any combination thereof.

The alkali metal may include Li, Na, K, Rb, Cs, and/or any combination thereof. The alkaline earth metal may include Mg, Ca, Sr, Ba, and/or any combination thereof. The rare earth metal may include Sc, Y, Ce, Tb, Yb, Gd, and/or any combination thereof.

The alkali metal-containing compound, the alkaline earth metal-containing compound, and the rare earth metal-containing compound may include oxides, halides (for example, fluorides, chlorides, bromides, iodides, etc.), or tellurides of the alkali metal, the alkaline earth metal, and the rare earth metal, and/or any combination thereof.

The alkali metal-containing compound may include: an alkali metal oxide, such as Li₂O, Cs₂O, K₂O, etc.; alkali metal halides, such as LiF, NaF, CsF, KF, Lil, Nal, Csl, Kl, etc.; or any combination thereof. The alkaline earth metal-containing compound may include an alkaline earth metal compound, such as BaO, SrO, CaO, BaxSr1-xO (x may be a real number satisfying 0<x<1), or BaxCa1-xO (x may be a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, and/or any combination thereof. In an embodiment, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and LU₂Te₃.

The alkali metal complex, the alkaline earth-metal complex, and the rare earth metal complex may include i) one of metal ions of the alkali metal, the alkaline earth metal, and the rare earth metal, and ii) as a ligand bonded to the metal ions, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, and/or any combination thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, and/or any combination thereof, as described above. In an embodiment, the electron injection layer may further include an organic material (for example, a compound represented by Formula 601).

In an embodiment, the electron injection layer may consist of i) an alkali metal-containing compound (for example, alkali metal halide), ii) a) an alkali metal-containing compound (for example, alkali metal halide); and b) an alkali metal, an alkaline earth metal, a rare earth metal, and/or any combination thereof. In an embodiment, the electron injection layer may be a Kl:Yb co-deposited layer, an Rbl:Yb co-deposited layer, a LiF:Yb co-deposited layer, or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly or non-uniformly dispersed in a matrix including the organic material.

The thickness of the electron injection layer may be about 1 Å to about 100 Å, and, for example, about 3 Å to about 90 Å. When the thickness of the electron injection layer may be within the range as described above, satisfactory electron injection characteristics may be obtained without a substantial increase in driving voltage.

### [Second electrode]

A second electrode may be positioned on the interlayer as described above. The second electrode may be a cathode, which may be an electron injection electrode, and as the material for the second electrode, a metal, an alloy, an electrically conductive compound, and/or a combination thereof, each having a low-work function, may be used.

The second electrode may include Li, Ag, Mg, Al, Al-Li, Ca, Mg-In, Mg-Ag, Yb, Ag-Yb, ITO, IZO, and/or any combination thereof. The second electrode may be a transmissive electrode, a semi-transmissive electrode, or a reflective electrode.

The second electrode may have a single-layered structure having a single layer or a multi-layered structure including two or more layers.

### [Capping layer]

A first capping layer may be positioned on the outer side of the pixel electrode, and/or a second capping layer may be positioned on the outer side of the counter electrode. In some embodiments, the light-emitting element may have a structure in which a first capping layer, a pixel electrode, an interlayer, and a counter electrode are sequentially laminated, a structure in which a pixel electrode, an interlayer, a counter electrode, and a second capping layer are sequentially laminated, or a structure in which a first capping layer, a pixel electrode, an interlayer, a counter electrode, and a second capping layer are sequentially laminated.

Light generated in the emission layer in the interlayer of the light-emitting element may be extracted to the outside through the pixel electrode, which may be a semi-transmissive electrode or a transmissive electrode, and the first capping layer, and light generated in the emission layer in the interlayer of the light-emitting element may be extracted to the outside through the counter electrode, which may be a semi-transmissive electrode or a transmissive electrode, and the second capping layer.

The first capping layer and the second capping layer may increase external luminescence efficiency according to the principle of constructive interference. Accordingly, the light extraction efficiency of the light-emitting element may be increased, so that the luminescence efficiency of the light-emitting element may be improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, and/or any combination thereof. The carbocyclic compound, the heterocyclic compound, and the amine group-containing compound may optionally be substituted with a substituent including O, N, S, Se, Si, F, Cl, Br, I, and/or any combination thereof. In an embodiment, at least one of the first capping layer and the second capping layer may each independently include an amine group-containing compound.

In an embodiment, at least one of the first capping layer and the second capping layer may each independently include a compound represented by Formula 201, a compound represented by Formula 202, and/or any combination thereof.

In an embodiment, at least one of the first capping layer and the second capping layer may each independently include one of Compounds HT28 to HT33, one of Compounds CP1 to CP6, β-NPB, and/or any combination thereof:

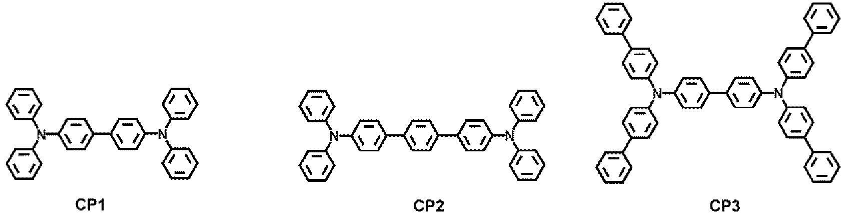

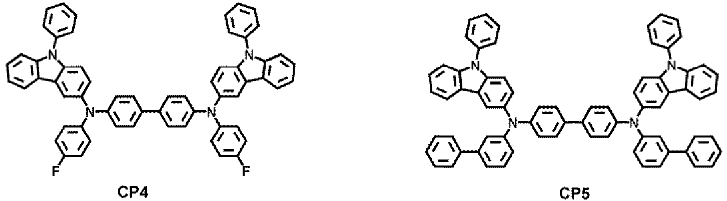

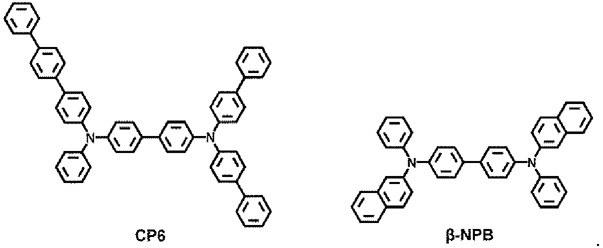

The upper layer 150 may be a layer provided to protect the counter electrode 123 and increase light extraction efficiency. The upper layer 150 may include LiF. Alternatively, the upper layer 150 may additionally include an inorganic insulating material such as silicon oxide SiOₓ or silicon nitride SiNₓ.

Display elements may be covered by the thin film encapsulation layer TFEL. In an embodiment, the thin film encapsulation layer TFEL may include at least one inorganic encapsulation layer and at least one organic encapsulation layer. For example, the thin film encapsulation layer TFEL may include a first inorganic encapsulation layer 161 and a second inorganic encapsulation layer 163 and an organic encapsulation layer 162 therebetween.

A touch screen layer TSL may be positioned on the second inorganic encapsulation layer 163. A touch screen layer TSL may obtain coordinate information based on external input, such as a touch event. The touch screen layer TSL may detect an external input using a self-capacitive method or a mutual capacitive method. The touch screen layer TSL may include touch electrodes TPEs and wiring connected to the touch electrodes TPEs. The touch electrodes TPE may include first touch electrodes 171 and second touch electrodes 172. The first touch electrodes 171 may be connected by connection electrodes positioned in the same layer. The second touch electrodes 172 may be connected to the connection electrodes 172b positioned on another layer via contact holes CNT of the insulating layer 174. Touch electrodes TPE may be positioned to correspond to the pixel definition film 119.

An optical functional layer OFL may include a filter layer 180 including a color filter 182, a black matrix 183, and an overcoat layer 184. The black matrix 183 may cover the first touch electrodes 171 and the second touch electrodes 172. The black matrix 183 may be positioned to correspond to the pixel definition film 119. The overcoat layer 184 may include an organic material such as a resin, and the organic material may be transparent.

In the case of the display panel 10 that uses, as the optical functional layer OFL, the color filter 182 and the black matrix 183 instead of a polarizing plate or a polarizing film, the luminescence efficiency of display elements are improved, and thus, an improvement in power consumption and an increase in brightness may be obtained, resulting in an improvement in the lifespan of the display panel. In addition, the same brightness/lifespan may be obtained even with a smaller area than the existing light-emitting area. Furthermore, because the polarizing plate or polarizing film itself is not used, the thickness of the display panel may be reduced.

The color filter 182 may include a first color filter 182a that selectively transmits only light of a first color, a second color filter 182b that selectively transmits only light of a second color, and a third color filter 182c that selectively transmits only light of a third color. The first color filter 182a, the second color filter 182b, and the third color filter 182c may be positioned to correspond to the light-emitting area EA of the subpixel PX. The first color filter 182a, the second color filter 182b, and the third color filter 182c may be positioned adjacent to each other. The first color filter 182a, the second color filter 182b, and the third color filter 182c may each have an independent pattern structure. The first color filter 182a, the second color filter 182b, and the third color filter 182c may each be positioned within an opening 183OP of the black matrix 183. A portion of each of the first color filter 182a, the second color filter 182b, and the third color filter 182c may overlap with the pixel definition film 119.

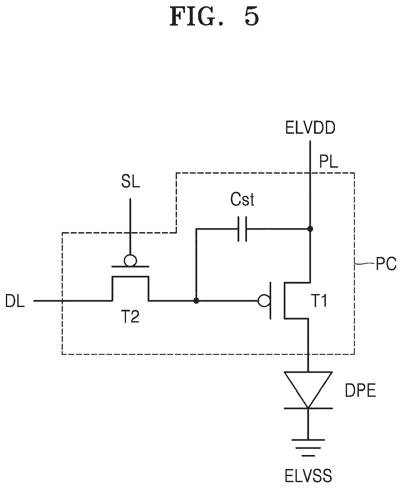

FIG. 5 is an equivalent circuit diagram of one pixel of a display apparatus according to an embodiment.

Referring to FIG. 5, the pixel circuit PC may include a driving transistor T1, a scan transistor T2, and a storage capacitor Cst. In an embodiment, the driving transistor T1 and the scan transistor T2 may each be a thin film transistor.

The scan transistor T2 may be electrically connected to each of the scan line SL and the data line DL, and may transmit a data voltage input via the data line DL to the driving transistor T1 based on a scan signal input via the scan line SL. The storage capacitor Cst may be electrically connected to the scan transistor T2 and a driving voltage line PL, and may store a voltage corresponding to the difference between the voltage received from the scan transistor T2 and a driving voltage ELVDD supplied to the driving voltage line PL.

The driving transistor T1 may be electrically connected to each of the driving voltage line PL and the storage capacitor Cst, and may control the driving current flowing from the driving voltage line PL to a display element DPE in response to a voltage value stored in the storage capacitor Cst. The display element DPE may emit light with a certain intensity of brightness by a driving current. The counter electrode of the display element DPE may be supplied with a common voltage ELVSS. The display element DFE may be an organic light-emitting diode OLED of FIG. 4.

Although FIG. 5 illustrates that the pixel circuit PC includes two transistors and one storage capacitor, the pixel circuit PC may include three or more transistors.

FIG. 6 is a plan view schematically illustrating a portion of a display apparatus according to an embodiment, and is a plan view illustrating the arrangement of subpixels. Referring to FIG. 6, the display panel 10 may have a unit area UA having a quadrangular shape. The unit areas UA may be repeatedly arranged in or along a first direction D1 and in or along a second direction D2 on the display panel 10. The second direction D2 may be transverse or perpendicular to the first direction D1. The first direction D1 may be the + x direction or the - x direction, and the second direction D2 may be the + y direction or the - y direction. The unit areas UA may be included in the substrate.

Multiple subpixels may be positioned on each of the unit areas UA. Each subpixel may emit light of different color, and may be, for example, one of a red subpixel, a green subpixel, and a blue subpixel. A first subpixel P1, a second subpixel P2, and a third subpixel P3 which emit light of different color, may be positioned on the unit area UA. That is, a first subpixel P1 emitting light of a first color, a second subpixel P2 emitting light of a second color, and a third subpixel P3 emitting light of a third color may be positioned on the unit area UA.

In an embodiment, the emission wavelength of the first color may be shorter than the emission wavelength of the second color and/or the emission wavelength of the third color. The emission wavelength of the first color may be about 400 nm to about 500 nm. In an embodiment, the first subpixel P1 may be a blue subpixel, the second subpixel P2 may be a green subpixel, and the third subpixel P3 may be a red subpixel. In other words, the first color may be blue, the second color may be green, and the third color may be red.

In some embodiments, the first subpixel P1 may be a blue subpixel, the second subpixel P2 may be a red subpixel, and the third subpixel P3 may be a green subpixel. In other words, the first color may be blue, the second color may be red, and the third color may be green. In one unit area UA, the first subpixel P1, the second subpixel P2, and the third subpixel P3 may be spaced apart from each other.

On the unit area UA, the first subpixel P1 may be positioned adjacent to the second subpixel P2 in or along the first direction D1, and the second subpixel P2 may be positioned adjacent to the third subpixel P3 in or along the first direction D1 such that the first subpixel P1, the second subpixel P2 and the third subpixel P3 are positioned in a linear arrangement.

In an embodiment, the unit area UA may have a rectangular or square shape. As shown in FIG. 6, a width W of the unit area UA in or along the first direction D1 and a width W in the second direction D2 may be equal to each other. However, embodiments of the disclosure are not limited thereto. For example, the unit area UA may have a rectangular shape.

The light-emitting areas of the subpixels are an area where the light-emitting element ED, i.e., the emission layer of an organic light-emitting diode, may be arranged, and as described above with reference to FIG. 4, the size and shape of the light-emitting area EA of the organic light-emitting diode OLED may be defined by the opening OP of the pixel definition film 119. In this specification, the arrangement (layout) of pixels may refer to the arrangement (layout) of display elements, the arrangement (layout) of pixel electrodes, or the arrangement (layout) of light-emitting areas. In this specification, the size (area) of pixels may refer to the size (area) of light-emitting areas or the size (area) of the opening OP of the pixel definition film 119.

Accordingly, the shapes of the first light-emitting area EA1, the second light-emitting area EA2, and the third light-emitting area EA3 described later may be the same as or different from each other.

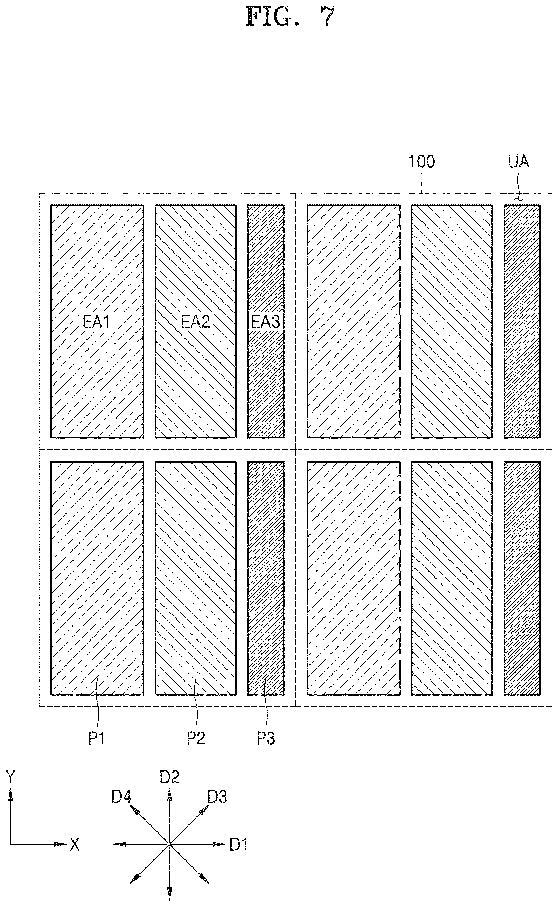

FIG. 7 is a plan view schematically illustrating a part of a display apparatus according to an embodiment, and is a plan view showing the light-emitting areas of subpixels.

Referring to FIG. 7, the substrate 100 has a unit area UA having a quadrangular shape, and on one unit area UA, the first subpixel P1, the second subpixel P2, and the third subpixel P3 may be spaced apart from each other such that the first subpixel P1, the second subpixel P2 and the third subpixel P3 are positioned in a linear arrangement.

In an embodiment, the first subpixel P1 may be a blue subpixel, the second subpixel P2 may be a green subpixel, and the third subpixel P3 may be a red subpixel.

The first subpixel P1 may include a first light-emitting area EA1, the second subpixel P2 may include a second light-emitting area EA2, and the third subpixel P3 may include a third light-emitting area EA3.

In an embodiment, the size of the first light-emitting area EA1 may be greater than each of the size of the second light-emitting area EA2 and the size of the third light-emitting area EA3.

In an embodiment, the size of the second light-emitting area EA2 may be larger than the size of the third light-emitting area EA3.

In an embodiment, the size of the first light-emitting area EA1 may be at least 1.3 times the size of the second light-emitting area EA2 or the size of the third light-emitting area EA3. The size of the first light-emitting area EA1 may be about 1.3 times to about 5.0 times, about 1.4 times to about 5.0 times, about 1.5 times to about 5.0 times, about 1.6 times to about 5.0 times, about 1.7 times to about 5.0 times, about 1.8 times to about 5.0 times, about 1.9 times to about 5.0 times, about 2.0 times to about 5.0 times, about 2.2 times to about 5.0 times, about 2.4 times to about 5.0 times, about 2.6 times to about 5.0 times, about 2.8 times to about 5.0 times, about 3.0 times to about 5.0 times, about 3.1 times to about 5.0 times, about 3.3 times to about 5.0 times, about 3.5 times to about 5.0 times, about 3.7 times to about 5.0 times, about 3.9 times to about 5.0 times, about 4.0 times to about 5.0 times, about 4.2 times to about 5.0 times, about 4.4 times to about 5.0 times, about 4.7 times to about 5.0 times, about 4.7 times to about 5.0 times, about 4.8 times to about 5.0 times, about 1.3 times to about 4.5 times, about 1.4 times to about 4.5 times, about 1.5 times to about 4.5 times, about 1.6 times to about 4.5 times, about 1.7 times to about 4.5 times, about 1.8 times to about 4.5 times, about 1.9 times to about 4.5 times, about 2.0 times to about 4.5 times, about 2.2 times to about 4.5 times, about 2.4 times to about 4.5 times, about 2.6 times to about 4.5 times, about 2.8 times to about 4.5 times, about 3.0 times to about 4.5 times, about 3.1 times to about 4.5 times, about 3.3 times to about 4.5 times, about 3.5 times to about 4.5 times, about 3.7 times to about 4.5 times, about 3.9 times to about 4.5 times, about 4.0 times to about 4.5 times, about 4.2 times to about 4.5 times, about 4.4 times to about 4.5 times, about 1.3 times to about 4.0 times, about 1.4 times to about 4.0 times, about 1.5 times to about 4.0 times, about 1.6 times to about 4.0 times, about 1.7 times to about 4.0 times, about 1.8 times to about 4.0 times, about 1.9 times to about 4.0 times, about 2.0 times to about 4.0 times, about 2.2 times to about 4.0 times, about 2.4 times to about 4.0 times, about 2.6 times to about 4.0 times, about 2.8 times to about 4.0 times, about 3.0 times to about 4.0 times, about 3.1 times to about 4.0 times, about 3.3 times to about 4.0 times, about 3.5 times to about 4.0 times, about 3.7 times to about 4.0 times, about 3.9 times to about 4.0 times, about 1.3 times to about 3.5 times, about 1.4 times to about 3.5 times, about 1.5 times to about 3.5 times, about 1.6 times to about 3.5 times, about 1.7 times to about 3.5 times, about 1.8 times to about 3.5 times, about 1.9 times to about 3.5 times, about 2.0 times to about 3.5 times, about 2.2 times to about 3.5 times, about 2.4 times to about 3.5 times, about 2.6 times to about 3.5 times, about 2.8 times to about 3.5 times, about 3.0 times to about 3.5 times, about 3.1 times to about 3.5 times, about 3.3 times to about 3.5 times, about 1.3 times to about 3.0 times, about 1.4 times to about 3.0 times, about 1.5 times to about 3.0 times, about 1.6 times to about 3.0 times, about 1.7 times to about 3.0 times, about 1.8 times to about 3.0 times, about 1.9 times to about 3.0 times, about 2.0 times to about 3.0 times, about 2.2 times to about 3.0 times, about 2.4 times to about 3.0 times, about 2.6 times to about 3.0 times, about 2.8 times to about 3.0 times, about 1.3 times to about 2.5 times, about 1.4 times to about 2.5 times, about 1.5 times to about 2.5 times, about 1.6 times to about 2.5 times, about 1.7 times to about 2.5 times, about 1.8 times to about 2.5 times, about 1.9 times to about 2.5 times, about 2.0 times to about 2.5 times, about 2.2 times to about 2.5 times, about 2.4 times to about 2.5 times, about 1.3 times to about 2.0 times, about 1.4 times to about 2.0 times, about 1.5 times to about 2.0 times, about 1.6 times to about 2.0 times, about 1.7 times to about 2.0 times, about 1.8 times to about 2.0 times, or about 1.9 times to about 2.0 times, each the size of the second light-emitting area EA2 or the size of the third light-emitting area EA3.

In some embodiments, the size of the first light-emitting area EA1 may be at least 1.6 times the size of the second light-emitting area EA2 or the size of the third light-emitting area EA3.

In some embodiments, the size of the first light-emitting area EA1 may be at least 1.6 times the size of the second light-emitting area EA2.

In some embodiments, the size of the first light-emitting area EA1 may be at least twice the size of the second light-emitting area EA2 or the size of the third light-emitting area EA3.

In some embodiments, the size of the first light-emitting area EA1 may be at least twice the size of the third light-emitting area EA3.

In an embodiment, the shape of each of the first light-emitting area EA1, the second light-emitting area EA2, and the third light-emitting area EA3 may be a quadrangular shape. In some embodiments, the shape of each of the first light-emitting area EA1, the second light-emitting area EA2, and the third light-emitting area EA3 may be rectangular. In some embodiments, the shapes of the first light-emitting area EA1, the second light-emitting area EA2, and the third light-emitting area EA3 may be the same as or different from each other.

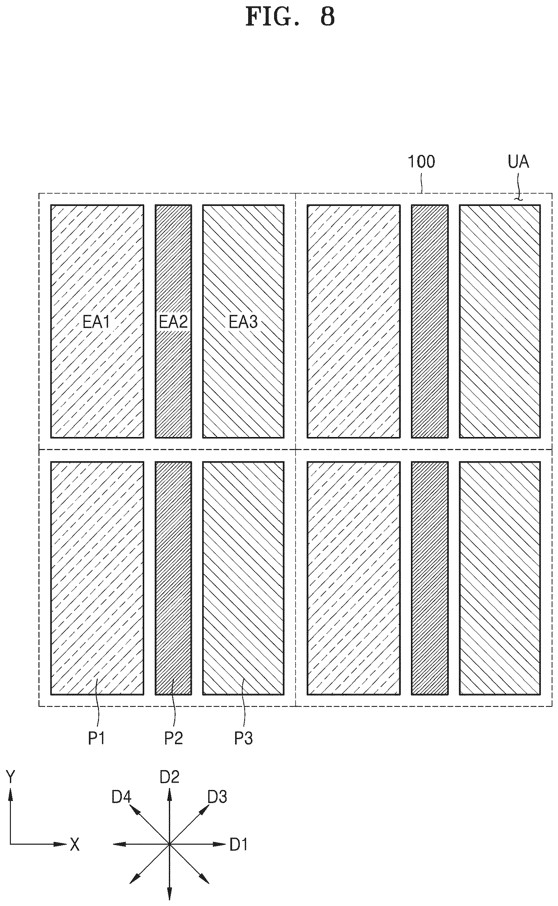

FIG. 8 is a plan view schematically illustrating a part of a display apparatus according to an embodiment, and is a plan view showing the light-emitting areas of subpixels.

Referring to FIG. 8, the substrate 100 has the unit area UA having a quadrangular shape, and on one unit area UA, the first subpixel P1, the second subpixel P2, and the third subpixel P3 may be spaced apart from each other such that the first subpixel P1, the second subpixel P2 and the third subpixel P3 are positioned in a linear arrangement.

In an embodiment, the first subpixel P1 may be a blue subpixel, the second subpixel P2 may be a red subpixel, and the third subpixel P3 may be a green subpixel.

The first subpixel P1 may include the first light-emitting area EA1, the second subpixel P2 may include the second light-emitting area EA2, and the third subpixel P3 may include the third light-emitting area EA3.

In an embodiment, the size of the first light-emitting area EA1 may be greater than each of the size of the second light-emitting area EA2 and the size of the third light-emitting area EA3.

In an embodiment, the size of the second light-emitting area EA2 may be smaller than the size of the third light-emitting area EA3.

In an embodiment, the size of the first light-emitting area EA1 may be at least 1.3 times the size of the second light-emitting area EA2 or the size of the third light-emitting area EA3.

In some embodiments, the size of the first light-emitting area EA1 may be at least 1.6 times the size of the second light-emitting area EA2 or the size of the third light-emitting area EA3.

In some embodiments, the size of the first light-emitting area EA1 may be at least 1.6 times the size of the third light-emitting area EA3.

In some embodiments, the size of the first light-emitting area EA1 may be at least twice the size of the second light-emitting area EA2 or the size of the third light-emitting area EA3.

In some embodiments, the size of the first light-emitting area EA1 may be at least twice the size of the second light-emitting area EA2.

In an embodiment, the shapes of the first light-emitting area EA1, the second light-emitting area EA2, and the third light-emitting area EA3 may be quadrangular shapes. In some embodiments, the shapes of the first light-emitting area EA1, the second light-emitting area EA2, and the third light-emitting area EA3 may be rectangular shapes.

Although the embodiments of FIGS. 6-8 relate to various cases in which the first subpixel P1, the second subpixel P2 and the third subpixel P3 are positioned in a linear arrangement, it is to be understood that this is not required and that other arrangements are possible. For example, in some cases, where the first subpixel P1, the second subpixel P2 and the third subpixel P3 are positioned in a linear arrangement, one or more of the first subpixel P1, the second subpixel P2 and the third subpixel P3 can be staggered or offset relative to the others.

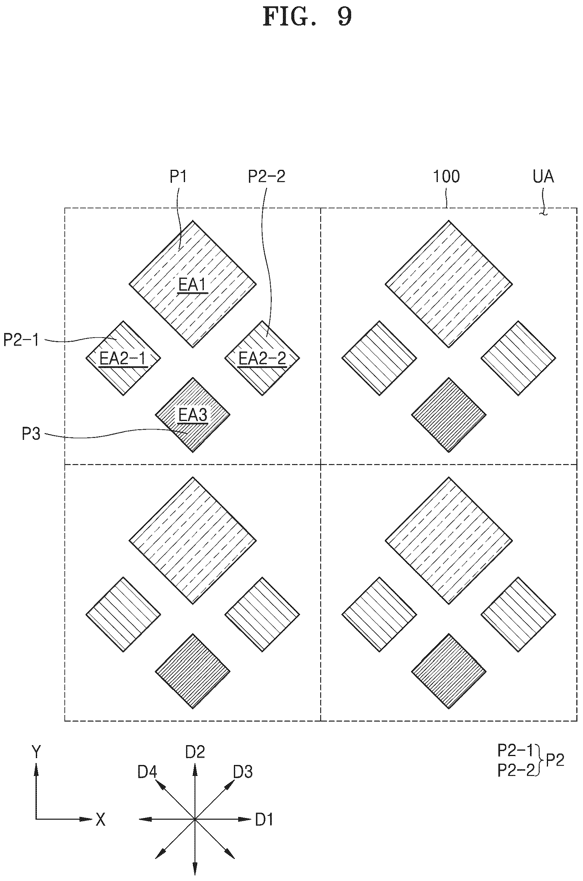

FIG. 9 is a plan view schematically illustrating a part of a display apparatus according to an embodiment, and is a plan view showing the light-emitting areas of subpixels.

Referring to FIG. 9, the second subpixel P2 may include a first sub-subpixel P2-1 and a second sub-subpixel P2-2 that are spaced apart from each other, and in this case, the first subpixel P1, the first sub-subpixel P2-1, the second sub-subpixel P2-2, and the third subpixel P3 may be spaced apart from each other. The first sub-subpixel P2-1 and the second sub-subpixel P2-2 may be driven by one pixel circuit.

In an embodiment, the first subpixel P1 may be a blue subpixel, the second subpixel P2 may be a green subpixel, and the third subpixel P3 may be a red subpixel.

On the unit area UA, the first sub-subpixel P2-1 may be positioned adjacent to the first subpixel P1 in the third direction D3 and adjacent to the third subpixel P3 in the fourth direction D4. The second sub-subpixel P2-2 may be positioned adjacent to the first subpixel P2 in the fourth direction D4 and adjacent to the third subpixel P3 in the third direction D3. The first sub-subpixel P2-1 and the second sub-subpixel P2-2 may be positioned adjacent to each other in or along the first direction D1. The third direction D3 and the fourth direction D4 may be formed in directions intersecting the first direction D1 and the second direction D2 such that the first sub-subpixel P2-1, the second sub-subpixel P2-2 and the third subpixel P3 are positioned in a crisscrossing or diamond-shaped pattern.

On the unit area UA, the first subpixel P1 and the third subpixel P3 may be positioned adjacent to each other in or along the second direction D2.

The first subpixel P1 may include a first light-emitting area EA1, the second subpixel P2 may include a first sub light-emitting area EA2-1 corresponding to the first sub-subpixel P2-1 and a second sub light-emitting area EA2-2 corresponding to the second sub-subpixel P2-2, and the third subpixel P3 may include a third light-emitting area EA3.

In an embodiment, the size of the first light-emitting area EA1 may be greater than the sum of the sizes of the first sub light-emitting area EA2-1 and the second sub light-emitting area EA2-2.

In an embodiment, the size of the first light-emitting area EA1 may be greater than the size of the third light-emitting area EA3.

In an embodiment, the sum of the sizes of the first sub light-emitting area EA2-1 and the second sub light-emitting area EA2-2 may be greater than the size of the third light-emitting area EA3.

In an embodiment, the size of the first light-emitting area EA1 may be at least 1.3 times the sum of the sizes of the first sub light-emitting area EA2-1 and the second sub light-emitting area EA2-2 or the size of the third light-emitting area EA3. The size of the first light-emitting area EA1 may be about 1.3 times to about 5.0 times, about 1.4 times to about 5.0 times, about 1.5 times to about 5.0 times, about 1.6 times to about 5.0 times, about 1.7 times to about 5.0 times, about 1.8 times to about 5.0 times, about 1.9 times to about 5.0 times, about 2.0 times to about 5.0 times, about 2.2 times to about 5.0 times, about 2.4 times to about 5.0 times, about 2.6 times to about 5.0 times, about 2.8 times to about 5.0 times, about 3.0 times to about 5.0 times, about 3.1 times to about 5.0 times, about 3.3 times to about 5.0 times, about 3.5 times to about 5.0 times, about 3.7 times to about 5.0 times, about 3.9 times to about 5.0 times, about 4.0 times to about 5.0 times, about 4.2 times to about 5.0 times, about 4.4 times to about 5.0 times, about 4.6 times to about 5.0 times, about 4.7 times to about 5.0 times, about 4.8 times to about 5.0 times, about 1.3 times to about 4.5 times, about 1.4 times to about 4.5 times, about 1.5 times to about 4.5 times, about 1.6 times to about 4.5 times, about 1.7 times to about 4.5 times, about 1.8 times to about 4.5 times, about 1.9 times to about 4.5 times, about 2.0 times to about 4.5 times, about 2.2 times to about 4.5 times, about 2.4 times to about 4.5 times, about 2.6 times to about 4.5 times, about 2.8 times to about 4.5 times, about 3.0 times to about 4.5 times, about 3.1 times to about 4.5 times, about 3.3 times to about 4.5 times, about 3.5 times to about 4.5 times, about 3.7 times to about 4.5 times, about 3.9 times to about 4.5 times, about 4.0 times to about 4.5 times, about 4.2 times to about 4.5 times, about 4.4 times to about 4.5 times, about 1.3 times to about 4.0 times, about 1.4 times to about 4.0 times, about 1.5 times to about 4.0 times, about 1.6 times to about 4.0 times, about 1.7 times to about 4.0 times, about 1.8 times to about 4.0 times, about 1.9 times to about 4.0 times, about 2.0 times to about 4.0 times, about 2.2 times to about 4.0 times, about 2.4 times to about 4.0 times, about 2.6 times to about 4.0 times, about 2.8 times to about 4.0 times, about 3.0 times to about 4.0 times, about 3.1 times to about 4.0 times, about 3.3 times to about 4.0 times, about 3.5 times to about 4.0 times, about 3.7 times to about 4.0 times, about 3.9 times to about 4.0 times, about 1.3 times to about 3.5 times, about 1.4 times to about 3.5 times, about 1.5 times to about 3.5 times, about 1.6 times to about 3.5 times, about 1.7 times to about 3.5 times, about 1.8 times to about 3.5 times, about 1.9 times to about 3.5 times, about 2.0 times to about 3.5 times, about 2.2 times to about 3.5 times, about 2.4 times to about 3.5 times, about 2.6 times to about 3.5 times, about 2.8 times to about 3.5 times, about 3.0 times to about 3.5 times, about 3.1 times to about 3.5 times, about 3.3 times to about 3.5 times, about 1.3 times to about 3.0 times, about 1.4 times to about 3.0 times, about 1.5 times to about 3.0 times, about 1.6 times to about 3.0 times, about 1.7 times to about 3.0 times, about 1.8 times to about 3.0 times, about 1.9 times to about 3.0 times, about 2.0 times to about 3.0 times, about 2.2 times to about 3.0 times, about 2.4 times to about 3.0 times, about 2.6 times to about 3.0 times, about 2.8 times to about 3.0 times, about 1.3 times to about 2.5 times, about 1.4 times to about 2.5 times, about 1.5 times to about 2.5 times, about 1.6 times to about 2.5 times, about 1.7 times to about 2.5 times, about 1.8 times to about 2.5 times, about 1.9 times to about 2.5 times, about 2.0 times to about 2.5 times, about 2.2 times to about 2.5 times, about 2.4 times to about 2.5 times, about 1.3 times to about 2.0 times, about 1.4 times to about 2.0 times, about 1.5 times to about 2.0 times, about 1.6 times to about 2.0 times, about 1.7 times to about 2.0 times, about 1.8 times to about 2.0 times, or about 1.9 times to about 2.0 times, each the sum of the sizes of the first sub light-emitting area EA2-1 and the second sub light-emitting area EA2-2 or the size of the third light-emitting area EA3.

In some embodiments, the size of the first light-emitting area EA1 may be at least 1.6 times the sum of the sizes of the first sub light-emitting area EA2-1 and the second sub light-emitting area EA2-2 or the size of the third light-emitting area EA3.

In some embodiments, the size of the first light-emitting area EA1 may be at least 1.6 times the sum of the sizes of the first sub light-emitting area EA2-1 and the second sub light-emitting area EA2-2.

In some embodiments, the size of the first light-emitting area EA1 may be at least twice the size of the sum of the sizes of the first sub light-emitting area EA2-1 and the second sub light-emitting area EA2-2 or the size of the third light-emitting area EA3.

In some embodiments, the size of the first light-emitting area EA1 may be at least twice the size of the third light-emitting area EA3.

In an embodiment, the shapes of the first light-emitting area EA1, the first sub light-emitting area EA2-1, the second sub light-emitting area EA2-2, and the third light-emitting area EA3 may be rhombus shapes.

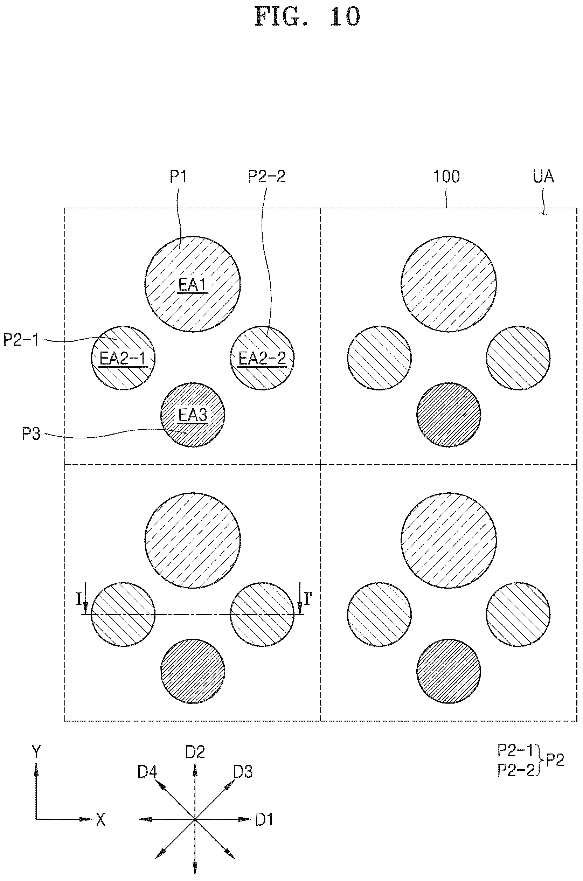

FIG. 10 is a plan view schematically illustrating a part of a display apparatus according to an embodiment, and is a plan view showing the light-emitting areas of subpixels.

Referring to FIG. 10, the second subpixel P2 may include a first sub-subpixel P2-1 and a second sub-subpixel P2-2 that are spaced apart from each other, and in this case, the first subpixel P1, the first sub-subpixel P2-1, the second sub-subpixel P2-2, and the third subpixel P3 may be spaced apart from each other. The first sub-subpixel P2-1 and the second sub-subpixel P2-2 may be driven by one pixel circuit.

In an embodiment, the first subpixel P1 may be a blue subpixel, the second subpixel P2 may be a green subpixel, and the third subpixel P3 may be a red subpixel.

On the unit area UA, the first sub-subpixel P2-1 may be positioned adjacent to the first subpixel P1 in the third direction D3 and adjacent to the third subpixel P3 in the fourth direction D4. The second sub-subpixel P2-2 may be positioned adjacent to the first subpixel P2 in the fourth direction D4 and adjacent to the third subpixel P3 in the third direction D3. The first sub-subpixel P2-1 and the second sub-subpixel P2-2 may be positioned adjacent to each other in or along the first direction D1. The third direction D3 and the fourth direction D4 may be formed in directions intersecting the first direction D1 and the second direction D2 such that the first sub-subpixel P2-1, the second sub-subpixel P2-2 and the third subpixel P3 are positioned in a crisscrossing or diamond-shaped pattern.

On the unit area UA, the first subpixel P1 and the third subpixel P3 may be positioned adjacent to each other in or along the second direction D2.

The first subpixel P1 may include a first light-emitting area EA1, the second subpixel P2 may include a first sub light-emitting area EA2-1 corresponding to the first sub-subpixel P2-1 and a second sub light-emitting area EA2-2 corresponding to the second sub-subpixel P2-2, and the third subpixel P3 may include a third light-emitting area EA3.

In an embodiment, the size of the first light-emitting area EA1 may be greater than the sum of the sizes of the first sub light-emitting area EA2-1 and the second sub light-emitting area EA2-2.

In an embodiment, the size of the first light-emitting area EA1 may be greater than the size of the third light-emitting area EA3.

In an embodiment, the sum of the sizes of the first sub light-emitting area EA2-1 and the second sub light-emitting area EA2-2 may be greater than the size of the third light-emitting area EA3.

In an embodiment, the size of the first light-emitting area EA1 may be at least 1.3 times the sum of the sizes of the first sub light-emitting area EA2-1 and the second sub light-emitting area EA2-2 or the size of the third light-emitting area EA3. The size of the first light-emitting area EA1 may be about 1.3 times to about 5.0 times, about 1.4 times to about 5.0 times, about 1.5 times to about 5.0 times, about 1.6 times to about 5.0 times, about 1.7 times to about 5.0 times, about 1.8 times to about 5.0 times, about 1.9 times to about 5.0 times, about 2.0 times to about 5.0 times, about 2.2 times to about 5.0 times, about 2.4 times to about 5.0 times, about 2.6 times to about 5.0 times, about 2.8 times to about 5.0 times, about 3.0 times to about 5.0 times, about 3.1 times to about 5.0 times, about 3.3 times to about 5.0 times, about 3.5 times to about 5.0 times, about 3.7 times to about 5.0 times, about 3.9 times to about 5.0 times, about 4.0 times to about 5.0 times, about 4.2 times to about 5.0 times, about 4.4 times to about 5.0 times, about 4.6 times to about 5.0 times, about 4.7 times to about 5.0 times, about 4.8 times to about 5.0 times, about 1.3 times to about 4.5 times, about 1.4 times to about 4.5 times, about 1.5 times to about 4.5 times, about 1.6 times to about 4.5 times, about 1.7 times to about 4.5 times, about 1.8 times to about 4.5 times, about 1.9 times to about 4.5 times, about 2.0 times to about 4.5 times, about 2.2 times to about 4.5 times, about 2.4 times to about 4.5 times, about 2.6 times to about 4.5 times, about 2.8 times to about 4.5 times, about 3.0 times to about 4.5 times, about 3.1 times to about 4.5 times, about 3.3 times to about 4.5 times, about 3.5 times to about 4.5 times, about 3.7 times to about 4.5 times, about 3.9 times to about 4.5 times, about 4.0 times to about 4.5 times, about 4.2 times to about 4.5 times, about 4.4 times to about 4.5 times, about 1.3 times to about 4.0 times, about 1.4 times to about 4.0 times, about 1.5 times to about 4.0 times, about 1.6 times to about 4.0 times, about 1.7 times to about 4.0 times, about 1.8 times to about 4.0 times, about 1.9 times to about 4.0 times, about 2.0 times to about 4.0 times, about 2.2 times to about 4.0 times, about 2.4 times to about 4.0 times, about 2.6 times to about 4.0 times, about 2.8 times to about 4.0 times, about 3.0 times to about 4.0 times, about 3.1 times to about 4.0 times, about 3.3 times to about 4.0 times, about 3.5 times to about 4.0 times, about 3.7 times to about 4.0 times, about 3.9 times to about 4.0 times, about 1.3 times to about 3.5 times, about 1.4 times to about 3.5 times, about 1.5 times to about 3.5 times, about 1.6 times to about 3.5 times, about 1.7 times to about 3.5 times, about 1.8 times to about 3.5 times, about 1.9 times to about 3.5 times, about 2.0 times to about 3.5 times, about 2.2 times to about 3.5 times, about 2.4 times to about 3.5 times, about 2.6 times to about 3.5 times, about 2.8 times to about 3.5 times, about 3.0 times to about 3.5 times, about 3.1 times to about 3.5 times, about 3.3 times to about 3.5 times, about 1.3 times to about 3.0 times, about 1.4 times to about 3.0 times, about 1.5 times to about 3.0 times, about 1.6 times to about 3.0 times, about 1.7 times to about 3.0 times, about 1.8 times to about 3.0 times, about 1.9 times to about 3.0 times, about 2.0 times to about 3.0 times, about 2.2 times to about 3.0 times, about 2.4 times to about 3.0 times, about 2.6 times to about 3.0 times, about 2.8 times to about 3.0 times, about 1.3 times to about 2.5 times, about 1.4 times to about 2.5 times, about 1.5 times to about 2.5 times, about 1.6 times to about 2.5 times, about 1.7 times to about 2.5 times, about 1.8 times to about 2.5 times, about 1.9 times to about 2.5 times, about 2.0 times to about 2.5 times, about 2.2 times to about 2.5 times, about 2.4 times to about 2.5 times, about 1.3 times to about 2.0 times, about 1.4 times to about 2.0 times, about 1.5 times to about 2.0 times, about 1.6 times to about 2.0 times, about 1.7 times to about 2.0 times, about 1.8 times to about 2.0 times, or about 1.9 times to about 2.0 times, each the sum of the sizes of the first sub light-emitting area EA2-1 and the second sub light-emitting area EA2-2 or the size of the third light-emitting area EA3.

In some embodiments, the size of the first light-emitting area EA1 may be at least 1.6 times the sum of the sizes of the first sub light-emitting area EA2-1 and the second sub light-emitting area EA2-2 or the size of the third light-emitting area EA3.

In some embodiments, the size of the first light-emitting area EA1 may be at least 1.6 times the sum of the sizes of the first sub light-emitting area EA2-1 and the second sub light-emitting area EA2-2.

In some embodiments, the size of the first light-emitting area EA1 may be at least twice the size of the sum of the sizes of the first sub light-emitting area EA2-1 and the second sub light-emitting area EA2-2 or the size of the third light-emitting area EA3.

In some embodiments, the size of the first light-emitting area EA1 may be at least twice the size of the third light-emitting area EA3.

In an embodiment, the shapes of the first light-emitting area EA1, the first sub light-emitting area EA2-1, the second sub light-emitting area EA2-2, and the third light-emitting area EA3 may be circular or annular shapes.

In an embodiment, the shapes of the unit area UA of FIGS. 7 to 10 and the first light-emitting area EA1, the second light-emitting area EA2, the first sub light-emitting area EA2-1, the second sub light-emitting area EA2-2, and the third light-emitting area EA3 included therein may be combined with each other. In other words, unit areas UA including the first light-emitting area EA1, the second light-emitting area EA2, the first sub light-emitting area EA2-1, the second sub light-emitting area EA2-2, and the third light-emitting area EA3, each having at least one or more of a rectangular shape, a rhombus shape, a circular or annular shape, and/or any combination thereof, may be combined with each other to form the display panel 10 including at least one or more of a rectangular shape, a rhombus shape, a circular or annular shape, and/or any combination thereof.

Although the embodiments of FIGS. 9 and 10 relate to various cases in which the first subpixel P1, the second subpixel P2 and the third subpixel P3 are positioned in a crisscrossing pattern, it is to be understood that this is not required and that other arrangements are possible. For example, in some cases, where the first subpixel P1, the second subpixel P2 and the third subpixel P3 are positioned in a crisscrossing pattern, the first subpixel P1, the second subpixel P2 and the third subpixel P3 can be arranged in a wishbone pattern or a dogbone pattern.

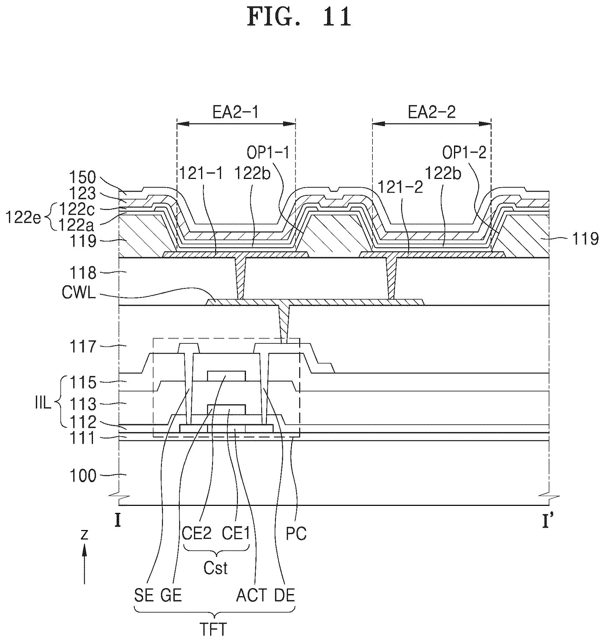

FIG. 11 is a cross-sectional view schematically illustrating a portion of a cross-section of a display apparatus according to an embodiment. FIG. 11 shows an example of a cross-section of a portion of the display apparatus of FIG. 10 taken along line I-I'. In FIG. 11, the same reference numerals as in FIG. 4 indicate the same elements. Accordingly, a duplicate description thereof is omitted.

Referring to FIG. 11 together with FIG. 10, the second subpixel P2 may include the first sub-subpixel P2-1 and the second sub-subpixel P2-2. The pixel electrode 121 of the second subpixel P2 may include a first sub pixel electrode 121-1 corresponding to the first sub-subpixel P2-1 and a second sub pixel electrode 121-2 corresponding to the second sub-subpixel P2-2. The pixel definition film 119 may define the first sub light-emitting area EA2-1 by having a first opening OP1-1 that exposes at least a portion of the first sub pixel electrode 121-1. The pixel definition film 119 may have a second opening OP1-2 that exposes at least a portion of the second sub pixel electrode 121-2 to define the second sub light-emitting area EA2-2. That is, the first sub pixel electrode 121-1 may correspond to the first sub light-emitting area EA2-1, and the second sub pixel electrode 121-2 may correspond to the second sub light-emitting area EA2-2.

In an embodiment, connecting wiring CWL may be positioned on the planarization layer 117. At least a portion of the connecting wiring CWL may overlap with the first sub pixel electrode 121-1 and the second sub pixel electrode 121-2 in the z direction. The connecting wiring CWL may include a conductive material. An upper planarization layer 118 may cover the connecting wiring CWL and may be positioned on the planarization layer 117. The upper planarization layer 118 may include the same material as the planarization layer 117. The first sub pixel electrode 121-1 and the second sub pixel electrode 121-2 may be positioned on the upper planarization layer 118.

The first sub pixel electrode 121-1 and the second sub pixel electrode 121-2 may be electrically connected to the connecting wiring CWL through a via hole of the upper planarization layer 118. Accordingly, the first sub pixel electrode 121-1 and the second sub pixel electrode 121-2 may be electrically connected to each other. The connecting wiring CWL may be in contact with the source electrode SE or the drain electrode DE through a via hole in the planarization layer 117, thereby being electrically connected to the thin film transistor TFT. The first sub pixel electrode 121-1 and the second sub pixel electrode 121-2 may be electrically connected to the same pixel circuit PC. The first sub-subpixel P2-1 and the second sub-subpixel P2-2 may be driven by the same pixel circuit PC.

Unlike FIG. 11, in an alternative embodiment, the first sub pixel electrode 121-1 and the second sub pixel electrode 121-2 may be formed integrally, and the connection wiring connecting the first sub pixel electrode 121-1 to the second sub pixel electrode 121-2 may be omitted or may be modified to have only a single via hole of the upper planarization layer 118.

According to an embodiment, the first subpixel, the second subpixel, and the third subpixel, which emit light of different colors on the unit area UA, may be spaced apart from each other. In addition, the first subpixel may be formed with a size (aperture ratio) that may be a preset multiple compared to the second subpixel and the third subpixel, and thus may have excellent long-lifespan characteristics.

In addition, according to an embodiment, a light-emitting element included in a display apparatus according to the disclosure can have excellent long-lifespan characteristics and excellent front-side efficiency characteristics due to the inclusion of an emission layer, an electron-blocking layer, and a hole-blocking layer, which have preset thickness ranges.

The display apparatus according to the embodiment may be applied to various electronic devices. An electronic device according to an embodiment includes the display apparatus described above, and may further include a module or device having additional functions in addition to the display apparatus.

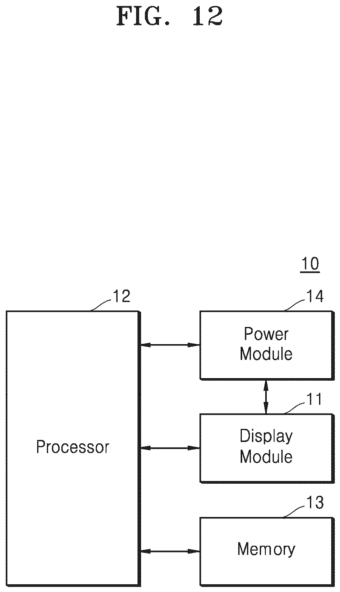

FIG. 12 is a block diagram of an electronic device according to an embodiment. Referring to FIG. 12, an electronic device 10 according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

Data information for the operation of the processor 12 or display module 11 may be stored in the memory 13. When the processor 12 executes an application stored in the memory 13, an image data signal and/or an input control signal may be transmitted to the display module 11, and the display module 11 may process the received signal and output image information through a display screen.

The power module 14 may include a power supply module, such as a power adapter or a battery device, and a power conversion module that converts power supplied by the power supply module to generate power for the operation of the electronic device 10.

At least one of the components of the electronic device 10 may be included in the display apparatus according to the embodiments provided hereinbefore. Additionally, some of the individual modules functionally included within a module may be included within the display apparatus, while others may be provided separately from the display apparatus. For example, the display apparatus may include the display module 11, and the processor 12, the memory 13, and the power module 14 may be provided in the form of other devices within the electronic device 10 other than the display apparatus.

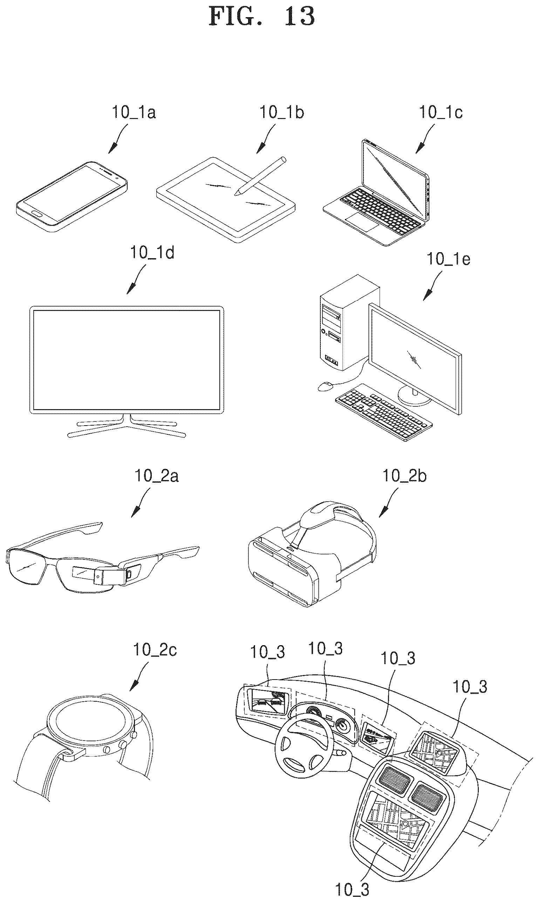

FIG. 13 shows schematic diagrams of an electronic device according to various embodiments.

Referring to FIG. 13, various electronic devices to which the display apparatus according to embodiments are applied may include not only image display electronic devices such as a smart phone 10_1a, a tablet PC 10_1b, a laptop 10_1c, a TV 10_1d, and a desk monitor 10_1e, but also wearable electronic devices including display modules such as smart glasses 10_2a, a head mounted display 10_2b, and a smart watch 10_2c, and vehicle electronic devices 10_3 including display modules such as a center information display (CID) positioned on a dashboard, a center fascia, and a car instrument panel, and a room mirror display.

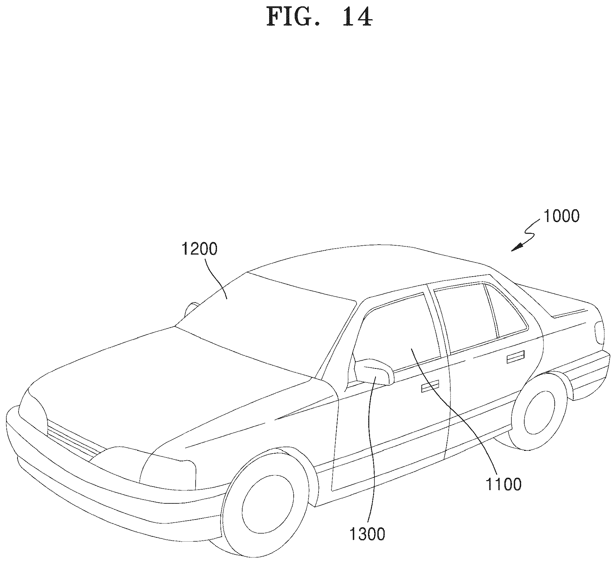

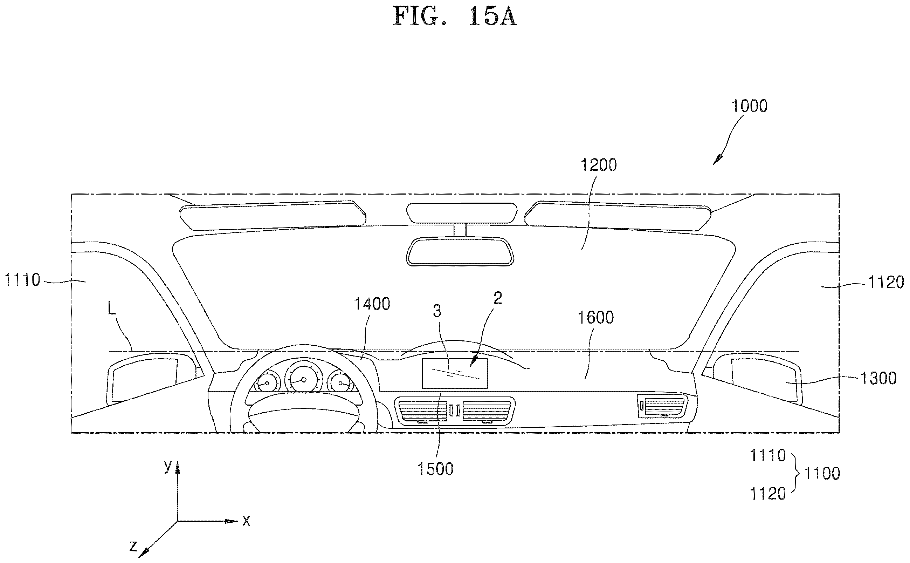

FIG. 14 is a drawing schematically illustrating the exterior of a vehicle 1000 as an electronic device including a display apparatus according to an embodiment. FIGS. 15A to 15C are schematic drawings illustrating the interior of the vehicle 1000 according to various embodiments.

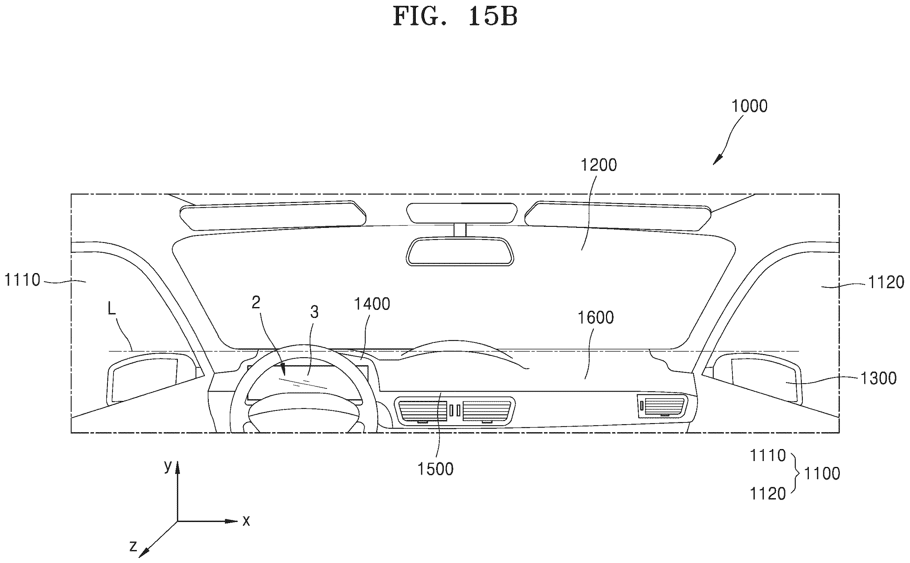

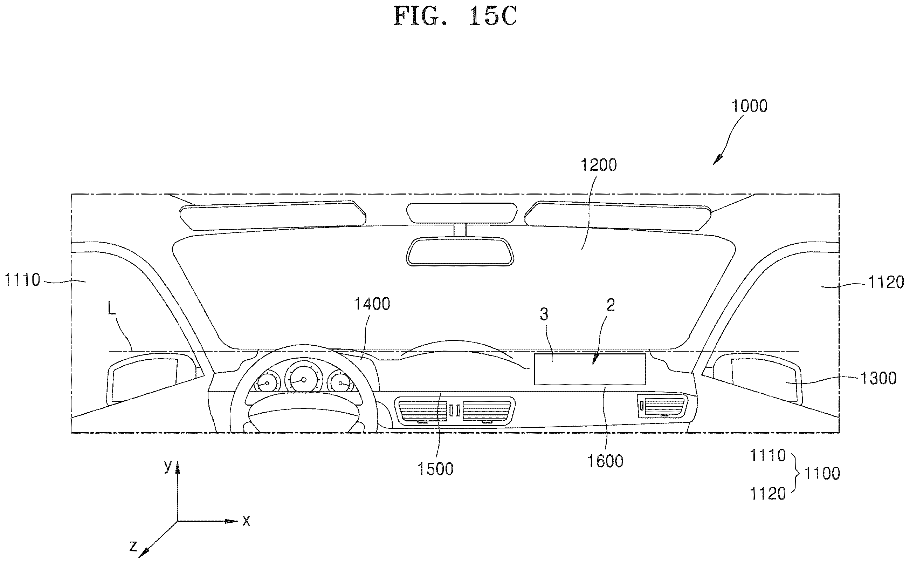

Referring to FIGS. 14, 15A, 15B, and 15C, the vehicle 1000 may refer to various apparatuses for moving a subject object to be transported, such as a human, an object, or an animal, from a departure point to a destination. The vehicle 1000 may include a vehicle traveling on a road or track, a vessel moving over the sea or river, an airplane flying in the sky using the action of air, and the like.

The vehicle 1000 may travel on a road or a track. The vehicle 1000 may move in a certain direction according to rotation of at least one wheel. In an embodiment, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body of the vehicle 1000. The exterior of the body of the vehicle may include a front panel, a bonnet, a roof panel, a rear panel, a trunk, a pillar provided at a boundary between doors, and the like. The chassis of the vehicle 1000 may include a power generating device, a power transmitting device, a driving device, a steering device, a braking device, a suspension device, a transmission device, a fuel device, front and rear wheels, left and right wheels, and the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar positioned between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be positioned adjacent to the cluster 1400. The second side window glass 1120 may be positioned adjacent to the passenger seat dashboard 1600.

In an embodiment, the side window glasses 1100 may be spaced apart from each other in an x direction or a -x direction. In an embodiment, the first side window glass 1110 and the second side window glass 1120 may be spaced apart from each other in the x direction or the -x direction. In other words, an imaginary straight line L connecting the side window glasses 1100 may extend in the x direction or the -x direction. In an embodiment, an imaginary straight line L connecting the first side window glass 1110 and the second side window glass 1120 to each other may extend in the x direction or the -x direction.

The front window glass 1200 may be installed in front of the vehicle 1000. The front window glass 1200 may be positioned between the side window glasses 1100 facing each other.

The side-view mirror 1300 may provide a rear view of the vehicle 1000. The side-view mirror 1300 may be installed on the exterior of the body of the vehicle. In an embodiment, a plurality of side-view mirrors 1300 may be provided. Any one of the plurality of side-view mirrors 1300 may be positioned outside the first side window glass 1110. Another of the plurality of side-view mirrors 1300 may be positioned outside the second side window glass 1120.

The cluster 1400 may be positioned in front of a steering wheel. The cluster 1400 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1500 may include a control panel on which a plurality of buttons for adjusting an audio device, an air conditioning device, and a seat heater are positioned. The center fascia 1500 may be positioned on one side of the cluster 1400.

The passenger seat dashboard 1600 may be spaced apart from the cluster 1400, and the center fascia 1500 may be positioned between the cluster 1400 and the passenger seat dashboard 1600. In an embodiment, the cluster 1400 may be positioned to correspond to a driver seat (not shown), and the passenger seat dashboard 1600 may be positioned to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display apparatus 2 may include a display panel 3, and the display panel 3 may display an image. The display apparatus 2 may be positioned inside the vehicle 1000. In an embodiment, the display apparatus 2 may be positioned between the side window glasses 1100 facing each other. The display apparatus 2 may be positioned on at least one of the cluster 1400, the center fascia 1500, and the passenger seat dashboard 1600.

The display device 2 may include an organic light-emitting display device, an inorganic electroluminescent display device, a quantum dot display device, and the like. Hereinafter, as the display device 2 according to an embodiment, an organic light-emitting display apparatus will be described as an example, but various types of the aforementioned display apparatus may be used in embodiments.

Referring to FIG. 15A, the display apparatus 2 may be positioned in the center fascia 1500. In an embodiment, the display apparatus 2 may display navigation information. In an embodiment, the display apparatus 2 may display information regarding audio settings, video setting, or vehicle settings.

Referring to FIG. 15B, the display apparatus 2 may be positioned in the cluster 1400. In this case, the cluster 1400 may display driving information and the like through the display apparatus 2. In other words, the cluster 1400 may be implemented digitally. The digital cluster 1400 may display vehicle information and driving information as images. In an embodiment, a needle and a gauge of a tachometer and various warning light icons may be displayed by a digital signal.

Referring to FIG. 15C, the display apparatus 2 may be positioned on the passenger seat dashboard 1600. The display apparatus 2 may be embedded in the passenger seat dashboard 1600 or positioned on the passenger seat dashboard 1600. In an embodiment, the display apparatus 2 positioned on the passenger seat dashboard 1600 may display an image related to information displayed on the cluster 1400 and/or information displayed on the center fascia 1500. In an embodiment, the display apparatus 2 positioned on the passenger seat dashboard 1600 may display information different from information displayed on the cluster 1400 and/or information displayed on the center fascia 1500.

### [Manufacturing method]

Layers constituting the hole transport area, the emission layer, and the layers constituting the electron transport area may be formed in a certain area by using various methods such as vacuum deposition, spin coating, casting, Langmuir-Blodgett (LB) deposition, ink-jet printing, laser-printing, laser-induced thermal imaging, and the like.

In addition, an organic compound layer included in the hole transport area, the emission layer and the electron transport area (the first electron transport layer and the second electron transport layer) may be formed by an inkjet printing method. The inkjet printing method may be performed using a known inkjet printer and a known inkjet printing method.

When the layers constituting the hole transport area, the emission layer, and the layers constituting the electron transport area are formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed and the structure of a layer to be formed.

### [Definition of terms]

The term "C₃-C₆₀ carbocyclic group" as used herein refers to a cyclic group including carbon atoms as the only ring-forming atoms and having three to sixty carbon atoms, and the term "C₁-C₆₀ heterocyclic group" as used herein refers to a cyclic group that has one to sixty carbon atoms and further includes, in addition to a carbon atom, a heteroatom as a ring-forming atom. The C₃-C₆₀ carbocyclic group and the C₁-C₆₀ heterocyclic group may each be a monocyclic group including one ring or a polycyclic group in which two or more rings are condensed with each other. In an alternative embodiment, the number of ring-forming atoms of the C₁-C₆₀ heterocyclic group may be 3 to 61.

The "cyclic group" as used herein may include both the C₃-C₆₀ carbocyclic group and the C₁-C₆₀ heterocyclic group.

The term "π electron-rich C₃-C₆₀ cyclic group" as used herein refers to a cyclic group that has 3 to 60 carbon atoms and does not include *-N=*' as a ring-forming moiety, and the term "π electron-deficient nitrogen-containing C₁-C₆₀ heterocyclic group" as used herein refers to a heterocyclic group that has 1 to 60 carbon atoms and includes *-N=*' as a ring-forming moiety.

In an embodiment,
the C₃-C₆₀ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the C3-C60 carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),
the π electron-deficient nitrogen-containing C₁-C₆₀ heterocyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

Group T3 may be a furan group, a thiophene group, a 1H-pyrrole group, a silole group, or a borole group, and

Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group," "the C₁-C₆₀ heterocyclic group," "the π electron-rich C₃-C₆₀ cyclic group," and "the π electron-deficient nitrogen-containing C₁-C₆₀ heterocyclic group" as used herein may each refer to a monovalent or polyvalent group (for example, a divalent group, a trivalent group, a tetravalent group, or the like) that is condensed with (e.g., combined together with) a cyclic group according to the structure of a formula for which the corresponding term is used. In an embodiment, the "benzene group" may be a benzo group, a phenyl group, a phenylene group, or the like, which may be easily understood by those of ordinary skill in the art according to the structure of a formula including the "benzene group."

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA101 (wherein A₁₀₁ may be the C₁-C₆₀ alkyl group), and examples thereof include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group that has one to ten carbon atoms and further includes, in addition to the carbon atoms, at least one heteroatom as a ring-forming atom, and examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of six to sixty carbon atoms, and the term "C₆-C₆₀ arylene group" as used herein refers to a divalent group having a carbocyclic aromatic system of six to sixty carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system that has one to sixty carbon atoms and further includes, in addition to the carbon atoms, at least one heteroatom as a ring-forming atom. The term "C₁-C₆₀ heteroarylene group" as used herein refers to a divalent group having a heterocyclic aromatic system that has one to sixty carbon atoms and further includes, in addition to the carbon atoms, at least one heteroatom as a ring-forming atom. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group having two or more rings condensed with each other, only carbon atoms (for example, eight to sixty carbon atoms) as ring-forming atoms, and no aromaticity in its molecular structure when considered as a whole. Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group that has two or more rings condensed with each other, further includes, in addition to carbon atoms (for example, one to sixty carbon atoms), at least one heteroatom as a ring-forming atom, and has no aromaticity in its molecular structure when considered as a whole. Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as the monovalent non-aromatic condensed heteropolycyclic group.

The term "C₆-C₆₀ aryloxy group" as used herein refers to -OA₁₀₂ (wherein, A₁₀₂ may be the C₆-C₆₀ aryl group), the C₆-C₆₀ arylthio group refers to -SA₁₀₃ (wherein, A₁₀₃ may be the C₆-C₆₀ aryl group), and the C₆-C₆₀ arylseleno group refers to -SeA₁₀₈ (wherein, A₁₀₈ may be the C₆-C₆₀ aryl group).

The term "C₇-C₆₀ arylalkyl group" as used herein refers to -A₁₀₄A₁₀₅ (wherein A₁₀₄ may be a C₁-C₅₄ alkylene group, and A₁₀₅ may be a C₆-C₅₉ aryl group), and the term "C₂-C₆₀ heteroarylalkyl group" as used herein refers to -A₁₀₆A₁₀₇ (wherein A₁₀₆ may be a C₁-C₅₉ alkylene group, and A₁₀₇ may be a C₁-C₅₉ heteroaryl group)

As used herein, the term "C₃-C₆₀ carbocyclic group" includes a C₃-C₅₀ carbocyclic group, a C₃-C₄₀ carbocyclic group, a C₃-C₃₀ carbocyclic group, a C₃-C₂₀ carbocyclic group, or a C₃-C₁₀ carbocyclic group;
the term "C₁-C₆₀ heterocyclic group" includes a C₁-C₅₀ heterocyclic group, a C₁-C₄₀ heterocyclic group, a C₁-C₃₀ heterocyclic group, a C₁-C₂₀ heterocyclic group, or a C₁-C₁₀ heterocyclic group;
the term "C₁-C₆₀ alkyl group" includes a C₁-C₅₀ alkyl group, a C₁-C₃₀ alkyl group, a C₁-C₂₀ alkyl group, or a C₁-C₁₀ alkyl group;
the term "C₂-C₆₀ alkenyl group" includes a C₂-C₃₀ alkenyl group, a C₂-C₂₀ alkenyl group, or a C₂-C₁₀ alkenyl group;
the term "C₂-C₆₀ alkynyl group" includes a C₂-C₃₀ alkynyl group, a C₂-C₂₀ alkynyl group, or a C₂-C₁₀ alkynyl group;
the term "C₁-C₆₀ alkoxy group" includes a C₁-C₃₀ alkoxy group, a C₁-C₂₀ alkoxy group, or a C₁-C₁₀ alkoxy group;
the term "C₆-C₆₀ aryl group" includes a C₆-C₅₀ aryl group, a C₆-C₄₀ aryl group, a C₆-C₃₀ aryl group, a C₆-C₂₀ aryl group, or a C₆-C₁₅ aryl group;
the term "C₁-C₆₀ heteroaryl group" includes a C₁-C₅₀ heteroaryl group, a C₁-C₄₀ heteroaryl group, a C₁-C₃₀ heteroaryl group, a C₁-C₂₀ heteroaryl group, or a C₁-C₁₀ heteroaryl group;
the term "monovalent non-aromatic condensed polycyclic group" includes a C₈-C₆₀ monovalent non-aromatic condensed polycyclic group, a C₈-C₅₀ monovalent non-aromatic condensed polycyclic group, a C₈-C₄₀ monovalent non-aromatic condensed polycyclic group, a C₈-C₃₀ monovalent non-aromatic condensed polycyclic group, or a C₈-C₂₀ monovalent non-aromatic condensed polycyclic group;
the term "monovalent non-aromatic condensed heteropolycyclic group" includes a C₁-C₆₀ monovalent non-aromatic condensed heteropolycyclic group, a C₁-C₅₀ monovalent non-aromatic condensed heteropolycyclic group, a C₁-C₄₀ monovalent non-aromatic condensed heteropolycyclic group, a C₁-C₃₀ monovalent non-aromatic condensed heteropolycyclic group, or a C₁-C₂₀ monovalent non-aromatic condensed heteropolycyclic group;
the term "C₆-C₆₀ aryloxy group" includes a C₆-C₅₀ aryloxy group, a C₆-C₄₀ aryloxy group, a C₆-C₃₀ aryloxy group, a C₆-C₂₀ aryloxy group, or a C₆-C₁₅ aryloxy group;
the term "C₆-C₆₀ arylthio group" includes a C₆-C₅₀ arylthio group, a C₆-C₄₀ arylthio group, a C₆-C₃₀ arylthio group, a C₆-C₂₀ arylthio group, or a C₆-C₁₅ arylthio group;
the term "C₆-C₆₀ arylseleno group" includes a C₆-C₅₀ arylseleno group, a C₆-C₄₀ arylseleno group, a C₆-C₃₀ arylseleno group, a C₆-C₂₀ arylseleno group, or a C₆-C₁₅ arylseleno group;
the term "C₇-C₆₀ arylalkyl group" includes a C₇-C₅₀ arylalkyl group, a C₇-C₄₀ arylalkyl group, a C₇-C₃₀ arylalkyl group, a C₇-C₂₀ arylalkyl group, or a C₇-C₁₅ arylalkyl group; and
the term "C₂-C₆₀ heteroarylalkyl group" includes a C₂-C₅₀ heteroarylalkyl group, a C₂-C₄₀ heteroarylalkyl group, a C₂-C₃₀ heteroarylalkyl group, a C₂-C₂₀ heteroarylalkyl group, or a C₂-C₁₅ heteroarylalkyl group.

**.**

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), and/or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), and/or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, and/or any combination thereof; a C₇-C₆₀ arylalkyl group; or a C₂-C₆₀ heteroarylalkyl group.

The term "heteroatom" as used herein refers to any atom other than a carbon atom. Examples of the heteroatom include O, S, N, P, Si, B, Ge, Se, and/or any combination thereof.

The term "third-row transition metal" used herein includes hafnium (Hf), tantalum (Ta), tungsten (W), rhenium (Re), osmium (Os), iridium (Ir), platinum (Pt), gold (Au), and the like.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group that may be substituted with a phenyl group." In other words, the "biphenyl group" may be a substituted phenyl group having a C₆-C₆₀ aryl group as a substituent.

The term "terphenyl group" as used herein refers to "a phenyl group substituted with a biphenyl group." The "terphenyl group" may be a substituted phenyl group having, as a substituent, a C₆-C₆₀ aryl group substituted with a C₆-C₆₀ aryl group.

* and *' as used herein, unless defined otherwise, each refer to a binding site to a neighboring atom in a corresponding formula or moiety.
The terms "x-axis," "y-axis," and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.
In the specification, "an integer selected from 0 to 20" refers to an integer selected from 0, 1, 2, 3, 4, 5, 6, 7, 8, 9, 10, 11, 12, 13, 14, 15, 16, 17, 18, 19, and 20. The above description of numerical ranges is also applicable for any other numerical range that appears in the present specification, for example, an integer selected from 0 and 1, an integer selected from 0 to 2, an integer selected from 0 to 3, an integer selected from 0 to 4, an integer selected from 0 to 5, an integer selected from 0 to 6, an integer selected from 0 to 7, an integer selected from 0 to 8, an integer selected from 0 to 9, an integer selected from 0 to 10, an integer selected from 0 to 11, an integer selected from 0 to 12, an integer selected from 0 to 13, an integer selected from 0 to 14, an integer selected from 0 to 15, an integer selected from 0 to 16, an integer selected from 0 to 17, an integer selected from 0 to 18, an integer selected from 0 to 19, and the like.

Hereinafter, a display apparatus according to an embodiment will be described in more detail with reference to examples. In the expression "B was used instead of A" below, the molar equivalents of A and B are the same.

### [Examples]

### Manufacturing of light-emitting elements

A light-emitting element included in a display apparatus confirmed in the evaluation example below was manufactured by the following method.

An anode was prepared by cutting Corning 15 Ω/cm² (1200 Å) ITO/Ag/ITO glass substrate to 50 mm x 50 mm x 0.5 mm size, ultrasonically cleaning with isopropyl alcohol and pure water for 5 minutes each, then cleaning by irradiating with ultraviolet light for 30 minutes and exposing to ozone, and installing this glass substrate in a vacuum deposition apparatus.

On the substrate, HATCN was first deposited to form a hole injection layer having a thickness of 100 Å, followed by vacuum deposition of HT3, which may be a hole transport material, to a thickness of 600 Å, and then HTH41 was vacuum-deposited to form an electron-blocking layer.

On the electron-blocking layer, a hole transport host (HTH42), an electron transport host (ETH101), a phosphorescent compound (PD40), and a delayed fluorescence compound (DFD30) were co-deposited at a weight ratio of 87HTH42:ETH101=6:4):13:1.

Subsequently, ETH34 was deposited on the emission layer as a hole-blocking layer, followed by co-deposition of mSiTrz and LiQ at a ratio of 1:1 to form an electron transport layer having a thickness of 350 Å. Yb was deposited on the electron transport layer to form an electron injection layer having a thickness of 13 Å, and Mg:Ag was vacuum-deposited at a weight ratio of 10:90 to form an electrode having the thickness of 120 Å, thereby completing of fabrication an organic light-emitting element.

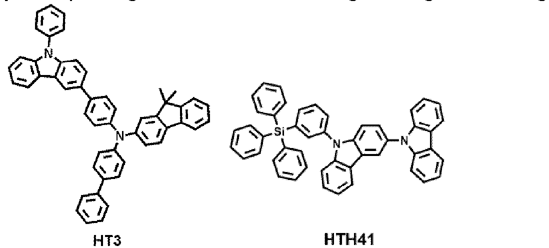

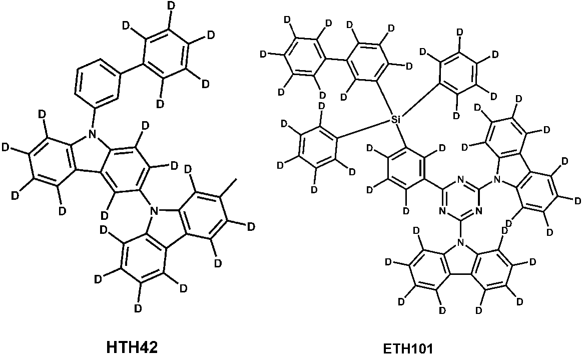

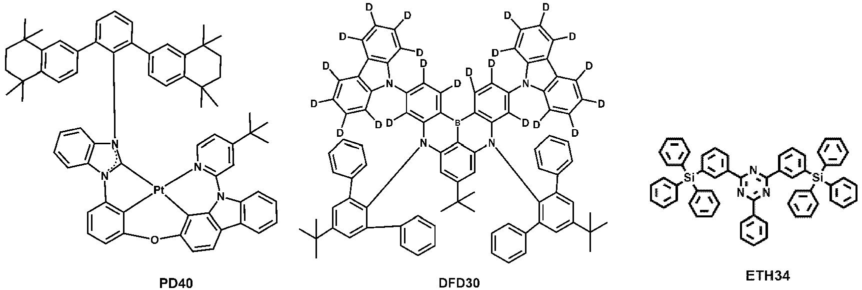

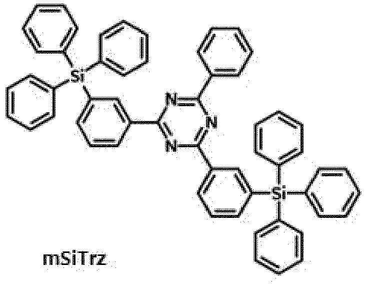

### Evaluation Example 1: Confirmation of lifespan characteristics by panel pixel aperture ratio (light-emitting area)

The lifespan characteristics of display apparatuses with different aperture ratios were verified. Results thereof are shown below. The lifespan was calculated based on a display apparatus with a blue aperture of 42% (100%).

**Table 1**

| Aperture rato % | | | Blue Lifespan % |
|---|---|---|---|
| R | G | B | |
| 16 | 23 | 27 | 50 |
| 16 | 23 | 30 | 75 |
| 14 | 24 | 42 | 100 |
| 15 | 25 | 41 | 100 |

Referring to Table 1, it was confirmed that when the aperture ratio (light-emitting area) of a blue subpixel may be a multiple of the ranges provided herein compared to the aperture ratio of a red subpixel or a green subpixel, excellent long-lifespan characteristics can be secured.

### Evaluation Example 2: Verification of front-side efficiency and lifespan characteristics according to the thickness of emission layer, electron-blocking layer, and hole-blocking layer

The front-side efficiency and lifespan characteristics of a display apparatus according to thicknesses of an emission layer, an electron-blocking layer, and a hole-blocking layer were confirmed. Results thereof are shown below. For front-side efficiency, the front-side conversion efficiency (cd/A/y) was quantified based on the efficiency and color coordinates at blue luminance considering the white target luminance, and for lifespan, it was measured by applying the needed current at this blue luminance and calculated relative lifespan based on lifespan(100%).

**Table 2**

| Thickness of emission layer (Å) | Front-side efficiencycd/A/y) | Lifespan (%) |
|---|---|---|
| 300 | 480 | 80 |
| 350 | 510 | 95 |
| 400 | 514 | 100 |
| 450 | 507 | 105 |

**Table 3**

| Thickness of electron-blocking layer (Å) | Front-side efficiency (cd/A/y) | Lifespan (%) |
|---|---|---|
| 150 | 510 | 80 |
| 100 | 509 | 95 |
| 50 | 514 | 100 |
| 25 | 478 | - |

**Table 4**

| Thickness of hole-blocking layer (Å) | Front-side efficiency (cd/A/y) | Lifespan (%) |
|---|---|---|
| 100 | 500 | 90 |
| 80 | 511 | 90 |
| 50 | 514 | 100 |
| 30 | 503 | 105 |

Referring to Tables 2 to 4, it was confirmed that when the thickness of the emission layer, electron-blocking layer, and hole-blocking layer may be formed within the ranges of the disclosure, excellent long-lifespan characteristics and excellent front-side efficiency characteristics are obtained.

The display apparatus according to the disclosure can have long-lifespan characteristics by forming the area of the first light-emitting area to be at least a preset multiple of the area of the second light-emitting area or the third light-emitting area.

In addition, the display apparatus according to the disclosure can have excellent front-side efficiency characteristics and long-lifespan characteristics because the thickness range of a layer included in an interlayer of a light-emitting element satisfies the range disclosed herein.

Additionally, the display apparatus according to the disclosure enables the manufacture of high-quality electronic devices.

Although the disclosure has been described with reference to an embodiment shown in the drawings, this is merely exemplary, and those skilled in the art will understand that various modifications and variations of the embodiments are possible. Accordingly, the true scope of the present disclosure should be determined by the technical idea of the appended claims.

## Claims

1. A display apparatus comprising:
a substrate having a unit area;
a first subpixel configured to emit light of a first color and comprising a first light-emitting area on the unit area;
a second subpixel configured to emit light of a second color and comprising a second light-emitting area on the unit area adjacent to the first light-emitting area; and
a third subpixel configured to emit light of a third color and comprising a third light-emitting area on the unit area adjacent to the second light-emitting area,
wherein:
a size of the first light-emitting area is at least 1.3 times one of a size of the second light-emitting area and a size of the third light-emitting area, and
a maximum emission wavelength of the light of the first color is shorter than one of a maximum emission wavelength of the light of the second color and a maximum emission wavelength of the light of the third color.

2. The display apparatus of claim 1, wherein the size of the first light-emitting area is at least 1.6 times the one of the size of the second light-emitting area and the size of the third light-emitting area; or
wherein the size of the first light-emitting area is at least twice the one of the size of the second light-emitting area and the size of the third light-emitting area.

3. The display apparatus of claim 1 or 2, wherein the size of the second light-emitting area is greater than the size of the third light-emitting area.

4. The display apparatus of any one of claims 1 to 3, wherein shapes of the first light-emitting area, the second light-emitting area, and the third light-emitting area are at least one or more of circular, rectangular and rhombus shapes; and/or
wherein shapes of the first light-emitting area, the second light-emitting area, and the third light-emitting area are the same as or different from each other.

5. The display apparatus of any one of claims 1 to 4, further comprising:
a pixel electrode of the first subpixel; and
a pixel definition film positioned on the substrate to cover at least a portion of the pixel electrode of the first subpixel and having an opening defining the first light-emitting area.

6. The display apparatus of any one of claims 1 to 5, further comprising a first light-emitting element, a second light-emitting element and a third light-emitting element, which are positioned on the substrate,
wherein the first light-emitting element, the second light-emitting element, and the third light-emitting element each independently comprise:
a pixel electrode;
a counter electrode; and
an interlayer positioned between the pixel electrode and the counter electrode and comprising an emission layer;
optionally wherein a thickness of the emission layer of the first light-emitting element is about 35 nm to about 45 nm.

7. The display apparatus of claim 6, wherein:
the interlayer further comprises a first functional layer positioned between the pixel electrode and the emission layer and a second functional layer positioned between the emission layer and the counter electrode,
the first functional layer comprises at least one of a hole injection layer, a hole transport layer, a buffer layer, an emission auxiliary layer, and an electron-blocking layer, and
the second functional layer comprises at least one of a hole-blocking layer, an electron transport layer, and an electron injection layer.

8. The display apparatus of claim 7, wherein a thickness of the electron-blocking layer is about 5 nm to about 10 nm; or
wherein a thickness of the hole-blocking layer is about 3 nm to about 5 nm.

9. The display apparatus of claim 11, wherein the emission layer of the first light-emitting element comprises a first compound including a group represented by Formula 20, a second compound including at least one π electron-deficient nitrogen-containing C₁-C₆₀ cyclic group, a third compound including a transition metal, a fourth compound that emits delayed fluorescence and includes at least one cyclic group including boron (B) and nitrogen (N) as ring-forming atoms, and/or any combination thereof, and
the first compound, the second compound, the third compound, and the fourth compound are different from each other: 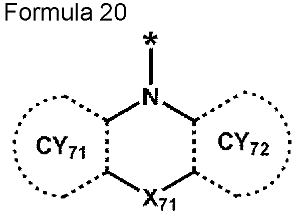
wherein ring CY₇₁ and ring CY₇₂ in Formula 20 are each independently a π electron-rich C₃-C₆₀ cyclic group or a pyridine group,
X₇₁ in Formula 20 is a single bond or a linking group including O, S, N, B, C, Si, and/or any combination thereof,
* in Formula 20 indicates a binding site to a neighboring atom in compound 20, and the following compounds are excluded from the first compound:

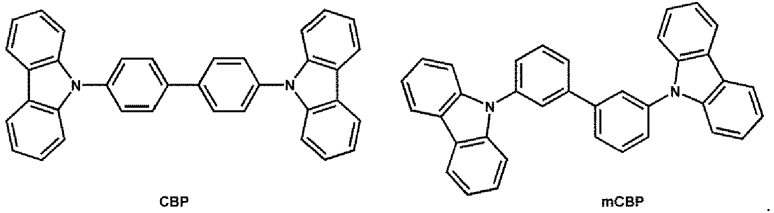

10. The display apparatus of claim 9, wherein the second compound includes a pyridine group, a pyrimidine group, a pyrazine group, a pyridazine group, a triazine group, and/or any combination thereof.

11. A display apparatus comprising:
a substrate having a unit area;
a first subpixel configured to emit light of a first color and comprising a first light-emitting area positioned on the unit area;
a second subpixel configured to emit light of a second color and comprising a second light-emitting area positioned on the unit area adjacent to the first light-emitting area; and
a third subpixel configured to emit light of a third color and comprising a third light-emitting area positioned on the unit area adjacent to the first light-emitting area,
wherein:
the first subpixel, the second subpixel, and the third subpixel are arranged in a crisscrossing pattern,
a size of the first light-emitting area is at least 1.3 times one of a size of the second light-emitting area and a size of the third light-emitting area, and
a maximum emission wavelength of the light of the first color is shorter than one of a maximum emission wavelength of the light of the second color and a maximum emission wavelength of the light of the third color.

12. The display apparatus of claim 11, wherein the size of the first light-emitting area is at least 1.6 times the size of the second light-emitting area; or
wherein the size of the first light-emitting area is at least twice the size of the third light-emitting area.

13. The display apparatus of claim 11 or 12, wherein:
the second light-emitting area comprises a first sub light-emitting area and a second sub light-emitting area which are spaced apart from each other on the unit area,
the first sub light-emitting area is adjacent to the first light-emitting area, and
the second sub light-emitting area is adjacent to the first light-emitting area.

14. An electronic device comprising the display apparatus of any one of claims 1 to 13.

15. The electronic device of claim 14, wherein the electronic device is one of a smartphone, a tablet personal computer, a laptop, a desk monitor, smart glasses, a head-mounted display, a smart watch, an instrument panel, a center fascia, a center information display, and a room mirror display.
